# EUROPEAN PATENT APPLICATION

(11) **EP 2 360 201 A1**
(43) Date of publication of application: **24.08.2011**
(21) Application number: 09827640.5
(22) Date of filing: 18.11.2009
(51) Int. Cl.: C08G 61/10, C09K 11/06, H01L 51/50

(54) **AMINE POLYMER COMPOUND AND LIGHT-EMITTING ELEMENT USING SAME**

(30) Priority: 20.11.2008 JP 2008296434
(71) Applicant: Sumitomo Chemical Company, Limited, Tokyo 104-8260 (JP); Sumation Co., Ltd., Chuo-ku Tokyo 104-8260 (JP)
(72) Inventor: OHUCHI, Kazuei, Tsukuba-shi Ibaraki 305-0005 (JP); NAKATANI, Tomoya, Tsukuba-shi Ibaraki 305-0821 (JP)
(74) Representative: Duckworth, Timothy John
(86) International application number: PCT/JP2009/069891
(87) International publication number: WO 2010/058859

(57) **Abstract**

A polymer compound comprising a constituent unit represented by the following formula (1a) : 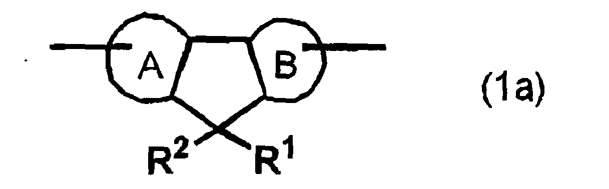 wherein ring A and ring B represent an aromatic hydrocarbon ring. R¹ is a group represented by the following formula (2). R² represents an aryl group or a monovalent aromatic heterocyclic group. 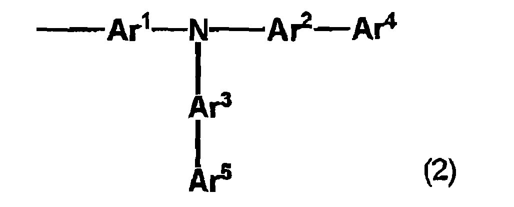 wherein Ar¹ represents an arylene group or a divalent group comprising two or more directly bonded arylene groups;
Ar⁴ and Ar⁵ represent an aryl group or a monovalent aromatic heterocyclic group; Ar² and Ar³ represent an arylene group or a divalent aromatic heterocyclic group.; R⁶ represents a hydrogen atom, an alkyl group, an aryl group or a monovalent aromatic heterocyclic group.

## Description

### Technical Field

The present invention relates to an amine polymer compound and a light emitting device using the same.

### Background Art

Polymer compounds having a fluorene structure such as 9,9-dialkylfluorene and the like having two alkyl groups introduced at the 9-position of a fluorene structure are known to be useful for production of light emitting devices (polymer LED, etc.) and the like (Advanced Materials 2000, 12(23), 1737-1750). As polymer compounds excellent in light emission efficiency, there are known a polymer compound having two triphenylamine skeletons introduced at the 9-position of a fluorene structure (Japanese Patent Application National Publication (Laid-Open) No. 2004-500463) and a polymer compound having two different aryl groups introduced at the 9-position of a fluorene structure (Japanese Patent Application National Publication (Laid-Open) No. 2002-527553).

### Disclosure of the Invention

Light emitting devices containing these polymer compounds, however, are not necessarily sufficient in external quantum yield (indicative of light emission efficiency in consideration of chromaticity) at a luminance of 1000 cd/m² in a practical area when used in a display and the like.

An object of the present invention is to provide a polymer compound which is useful for fabrication of a light emitting device excellent in external quantum yield at a luminance of 1000 cd/m².

The present invention provides, in a first aspect, a polymer compound comprising a constituent unit represented by the following formula (1a): 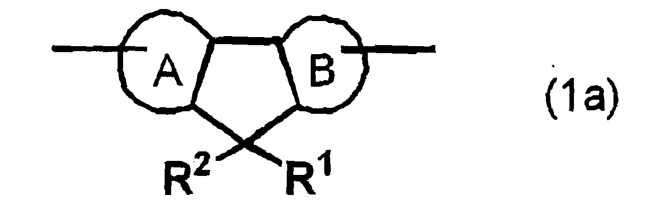 wherein ring A and ring B represent each independently an aromatic hydrocarbon ring optionally having a substituent; R¹ is a group represented by the following formula (2); R² represents an aryl group or a monovalent aromatic heterocyclic group, and any hydrogen atom in these groups may be substituted by an alkyl group, an alkoxy group, an alkylthio group, a substituted carbonyl group, a substituted carboxyl group, an aryl group, an aryloxy group, an arylthio group, an aralkyl group, a monovalent aromatic heterocyclic group, a fluorine atom or a cyano group. 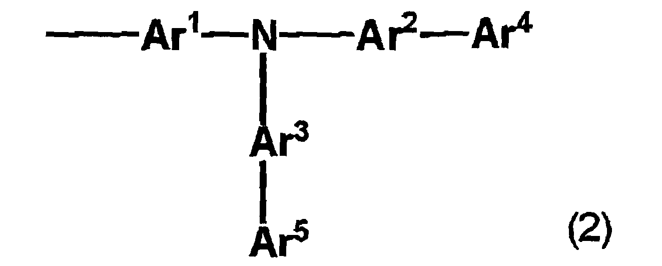 wherein Ar¹ represents an arylene group or a divalent group comprising two or more directly bonded identical or different arylene groups; Ar⁴ and Ar⁵ represent each independently an aryl group or a monovalent aromatic heterocyclic group; Ar² and Ar³ represent each independently an arylene group or a divalent aromatic heterocyclic group when Ar² and Ar³ are each a phenylene group, one carbon atom in the phenylene group represented by Ar² and one carbon atom in the phenylene group represented by Ar³ ,the carbon atoms being positioned at the ortho position with respect to the nitrogen atom bonded to these phenylene groups, may be bonded to each other directly or via -O-, -S-, -C (=O)-, -C(=O)-O-, -N(R⁶)-,-C(=O) -N(R⁶)- or -C(R⁶)(R⁶)- to form a 5- to 7-membered ring; R⁶ represents a hydrogen atom, an alkyl group, an aryl group or a monovalent aromatic heterocyclic group; any hydrogen atom in the groups represented by Ar¹, Ar², Ar³, Ar⁴, Ar⁵ and R⁶ may be substituted by an alkyl group, an alkoxy group, an alkylthio group, a substituted carbonyl group, a substituted carboxyl group, an aryl group, an aryloxy group, an arylthio group, an aralkyl group, a monovalent aromatic heterocyclic group, a fluorine atom or a cyano group; when there are a plurality of R⁶ s, these may be the same or different.

The present invention provides, in a second aspect, a compound represented by the following formula (A). 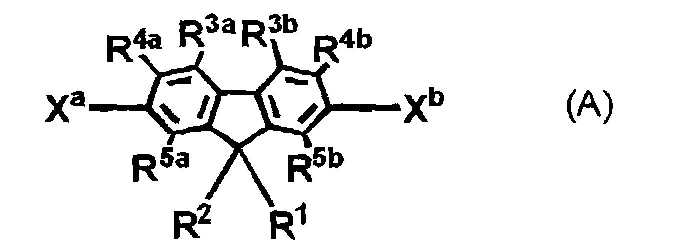 wherein R¹ , R² , R^{3a} , R^{4a} , R^{5a}, R^{3b}, R^{4b}, and R^{5b} have the same meaning as described above; X^{a} and X^{b} represent each independently a bromine atom, an iodine atom, a chlorine atom, -O-S(=O)₂R²⁰, -B(OR²¹)₂, -BF₄Q¹, -Sn(R²²)₃, -MgY¹ or -Zny¹; R²⁰ represents an alkyl group, or an aryl group optionally substituted by an alkyl group, an alkoxy group, a nitro group, a fluorine atom or a cyano group; R²¹ and R²² represent each independently a hydrogen atom or an alkyl group two R²¹s may be the same or different and may form a ring together; three R²²s may be the same or different and may form a ring together; Q¹ represents a monovalent cation of lithium, sodium, potassium, rubidium or cesium. Y¹ represents a bromine atom, an iodine atom or a chlorine atom.

The present invention provides, in a third aspect, a composition and a film comprising the above-described polymer compound.

The present invention provides, in a fourth aspect, a solution comprising the above-described polymer compound and a solvent.

The present invention provides, in a fifth aspect, a light emitting device having electrodes consisting of an anode and a cathode, and an organic layer containing the above-described polymer compound disposed between the electrodes.

The present invention provides, in a sixth aspect, a planar light source comprising the above-described light emitting device.

### Modes for Carrying Out the Invention

The present invention will be illustrated in detail below.

In the present specification, "constituent unit" indicates one or more units present in a polymer compound, and the constituent unit is preferably contained as "repeating units" (namely, two or more units present in a polymer compound) in a polymer compound. "n-valent aromatic heterocyclic group" (n represents 1 or 2) means an atomic group obtained by removing n hydrogen atoms from a heterocyclic group having an aromatic property and includes also groups having a condensed ring. "Heterocyclic compound" includes organic compounds having a cyclic structure in which atoms constituting the ring include not only a carbon atom but also a hetero atom such as an oxygen atom, a sulfur atom, a nitrogen atom, a phosphorus atom, a boron atom, a silicon atom and the like. "Aromatic heterocyclic compound" includes heterocyclic compounds containing a hetero atom such as oxadiazole, thiadiazole, thiazole, oxazole, thiophene, pyrrole, phosphole, furan, pyridine, pyrazine, pyrimidine, triazine, pyridazine, quinoline, isoquinoline, carbazole, dibenzosilole, dibenzophosphole and the like, the heterocycle itself showing an aromatic property; and compounds of which heterocycle itself containing a hetero atom shows no aromatic property but to which heterocycle an aromatic ring is condensed, such as phenoxazine, phenothiazine, dibenzoborole, dibenzosilole, benzopyran and the like.

### <Polymer Compound>

### -Constituent unit represented by the formula (1a)-

The polymer compound of the present invention comprises a constituent unit represented by the formula (1a)

In the aromatic hydrocarbon ring represented by ring A and ring B in the formula (1a), the number of carbon atoms constituting the aromatic ring is usually 6 to 14. The aromatic hydrocarbon ring includes a benzene ring, a naphthalene ring, a fluorene ring, an anthracene ring, a phenanthrene ring and the like. The aromatic hydrocarbon ring may have a substituent. A connecting bond is present on the ring A and a connecting bond is present on the ring B, respectively.

The aryl group represented by R² in the formula (1a) is an atomic group obtained by removing one hydrogen atom from an aromatic hydrocarbon, and includes groups having a condensed ring. The aryl group has a carbon atom number of usually 6 to 60, preferably 6 to 48, more preferably 6 to 20, further preferably 6 to 14. This carbon atom number does not include the carbon atom number of the substituent. The aryl group includes a phenyl group, a 1-naphthyl group, a 2-naphthyl group, a 1-anthracenyl group, a 2-anthracenyl group, a 9-anthracenyl group, a 1-tetracenyl group, a 2-tetracenyl group, a 5-tetracenyl group, a 1-pyrenyl group, a 2-pyrenyl group, a 4-pyrenyl group, a 2-perylenyl group, a 3-perylenyl group, a 2-fluorenyl group, a 3-fluorenyl group, a 4-fluorenyl group, a 1-biphenylenyl group, a 2-biphenylenyl group, a 2-phenanthrenyl group, a 9-phenanthrenyl group, a 6-chrycenyl group, a 1-coronenyl group and the like. Any hydrogen atom in the aryl group may be substituted by an alkyl group, an alkoxy group, an alkylthio group, a substituted carbonyl group, a substituted carboxyl group, an aryl group, an aryloxy group, an arylthio group, an aralkyl group, a monovalent aromatic heterocyclic group, a fluorine atom or a cyano group.

The monovalent aromatic heterocyclic group represented by R² in the formula (1a) has a carbon atom number of usually 3 to 60, preferably 3 to 20. This carbon atom number does not include the carbon atom number of the substituent. The monovalent aromatic heterocyclic group includes a 2-oxadiazole group, a 2-thiadiazole group, a 2-thiazole group, a 2-oxazole group, a 2-thienyl group, a 2-pyrrolyl group, a 2-furyl group, a 2-pyridyl group, a 3-pyridyl group, a 4-pyridyl group, a 2-pyrazyl group, a 2-pyrimidyl group, a 2-triazyl group, a 3-pyridazyl group, a quinolyl group, an isoquinolyl group, a 2-carbazolyl group, a 3-carbazolyl group, a 2-phenoxazinyl group, a 3-phenoxazinyl group, a 2-phenothiazinyl group, a 3-phenothiazinyl group and the like. Any hydrogen atom in the monovalent aromatic heterocyclic group may be substituted by an alkyl group, an alkoxy group, an alkylthio group, a substituted carbonyl group, a substituted carboxyl group, an aryl group, an aryloxy group, an arylthio group, an aralkyl group, a monovalent aromatic heterocyclic group, a fluorine atom, a cyano group or the like.

### Explanation of substituent

The alkyl group may be any of linear, branched or cyclic and has a carbon atom number of usually 1 to 20. The alkyl group includes a methyl group, an ethyl group, a propyl group, an i-propyl group, a butyl group, an i-butyl group, a t-butyl group, a pentyl group, an isoamyl group, a hexyl group, a cyclohexyl group, a heptyl group, an octyl group, a 2-ethylhexyl group, a nonyl group, a decyl group, a 3,7-dimethyloctyl group, a dodecyl group, a trifluoromethyl group, a pentafluoroethyl group, a perfluorobutyl group, a perfluorohexyl group, a perfluorooctyl group and the like-

The alkoxy group may be any of linear, branched or cyclic and has a carbon atom number of usually 1 to 20. The alkoxy group includes a methoxy group, an ethoxy group, a propyloxy group, an i-propyloxy group, a butoxy group, an i-butoxy group, a t-butoxy group, a pentyloxy group, a hexyloxy group, a cyclohexyloxy group, a heptyloxy group, an octyloxy group, a 2-ethylhexyloxy group, a nonyloxy group, a decyloxy group, a 3,7-dimethyloctyloxy group, a dodecyloxy group, a trifluoromethoxy group, a pentafluoroethoxy group, a perfluorobutoxy group, a perfluorohexyloxy group, a perfluorooctyloxy group, a methoxymethyloxy group, a 2-methoxyethyloxy group, a 2-ethoxyethyloxy group and the like.

The alkylthio group may be any of linear, branched or cyclic and has a carbon atom number of usually 1 to 20. The alkylthio group includes a butylthio group, a hexylthio group, an octylthio group, a 2-ethylhexylthio group, a 3,7-dimethyloctylthio group, a dodecylthio group and the like.

The substituted carbonyl group has a carbon atom number of usually 2 to 60. The substituted carbonyl group includes carbonyl groups substituted by an alkyl group, an aryl group, an aralkyl group or a monovalent aromatic heterocyclic group, and preferable are an acetyl group, a butyryl group and a benzoyl group.

The substituted carboxyl group has a carbon atom number of usually 2 to 60. The substituted carboxyl group includes carboxyl groups substituted by an alkyl group, an aryl group, an aralkyl group or a monovalent aromatic heterocyclic group, and preferable are a methoxycarbonyl group, an ethoxycarbonyl group, a butoxycarbonyl group, a phenoxycarbonyl group and a benzyloxycarbonyl group.

The aryl group is the same as explained and exemplified in the section of the aryl group represented by R²_{.}

The aryloxy group has a carbon atom number of usually 6 to 60. The aryloxy group includes a phenoxy group, a C₁ to C₁₂ alkoxyphenoxy group ("C₁ to C₁₂ alkoxy" means that an alkoxy portion has a carbon atom number of 1 to 12, the same shall apply hereinafter), a C₁ to C₁₂ alkylphenoxy group ("C₁ to C₁₂ alkyl" means that an alkyl portion has a carbon atom number of 1 to 12, the same shall apply hereinafter), a 1-naphthyloxy group, a 2-naphthyloxy group, a pentafluorophenyloxy group and the like.

The arylthio group has a carbon atom number of usually 6 to 60. The arylthio group includes a phenylthio group, a C₁ to C₁₂ alkoxyphenylthio group, a C₁ to C₁₂ alkylphenylthio group, a 1-naphthylthio group, a 2-naphthylthio group, a pentafluorophenylthio group and the like.

The aralkyl group has a carbon atom number of usually 7 to 60. The aralkyl group includes a phenyl C₁ to C₁₂ alkyl group, a C₁ to C₁₂ alkoxyphenyl C₁ to C₁₂ alkyl group, a C₁ to C₁₂ alkylphenyl C₁ to C₁₂ alkyl group, a 1-naphthyl C₁ to C₁₂ alkyl group, a 2-naphthyl C₁ to C₁₂ alkyl group and the like.

The monovalent aromatic heterocyclic group as a substituent is the same as explained and exemplified in the section of the monovalent aromatic heterocyclic group as the group represented by R².

As the group represented by R² in the formula (1a), aryl groups are preferable, and from the standpoint of a balance between heat resistance and solubility of the polymer compound of the present invention in an organic solvent, aryl groups substituted by an alkyl group, an alkoxy group or an aryl group, and unsubstituted aryl groups are more preferable, aryl groups substituted by an alkyl group or an aryl group, and unsubstituted aryl groups are further preferable, aryl groups substituted by an alkyl group are particularly preferable.

Suitable examples of the group represented by R² include a phenyl group, a 4-tolyl group, a 4-butylphenyl group, a 4-t-butylphenyl group, a 4-hexylphenyl group, a 4-octylphenyl group, a 4-(2-ethylhexyl)phenyl group, a 4-(3,7-dimethyloctyl)phenyl group, a 3-tolyl group, a 3-butylphenyl group, a 3-t-butylphenyl group, a 3-hexylphenyl group, a 3-octylphenyl group, a 3-(2-ethylhexyl)phenyl group, a 3-(3,7-dimethyloctyl)phenyl group, a 3,5-dimethylphenyl group, a 3,5-di-(t-butyl)phenyl group, a 3,4-dihexylphenyl group, a 3,4-dioctylphenyl group, a 1-naphthyl group, a 2-naphthyl group, a 2-fluorenyl group, a 9,9-dihexyl-2-fluorenyl group, a 9,9-dioctyl-2-fluorenyl group and a 4-(4'-t-butylbiphenyl) group.

The group represented by the formula (2) represented by R¹ in the formula (1a) will be illustrated below.

The arylene group represented by Ar¹, Ar² and Ar³ in the formula (2) means an atomic group obtained by removing two hydrogen atoms from an aromatic hydrocarbon, and includes groups having a condensed ring. The arylene group has a carbon atom number of usually 6 to 60. This carbon atom number does not include the carbon atom number of the substituent. The arylene group includes phenylene groups such as a 1,4-phenylene group, a 1,3-phenylene group, a 1,2-phenylene group and the like; naphthalenediyl groups such as a naphthalene-1,4-diyl group, a naphthalene-1,5-diyl group, a naphthalene-2,6-diyl group and the like; anthracenediyl groups such as an anthracene-1,4-diyl group, an anthxacene-1,5-diyl group, an anthracene-2,6-diyl group, an anthracene-9,10-diyl group and the like; phenanthrenediyl groups such as a phenanthrene-2,7-diyl group and the like; naphthacenediyl groups such as a naphthacene-1,7-diyl group, a naphthacene-2,8-diyl group and the like; fluorenediyl groups such as a fluorene-2,7-diyl group, a 7H-benzo[c]fluorene-5,9-diyl group, a 6,12-dihydro-indeno[1,2-b]fluorene-2,8-diyl group and the like. Any hydrogen atom in the arylene group may be substituted by an alkyl group, an alkoxy group, an alkylthio group, a substituted carbonyl group, a substituted carboxyl group, an aryl group, an aryloxy group, an arylthio group, an aralkyl group, a monovalent aromatic heterocyclic group, a fluorine atom, a cyano group or the like.

The divalent aromatic heterocyclic group represented by Ar² and Ar³ in the formula (2) has a carbon atom number of usually 2 to 60. This carbon atom number does not include the carbon atom number of the substituent. The divalent aromatic heterocyclic group includes a 1,3,4-oxadiazole-2,5-diyl group, a 1,3,4-thiadiazole-2,5-diyl group, a 1,3-thiazole-2,5-diyl group, a 1,3-oxazole-2,5-diyl group, a thiophene-2,5-diyl group, a pyrrole-2,5-diyl group, a furan-2,5-diyl group, a pyridine-2,5-diyl group, a pyridine-2,4-diyl group, a pyridine-2,6-diyl group, a pyridine-3,5-diyl group, a pyrimidine-2,4-diyl group, a pyrimidine-2,6-diyl group, a triazine-2,4-diyl group, a pyridazine-3,6-diyl group, a carbazole-2,7-diyl group, a carbazole-3,6-diyl group, a phenoxazine-2,7-diyl group, a phenoxazine-3,6-diyl group, a phenothiazine-2,7-diyl group, a phenothiazine-3,6-diyl group and the like. Any hydrogen atom in the divalent aromatic heterocyclic group may be substituted by an alkyl group, an alkoxy group, an alkylthio group, a substituted carbonyl group, a substituted carboxyl group, an aryl group, an aryloxy group, an arylthio group, an aralkyl group, a monovalent aromatic heterocyclic group, a fluorine atom, a cyano group or the like.

The divalent group comprising two or more directly bonded identical or different arylene groups represented by Ar¹ in the formula (2) includes biphenyldiyl groups such as a biphenyl-4,4'--diyl group, a biphenyl-3,4'-diyl group, a biphenyl-3,3'-diyl group and the like; terphenyldiyl groups such as a [1,1';4',1"]terphenyl-4,4"-diyl group and the like. Any hydrogen atom in the divalent group comprising two or more directly bonded identical or different arylene groups represented by Ar¹ may be substituted by an alkyl group, an alkoxy group, an alkylthio group, a substituted carbonyl group, a substituted carboxyl group, an aryl group, an aryloxy group, an arylthio group, an aralkyl group, a monovalent aromatic heterocyclic group, a fluorine atom, a cyano group or the like.

Ar¹ in the formula (2) represents preferably a 1,4-phenylene group, a 1,3-phenylene group, a naphthalene-1,4-diyl group, a naphthalene-1,5-diyl group, a naphthalene-2,6-diyl group, an anthracene-2,6-diyl group, an anthracene-9,10-diyl group, a phenanthrene-2,7-diyl group, a 9,9-dialkylfluorene-2,7-diyl group, a 9, 9-diarylfluorene-2,7-diyl group, a 7,7-dialkylbenzo[c]fluorene-5,9-diyl group, a 7,7-diaryl-benzo[c]fluorene-5,9-diyl group, a 6,6,12,12-tetraalkyl-indeno[1,2-b]fluorene-2,8-diyl group, a 6,6,12,12-tetraaryl-indeno[1,2-b]fluorene-2,8-diyl group, a biphenyl-4,4'-diyl group, a biphenyl-3,4'-diyl group, a biphenyl-3,3'-diyl group or a [1,1';4',1"]terphenyl-4,4"-diyl group, and particularly preferable from the standpoint of the easiness of synthesis of the polymer compound of the present invention are a 1,4-phenylene group, a 1,3-phenylene group, a biphenyl-4,4'-diyl group, a biphenyl-3,4'-diyl group and a biphenyl-3,3'-diyl group.

Ar² and Ar³ in the formula (2) represent preferably a 1,4-phenylene group, a 1,3-phenylene group, an anthracene-9,10-diyl group, a 9, 9-dialkylfluorene-2,7-diyl group or a 9, 9-diarylfluorene-2,7-diyl group, from the standpoint of the heat resistance and easiness of synthesis of the polymer compound of the present invention.

The aryl group and monovalent aromatic heterocyclic group represented by Ar⁴ and Ar⁵ in the (2) are the same as explained and exemplified as the aryl group and monovalent aromatic heterocyclic group represented by R².

As Ar⁴ and Ar⁵ in the (2), preferable are aryl groups substituted by an alkyl group, an alkoxy group or an aryl group, and unsubstituted aryl groups, more preferable are aryl groups substituted by an alkyl group or an aryl group, and unsubstituted aryl groups, further preferable are phenyl groups substituted by an alkyl group or an aryl group, and unsubstituted phenyl group, 1-naphthyl groups substituted by an alkyl group or an aryl group, and unsubstituted 1-naphthyl group, 2-naphthyl groups substituted by an alkyl group or an aryl group, and unsubstituted 2-naphthyl group, and, 2-fluorenyl groups substituted by an alkyl group or an aryl group, and unsubstituted 2-fluorenyl group, from the standpoint of the heat resistance of the polymer compound of the present invention. Ar⁴ and Ar⁵ include a 4-tolyl group, a 4-butylphenyl group, a 4-t-butylphenyl group, a 4-hexylphenyl group, a 4-octylphenyl group, a 4-(2-ethylhexyl)phenyl group, a 4-(3,7-dimethyloctyl)phenyl group, a 3-tolyl group, a 3-butylphenyl group, a 3-t-butylphenyl group, a 3-hexylphenyl group, a 3-octylphenyl group, a 3-(2-ethylhexyl)phenyl group, a 3-(3,7-dimethyloctyl)phenyl group, a 3,5-dimethylphenyl group, a 3,5-di-(t-butyl)phenyl group, a 3,4-dihexylphenyl group, a 3,4-dioctylphenyl group, a 1-naphthyl group, a 2-naphthyl group, a 2-fluorenyl group, a 9,9-dihexyl-2-fluorenyl group, a 9,9-dioctyl-2-fluorenyl group, a 9,9-bis(4-tolyl)-2-fluorenyl group, a 9,9-bis(4-hexylphenyl)-2-fluorenyl group, a 7,9,9-trioctyl-2-fluorenyl group, a 7-(4'-n-butylphenyl)-9,9-bis(4-hexylphenyl)-2-fluorenyl group, a 4-(4'-t-butylbiphenyl) group, a 4-(4'-hexylbiphenyl) group and the like.

When Ar² and Ar³ in the formula (2) are each a phenylene group and one carbon atom in the phenylene group represented by Ar² and one carbon atom in the phenylene group represented by Ar³, the carbon atoms being positioned at the ortho position with respect to the nitrogen atom bonded to these phenylene groups and being bonded to each other directly or via -O-, -S-, -C(=O)-, -C(=O)-O-, - N(R⁶)-, -C (=O)-N(R⁶)- or -C(R⁶)(R⁶)- to form a 5- to 7-membered ring, it is preferable that they are bonded directly or via -O-, -S- or -C(R⁶)(R⁶)- to form a 5- to 6-membered ring, it is more preferable that they are bonded directly or via -O- or -C(R⁶)(R⁶)- to form a 5- to 6-membered ring. The 5- to 7-membered ring includes a carbazole ring obtained by direct bonding of Ar² and Ar³, a phenoxazine ring obtained by bonding of Ar² and Ar³ via -O-a dihydroacridine ring obtained by bonding of Ar² and Ar³ via -C(R⁶)(R⁶)-, and the like, and a phenoxazine ring is preferable from the standpoint of light emission efficiency.

The alkyl group represented by R⁶ is the same as explained and exemplified as the alkyl group in the section of explanation of the substituent described above. The aryl group represented by R⁶ is the same as explained and exemplified as the aryl group represented by Ar² and Ar³ The monovalent aromatic heterocyclic group represented by R⁶ is the same as explained and exemplified as the monovalent aromatic heterocyclic group in explanation of the group represented by R². As the group represented by R⁶, an alkyl group and an aryl group are preferable.

As the group represented by the formula (2), groups represented by the following formulae (2-000) and (2-100) are preferable. 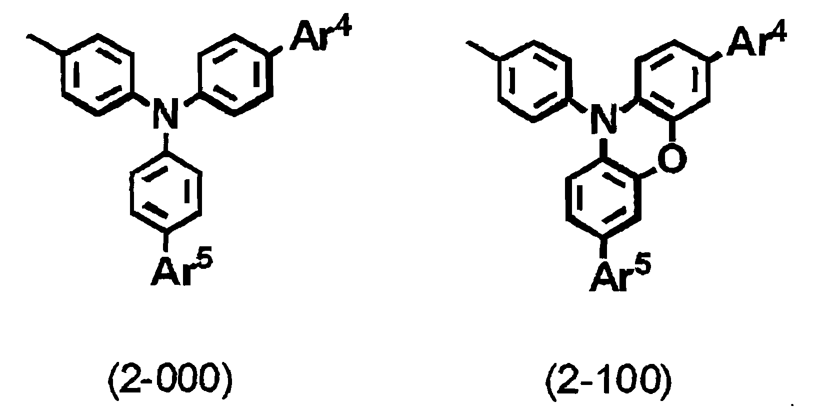 wherein Ar⁴ and Ar⁵ represent the same meaning as described above.

The group represented by the formula (2-000) includes groups represented by the following formulae (2-001) to (2-008); and groups obtained by substitution of any hydrogen atom in these groups by a group selected from the group consisting of an alkyl group, an alkoxy group, an alkylthio group, a substituted carbonyl group, a substituted carboxyl group, an aryl group, an aryloxy group, an arylthio group, an aralkyl group, a monovalent aromatic heterocyclic group, a fluorine atom and a cyano group. In the formulae, the connecting bond projecting from an aromatic ring represents a connecting bond itself, or a connecting bond via an arylene group.

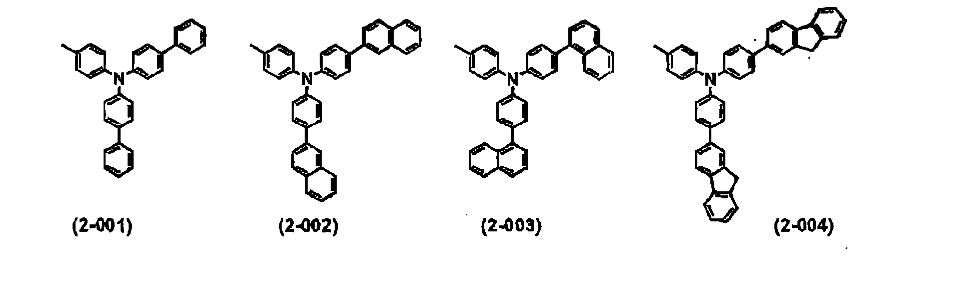

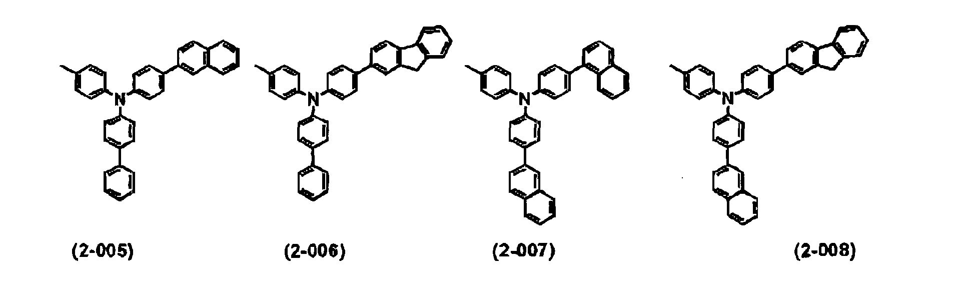

The group represented by the formula (2-100) includes groups represented by the following formulae (2-001) to (2-108); and groups obtained by substitution of any hydrogen atom in these groups by a group selected from the group consisting of an alkyl group, an alkoxy group, an alkylthio group, a substituted carbonyl group, a substituted carboxyl group, an aryl group, an aryloxy group, an arylthio group, an aralkyl group, a monovalent aromatic heterocyclic group, a fluorine atom and a cyano group. In the formulae, the connecting bond projecting from an aromatic ring represents a connecting bond itself, or a connecting bond via an arylene group.

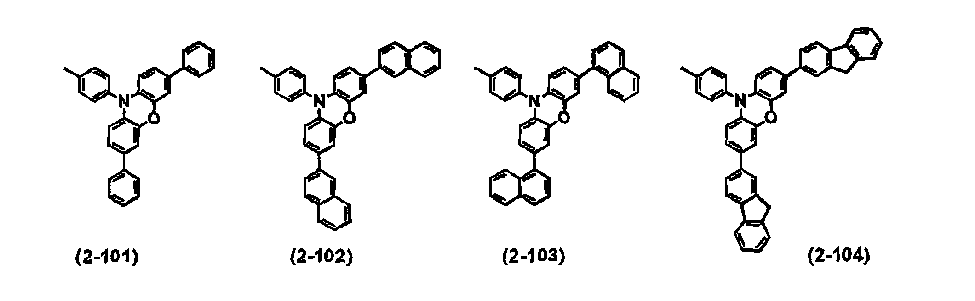

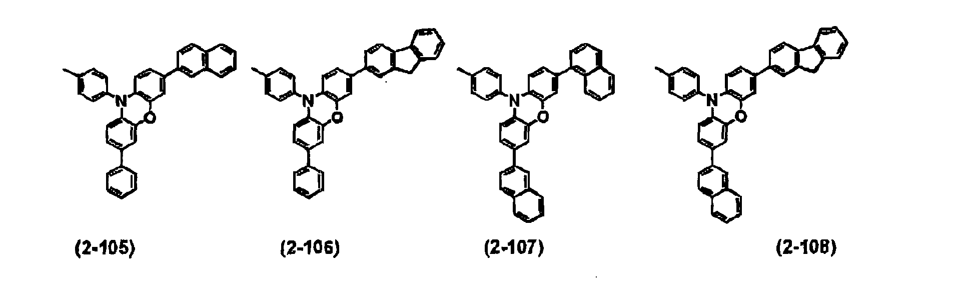

The group represented by the formula (2) includes, additionally, groups represented by the following formulae (2-201) to (2-208), (2-301) to (2-308); and groups obtained by substitution of any hydrogen atom in these groups by a group selected from the group consisting of an alkyl group, an alkoxy group, an alkylthio group, a substituted carbonyl group, a substituted carboxyl group, an aryl group, an aryloxy group, an arylthio group, an aralkyl group, a monovalent aromatic heterocyclic group, a fluorine atom and a cyano group. In the formulae, the connecting bond projecting from an aromatic ring represents a connecting bond itself, or a connecting bond via an arylene group.

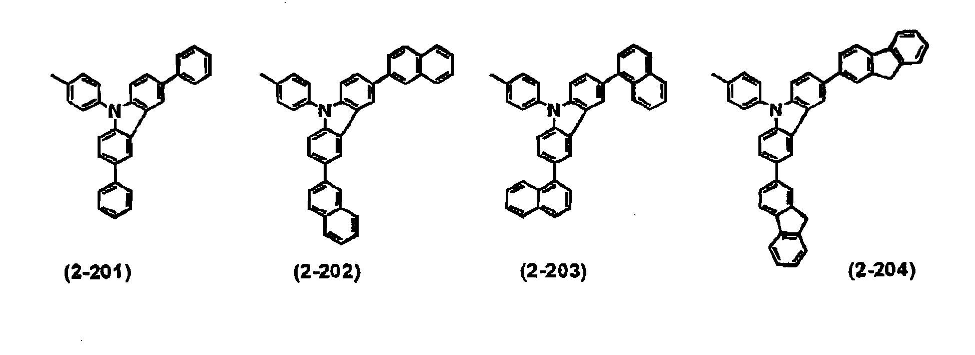

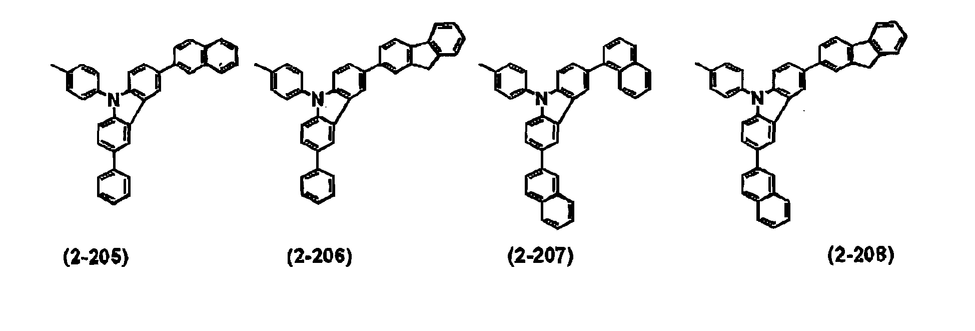

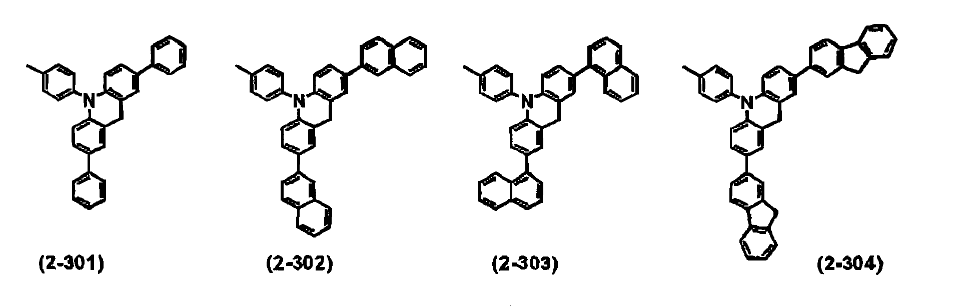

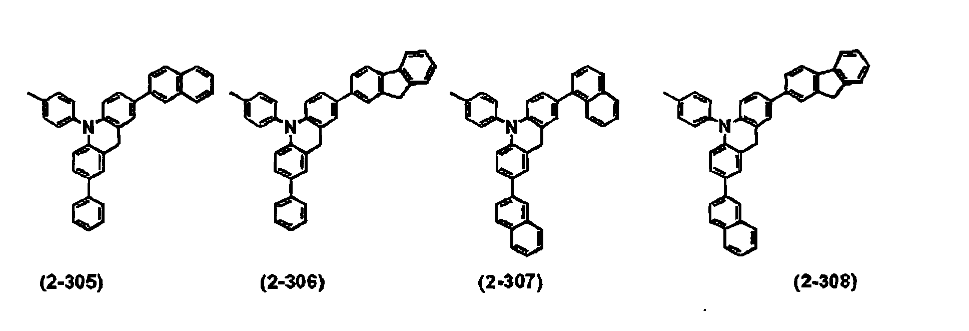

### Constituent unit represented by the formula (1)

As the constituent unit represented by the formula (1a), constituent units represented by the following formula (1) are preferable from the standpoint of the easiness of synthesis thereof. 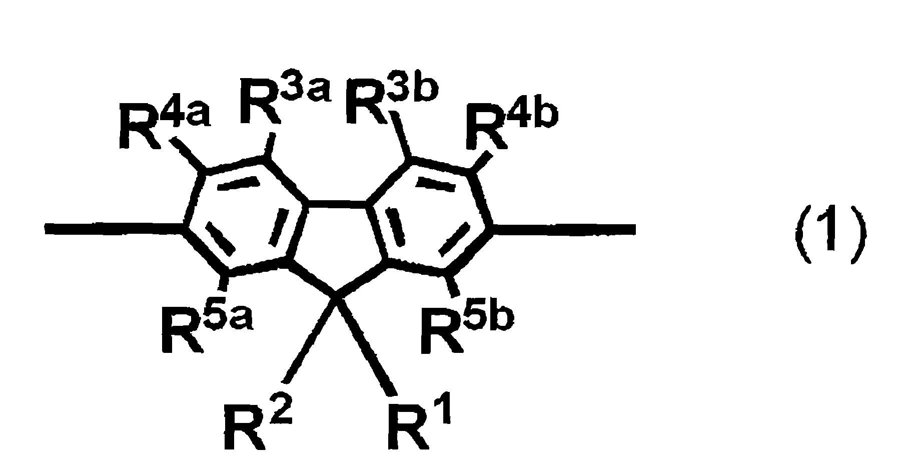 wherein R¹ and R² have the same meaning as described above; R^{3a}, R^{4a}, R^{5a}, R^{3b} , R^{4b} and R^{5b} represent each independently a hydrogen atom, an alkyl group, an aryl group, a monovalent aromatic heterocyclic group, -N(R⁸) (R⁹), a fluorine atom or a cyano group. R⁸ and R⁹ represent each independently a hydrogen atom, an alkyl group, an aryl group or a monovalent aromatic heterocyclic group; any hydrogen atom in the aryl group and monovalent aromatic heterocyclic group represented by R^{3a}, R^{4a}, R^{5a}, R^{3b}, R^{4b}, R^{5b}, R⁸ and R⁹ may be substituted by an alkyl group, an alkoxy group, an alkylthio group, a substituted carbonyl group, a substituted carboxyl group, an aryl group, an aryloxy group, an arylthio group, an aralkyl group, a monovalent aromatic heterocyclic group, a fluorine atom or a cyano group; a pair of R^{3a} and R^{4a}, a pair of R^{3b} and R^{4b}, a pair of R^{3a} and R^{3b}, and a pair of R⁸ and R⁹ each may form a ring together.

The alkyl group and aryl group represented by R^{3a}, R^{4a}, R⁵⁸, R^{3b}, R^{4b}, R^{5b}, R⁸ and R⁹ in the formula (1) are the same as explained and exemplified as the alkyl group and aryl group in the section of explanation of the substituent. The monovalent aromatic heterocyclic group represented by R^{3a}, R^{4a}, R^{5a}, R^{3b}, R^{4b}, R^{5b}, R⁸ and R⁹ is the same as explained and exemplified as the monovalent aromatic heterocyclic group in the explanation of the group represented by R². The alkyl group, alkoxy group, alkylthio group, substituted carbonyl group, substituted carboxyl group, aryl group, aryloxy group, arylthio group, aralkyl group and monovalent aromatic heterocyclic group which can be carried as a substituent on the group represented by R^{3b}, R^{4b}, R^{5b}, R⁸ and R⁹ are the same as exemplified and explained in the section of explanation of the substituent.

As R⁸ and R⁹, preferable are C₁ to C₁₂ alkyl groups, unsubstituted aryl groups or aryl groups substituted by a C₁ to C₁₂ alkyl group, more preferable are unsubstituted aryl groups or aryl groups substituted by a C₁ to C₁₂ alkyl group, from the standpoint of the heat resistance of the polymer compound of the present invention.

The group represented by -N(R⁸)(R⁹) includes a diphenylamino group, a di-4-tolylamino group, a di-3-tolylamino group, a di-(4-t-butylphenyl)amino group, a di-(4-hexylphenyl)amino group, a bis((3,5-di-t-butyl)phenyl)amino group, a phenyl-1-naphthylamino group, a phenyl-2-naphthylamino group and the like.

As R^{3a}, R^{4a}, R^{5a}, R^{3b}, R^{4b} and R^{5b}, preferable are a hydrogen atom, an alkyl group and an aryl group, more preferable is a hydrogen atom, from the standpoint of the easiness of synthesis of the polymer compound of the present invention.

The constituent unit represented by the formula (1) includes groups represented by the following formulae (1-001) to (1-008), (1-101) to (1-109), (1-201) to (1-202), (1-301) to (1-303) group; and groups obtained by substitution of any hydrogen atom in these groups by a group selected from the group consisting of an alkyl group, an alkoxy group, an alkylthio group, a substituted carbonyl group, a substituted carboxyl group, an aryl group, an aryloxy group, an arylthio group, an aralkyl group, a monovalent aromatic heterocyclic group, a fluorine atom and a cyano group. In the following formulae, Me represents a methyl group, n-Bu represents a n-butyl group and t-Bu represents a tert-butyl group, the same shall apply hereinafter.

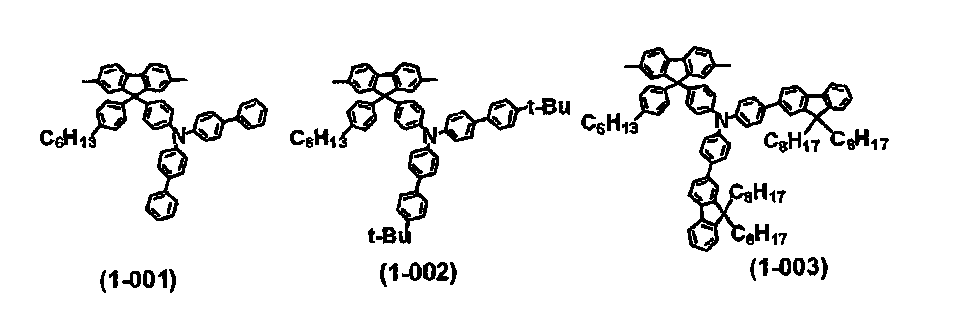

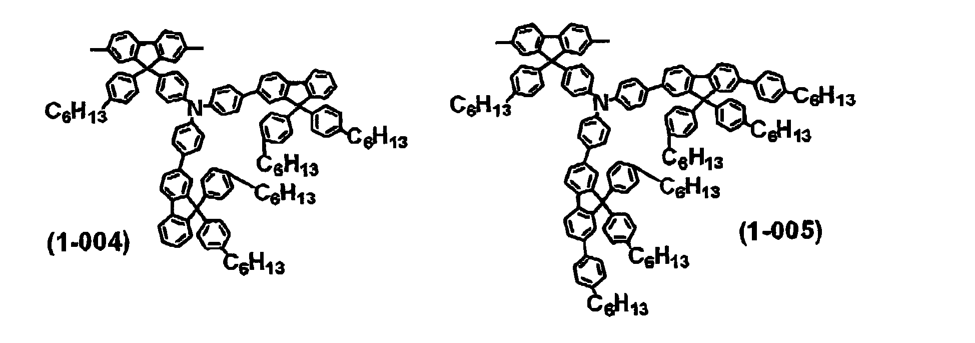

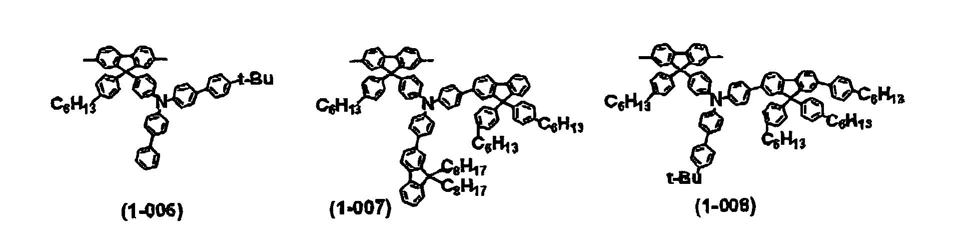

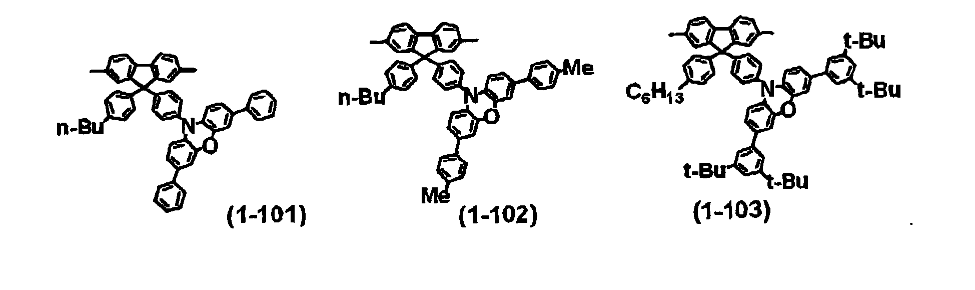

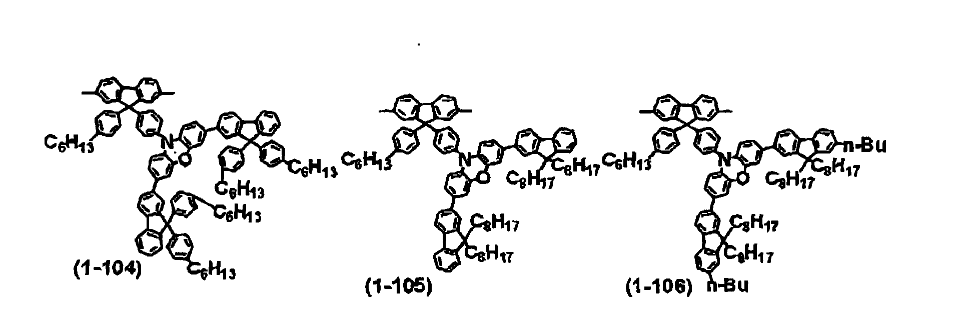

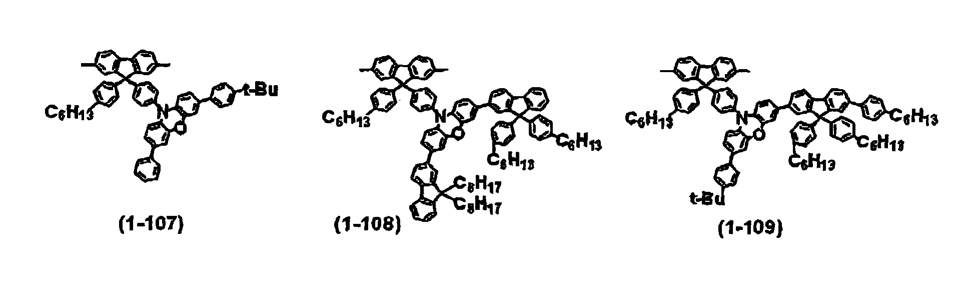

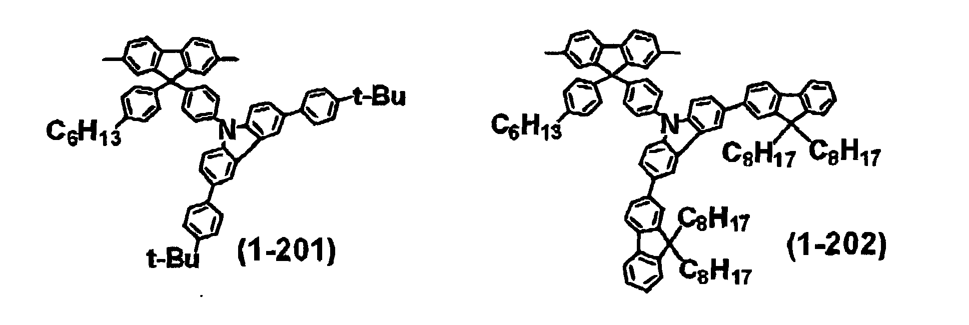

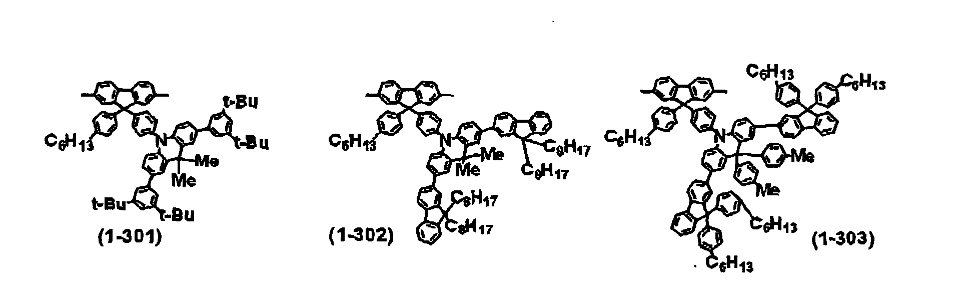

### -Constituent units represented by the formulae (3) to (5)-

The polymer compound of the present invention may further contain at least one constituent unit selected from the group consisting of constituent units represented by the following formulae (3) to (5), in addition to the constituent unit represented by the formula (1a).

-Ar⁸- (3)

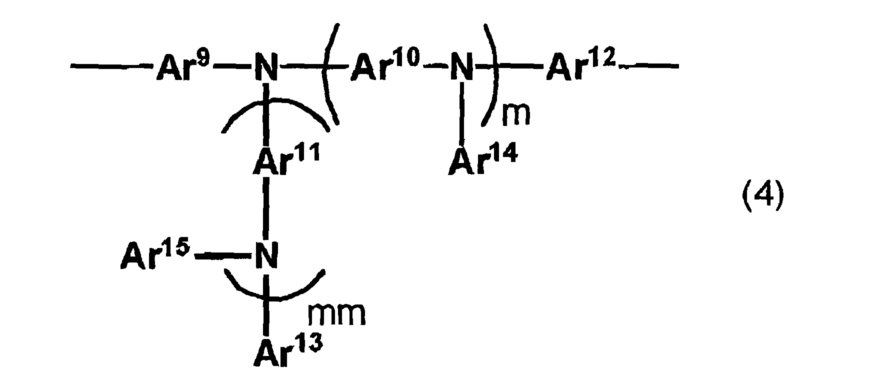

-Ar¹⁶-X¹- (5)

wherein Ar⁸ and Ar¹⁶ represent each independently an arylene group or a divalent aromatic heterocyclic group, or a divalent group comprising two or more directly bonded identical or different groups selected from the group consisting of arylene groups and divalent aromatic heterocyclic groups; Ar⁹, Ar¹⁰, Ar¹¹ and Ar¹² represent each independently an arylene group, or a divalent group comprising two or more directly bonded identical or different arylene groups; Ar¹³, Ar¹⁴ and Ar¹⁵ represent each independently an aryl group or a monovalent aromatic heterocyclic group; any hydrogen atom in the arylene group, divalent aromatic heterocyclic group and divalent group represented by Ar⁸ and Ar¹⁶ may be substituted by an alkyl group, an alkoxy group, an alkylthio group, a substituted carbonyl group, a substituted carboxyl group, an aryl group, an aryloxy group, an arylthio group, an aralkyl group, a monovalent aromatic heterocyclic group, - N(R⁸)(R⁹), a fluorine atom or a cyano group; any hydrogen atom in the groups represented by Ar⁹, Ar¹⁰, Ar¹¹, Ar¹², Ar¹³, Ar¹⁴ and Ar¹⁵ may be substituted by an alkyl group, an alkoxy group, an alkylthio group, a substituted carbonyl group, a substituted carboxyl group, an aryl group, an aryloxy group, an arylthio group, an aralkyl group, a monovalent aromatic heterocyclic group, a fluorine atom or a cyano group; a group selected from the group consisting of the groups represented by Ar¹¹, Ar¹⁴ and Ar¹⁵ and a group selected from the group consisting of the groups represented by Ar⁹, Ar¹⁰, Ar¹¹, Ar¹², Ar¹³ , Ar¹⁴ and Ar¹⁵ bonded to the same nitrogen atom as that to which that group bonds may be mutually bonded directly or bonded via - O-, -S-, -C (=O)-, -C (=O)-O-, -N(R⁶)-, -C(=O)-N(R⁶)- or -C(R⁶)(R⁶)- to form a 5- to 7-membered ring; m and mm represent each independently 0 or 1; X¹ represents -C(R⁷)=C(R⁷)- or -C≡C-; R⁷ represents a hydrogen atom, an alkyl group, an aryl group, a monovalent aromatic heterocyclic group, a fluorine atom or a cyano group; the group represented by R⁷ may have a substituent; when there are a plurality of Ar¹⁰s, Ar¹¹s, Ar¹⁴s and Ar¹⁵s, each of them may be the same or different; R⁶, R⁸ and R⁹ represent the same meaning as described above.

### Constituent unit represented by the formula (3)

It is preferable that the polymer compound of the present invention contains a constituent unit represented by the formula (3), from the standpoint of the light emission efficiency of a light emitting device obtained by using the polymer compound of the present invention, the easiness of adjustment of chromaticity obtained from the light emitting device, and the driving voltage or heat resistance of the light emitting device.

The arylene group represented by Ar⁸ means an atomic group obtained by removing two hydrogen atoms from an aromatic hydrocarbon, and includes groups having a condensed ring. The arylene group has a carbon atom number of usually 6 to 60, preferably 6 to 48, more preferably 6 to 30, further preferably 6 to 14. This carbon atom number does not include the carbon atom number of the substituent. The arylene group includes phenylene groups such as a 1,4-phenylene group, a 1,3-phenylene group, a 1,2-phenylene group and the like; naphthalenediyl groups such as a naphthalene-1,4-diyl group, a naphthalene-1,5-diyl group, a naphthalene-2,6-diyl group and the like; anthracenediyl groups such as an anthracene-1,4-diyl group, an anthracene-1,5-diyl group, an anthracene-2,6-diyl group, an anthracene-9,10-diyl group and the like; phenanthrenediyl groups such as a phenanthrene-2,7-diyl group and the like; dihydrophenanthrenediyl groups such as a 4,5-dihydrophenanthrene-2,7-diyl group and the like; naphthacenediyl groups such as a naphthacene-1,7-diyl group, a naphthacene-2,8-diyl group, a naphthacene-5,12-diyl group and the like; fluorenediyl groups such as a fluorene-2,7-diyl group, a fluorene-3,6-diyl group and the like; pyrenediyl groups such as a pyrene-1,6-diyl group, a pyrene-1,8-diyl group, a pyrene-2,7-diyl group, a pyrene-4,9-diyl group and the like; perylenediyl groups such as a perylene-2,5-diyl group, a perylene-2,8-diyl group, a perylene-3,9-diyl group, a perylene-3,10-diyl group and the like; benzofluorenediyl groups such as a 7H-benzo[c]fluorene-5,9-diyl group and the like; dihydroindenofluorenediyl groups such as a 6,12-dihydro-indeno[1,2-b]fluorene-2,8-diyl group and the like; etc. Any hydrogen atom in these arylene groups may be substituted by an alkyl group, an alkoxy group, an alkylthio group, a substituted carbonyl group, a substituted carboxyl group, an aryl group, an aryloxy group, an arylthio group, an aralkyl group, a monovalent aromatic heterocyclic group, -N(R⁸) (R⁹), a fluorine atom or a cyano group. The group represented by Ar⁸ is different from the group represented by the formula (1a) group.

The divalent aromatic heterocyclic group represented by Ar⁸ is an atomic group obtained by removing two hydrogen atoms from an aromatic heterocyclic compound, and includes also groups having a condensed ring. The divalent aromatic heterocyclic group has a carbon atom number of usually 3 to 60, preferably 3 to 20. This carbon atom number does not include the carbon atom number of the substituent. The divalent aromatic heterocyclic group includes an oxadiazole-2,5-diyl group; a thiadiazole-2,5-diyl group; thiazolediyl groups such as a thiazole-2,5-diyl group and the like; oxazolediyl groups such as an oxazole-2,5-diyl group and the like; thiophenediyl groups such as a thiophene-2,5-diyl group and the like; pyrrolediyl groups such as a pyrrole-2,5-diyl group and the like; furandiyl groups such as a furan-2,5-diyl group and the like; pyridinediyl groups such as a pyridine-2,5-diyl group, a pyridine-2,6-diyl group and the like; pyrazinediyl groups such as a pyrazine-2,5-diyl group and the like; pyrimidinediyl groups such as a pyrimidine-4,6-diyl group and the like; a triazine-2,4-diyl group; pyridazinediyl groups such as a pyridazine-3,6-diyl group and the like; quinolinediyl groups such as a quinolone-2,6-diyl group and the like; isoquinolinediyl groups such as an isoquinoline-1,4-diyl group and the like; quinoxalinediyl groups such as a quinoxaline-5,8-diyl group and the like; carbazolediyl groups such as a carbazole-2,7-diyl group, a carbazole-3,6-diyl group and the like; phenoxazinediyl groups such as a phenoxazine-3,7-diyl group, a phenoxazine-2,8-diyl group and the like; phenothiazinediyl groups such as a phenothiazine-3,7-diyl group, a phenothiazine-2,8-diyl group and the like; benzothiadiazolediyl groups such as a benzo[1,2,5]thiadiazole-4,7-diyl group and the like; benzothiazolediyl groups such as a benzothiazole-4,7-diyl group and the like; dibenzosilolediyl groups such as a dibenzosilole-2,7-diyl group, a dibenzosilole-3,6-diyl group and the like; etc. Any hydrogen atom in these divalent aromatic heterocyclic groups may be substituted by an alkyl group, an alkoxy group, an alkylthio group, a substituted carbonyl group, a substituted carboxyl group, an aryl group, an aryloxy group, an arylthio group, an aralkyl group, a monovalent aromatic heterocyclic group, - N(R⁸)(R⁹), a fluorine atom, a cyano group or the like.

In the formula (3), Ar⁸ is preferably a 1,4-phenylene group, a 1,3-phenylene group, a naphthalene-1,4-diyl group, a naphthalene-1,5-diyl group, a naphthalene-2,6-diyl group, an anthracene-2,6-diyl group, an anthracene-9,10-diyl group, a fluorene-2,7-diyl group, a fluoxene-3,6-diyl group, a pyrene-1,6-diyl group, a pyrene-1,8-diyl group, a perylene-3,9-diyl group, a 7H-benzo[c]fluorene-5,9-diyl group, a 6,12-dihydro-indeno[1,2-b]fluorene-2,8-diyl group, an oxadiazole-2,5-diyl group, a thiadiazole-2,5-diyl group, a thiophene-2,5-diyl group, a pyridine-2,5-diyl group, a quinolone-2,6-diyl group, an isoquinoline-1,4-diyl group, a quinoxaline-5,8-diyl group, a carbazole-2,7-diyl group, a carbazole-3,6-diyl group, a phenoxazine-2,7-diyl group, a phenoxazine-3,6-diyl group, a phenothiazine-2,7-diyl group, a phenothiazine-3,6-diyl group or a benzo[1,2,5]thiadiazole-4,7-diyl group, more preferably a 1,4-phenylene group, a naphthalene-1,4-diyl group, a naphthalene-2,6-diyl group, an anthracene-2,6-diyl group, an anthracene-9,10-diyl group, a fluorene-2,7-diyl group, a pyrene-1,6-diyl group, a perylene-3,9-diyl group, a 7H-benzo[c]fluorene-5,9-diyl group, a 6,12-dihydro-indeno[1,2-b]fluorene-2,8-diyl group, a quinolone-2,6-diyl group, a quinoxaline-5,8-diyl group, a phenoxazine-3,7-diyl group, a phenothiazine-3,7-diyl group or a benzo[1,2,5]thiadiazole-4,7-diyl group. Any hydrogen atom in these groups may be substituted by an alkyl group, an alkoxy group, an alkylthio group, a substituted carbonyl group, a substituted carboxyl group, an aryl group, an aryloxy group, an arylthio group, an aralkyl group, a monovalent aromatic heterocyclic group, -N(R⁸) (R⁹), a fluorine atom, a cyano group or the like.

Ar⁸ in the formula (3) is preferably a divalent group represented by the following formula (3a) or (3b), from the standpoint of the heat resistance of the polymer compound of the present invention, preferably a divalent group represented by the following formula (3b) or (3c), from the standpoint of the driving voltage and easiness of adjustment of chromaticity of a light emitting device obtained by using the polymer compound of the present invention, and preferably a divalent group represented by any of the following formulae (3b), (3d) and (3e), particularly preferably a divalent group represented by the following formulae (3b), from the standpoint of the light emission efficiency of a light emitting device obtained by using the polymer compound of the present invention. 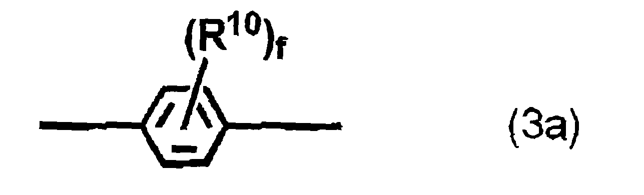 wherein R¹⁰ represents an alkyl group, an alkoxy group, an alkylthio group, a substituted carbonyl group, a substituted carboxyl group, an aryl group, an aryloxy group, an arylthio group, an aralkyl group, a monovalent aromatic heterocyclic group, -N(R⁸) (R⁹), a fluorine atom or a cyano group. f represent an integer of 0 to 4. When there are a plurality of R¹⁰ₛ, these may be the same or different. 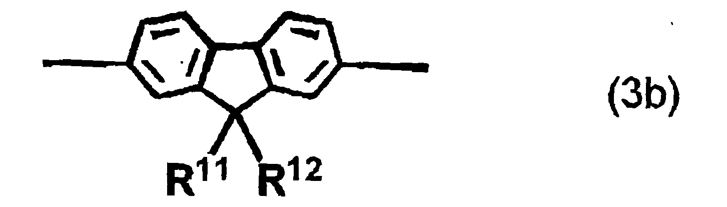 wherein R¹¹ and R¹² represent each independently a hydrogen atom, an alkyl group, an aryl group, an aralkyl group or a monovalent aromatic heterocyclic group; R¹¹ and R¹² may form a ring together. 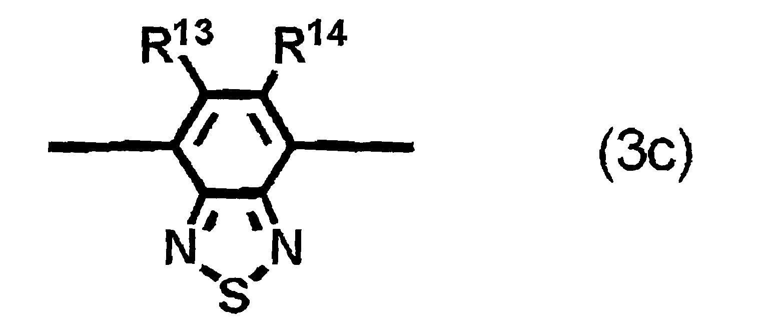 wherein R¹³ and R¹⁴ represent each independently a hydrogen atom, an alkyl group, an alkoxy.group, an alkylthio group, a substituted carbonyl group, a substituted carboxyl group, an aryl group, an aryloxy group, an arylthio group, an aralkyl group, a monovalent aromatic heterocyclic group, N(R⁸)(R⁹), a fluorine atom or a cyano group. 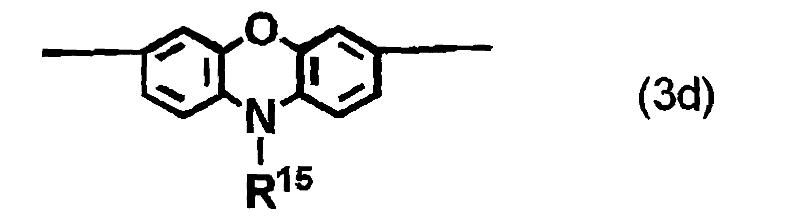 wherein R¹⁵ represents a hydrogen atom, an alkyl group, an aryl group, a monovalent aromatic heterocyclic group or an aralkyl group. 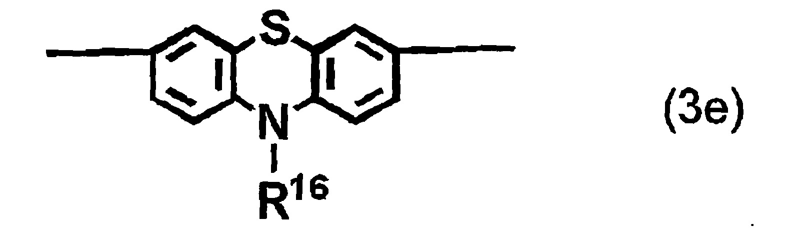 wherein R¹⁶ represents a hydrogen atom, an alkyl group, an aryl group, a monovalent aromatic heterocyclic group or an aralkyl group.

In the formula (3a), R¹⁰ is preferably an alkyl group, an alkoxy group, a substituted carbonyl group, an aryl group, an aryloxy group, an aralkyl group, a monovalent aromatic heterocyclic group or -N(R⁸) (R⁹), more preferably an alkyl group, an alkoxy group or an aryl group. The alkyl group, alkoxy group, alkylthio group, substituted carbonyl group, substituted carboxyl group, aryl group, aryloxy group, arylthio group and aralkyl group are the same as explained and exemplified as the substituent of R². The monovalent aromatic heterocyclic group represented by R¹⁰ is the same as explained and exemplified in the section of the monovalent aromatic heterocyclic group as the group represented by R².

In the formula (3a), f is preferably an integer of 1 to 4, more preferably 1 or 2, further preferably 2.

R¹¹ and R¹² in the formula (3b), R¹⁵ in the formula (3d) and R¹⁶ in the formula (3e) represent preferably an alkyl group, an aryl group or a monovalent aromatic heterocyclic group, more preferably an alkyl group or an aryl group. The alkyl group, aryl group and aralkyl group are the same as explained and exemplified as the substituent of R². The monovalent aromatic heterocyclic group represented by R¹¹, R¹², R¹⁵ and R¹⁶ is the same as explained and exemplified in the section of the monovalent aromatic heterocyclic group as the group represented by R².

In the formula (3c), R¹³ and R¹⁴ represent preferably a hydrogen atom or an alkyl group. The alkyl group is the same as explained and exemplified as the substituent of R². The monovalent aromatic heterocyclic group represented by R¹³ and R¹⁴ is the same as explained and exemplified in the section of the monovalent aromatic heterocyclic group as the group represented by R² .

### Constituent unit represented by the formula (4)

It is preferable that the polymer compound of the present invention contains a constituent unit represented by the formula (4), from the standpoint of improvement in the heat resistance of the polymer compound of the present invention, or from the standpoint the light emission efficiency or heat resistance of a light emitting device obtained by using the polymer compound.

The arylene group and the divalent group comprising two or more directly bonded identical or different arylene groups represented by Ar⁹ to Ar¹² in the formula (4) are the same as explained and exemplified as Ar¹ in the formula (2).

The aryl group and monovalent aromatic heterocyclic group represented by Ar¹³ to Ar¹⁵ in the formula (4) are the same as explained and exemplified as Ar² and Ar³ in the formula (2).

The constituent unit represented by the formula (4) includes preferably constituent units represented by the following formulae (4a) to (4d). R⁴ in these formulae represents a hydrogen atom, an alkyl group, an alkoxy group, an alkylthio group, a substituted carbonyl group, a substituted carboxyl group, an aryl group, an aryloxy group, an arylthio group, an aralkyl group, a monovalent aromatic heterocyclic group, a fluorine atom or a cyano group, preferably a hydrogen atom or an alkyl group. A plurality of R^{a}s may be the same or different. The alkyl group, alkoxy group, alkylthio group, substituted carbonyl group, substituted carboxyl group, aryl group, aryloxy group, arylthio group, aralkyl group and monovalent aromatic heterocyclic group are the same as explained and exemplified in the substituent section when R² in the formula (1a) has a substituent.

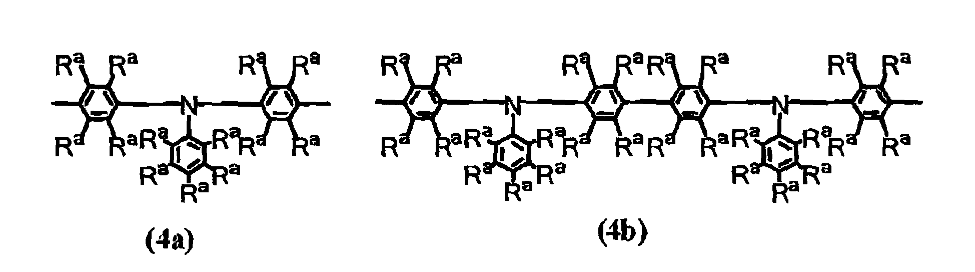

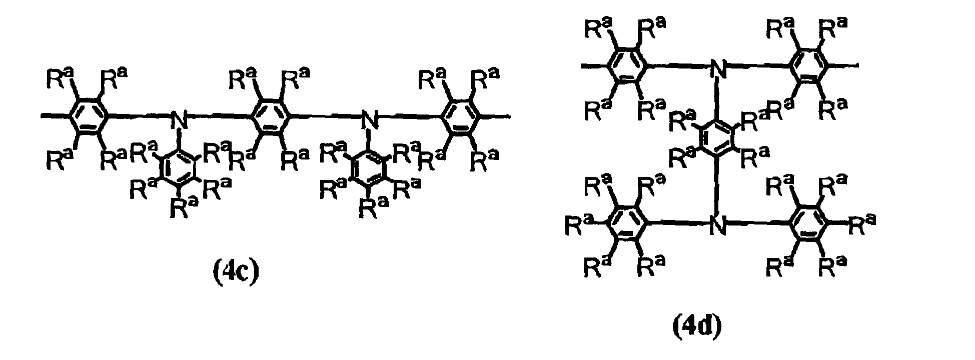

### Constituent unit represented by the formula (5)

The polymer compound of the present invention may contain a constituent unit represented by the formula (5) from the standpoint of adjustment of the chromaticity of a light emitting device obtained by using the polymer compound.

The arylene group, the divalent aromatic heterocyclic group and the divalent group obtained by direct bonding of two or more identical or different groups selected from the group consisting of the arylene group and the divalent aromatic heterocyclic group represented by Ar¹⁶ in the formula (5) are the same as explained and exemplified as Ar⁸.

R⁷ which can be contained in X¹ in the formula (5) represents preferably a hydrogen atom, an alkyl group or an aryl group, more preferably a hydrogen atom or an aryl group. The alkyl group and aryl group may have a substituent. The alkyl group and aryl group are the same as explained and exemplified as the substituent of R² in the formula (1a). The monovalent aromatic heterocyclic group represented by R⁷ is the same as explained and exemplified in the section of the monovalent aromatic heterocyclic group as the group represented by R².

As the constituent unit represented by the formula (5), constituent units represented by the following formulae (5a) to (5k) are preferable.

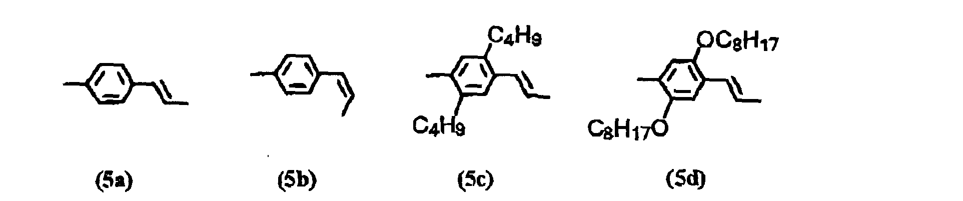

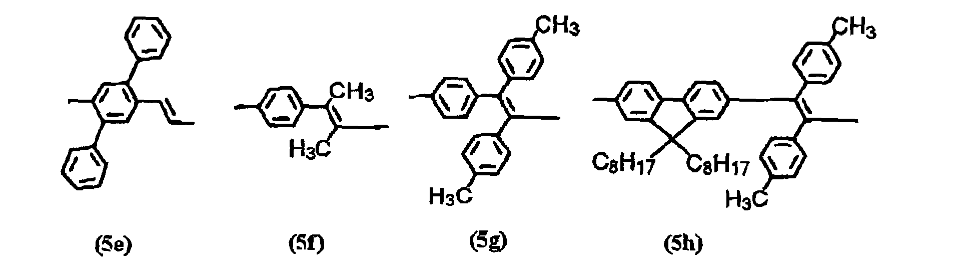

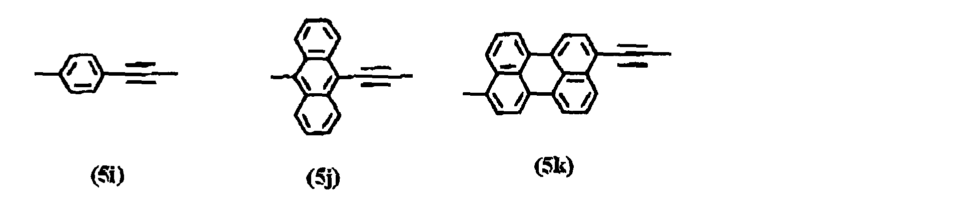

### -Polymer compound of the present invention-

In the polymer compound of the present invention, the molar amount of a constituent unit represented by the formula (1a) with respect to the total molar amount of all constituent units is preferably 0.1 to 100%, more preferably 0.5 to 50%, further preferably 1 to 20%, from the standpoint of the light emission efficiency of a light emitting device.

When constituent units represented by the formulae (3) to (5) are further contained in addition to a constituent unit represented by the formula (1a) in the polymer compound of the present invention, the total molar amount of constituent units represented by the formulae (1a), (3) to (5) with respect to the total molar amount of all constituent units is preferably 90 to 100%, more preferably 95 to 100%, further preferably 98 to 100%, particularly preferably 100%, from the standpoint of the light emission efficiency of a light emitting device.

Moreover, when constituent units represented by the formulae (3) and (4) are further contained in addition to a constituent unit represented by the formula (1a) in the polymer compound of the present invention, the total molar amount of constituent units represented by the formulae (1a), (3) and (4) with respect to the total molar amount of all constituent units is preferably 90 to 100%, more preferably 95 to 100%, from the standpoint of the heat resistance of the polymer compound and the light emission efficiency of a light emitting device.

As the polymer compound of the present invention, preferable are polymer compounds consisting of at least one constituent unit selected from the group consisting of constituent units represented by the formulae (3) and (4), in addition to a constituent unit represented by the formula (1a).

Additionally, the polymer compound of the present invention includes a polymer compound consisting of a constituent unit represented by the formula (1); a polymer compound consisting of constituent units represented by the formulae (1) and (3a); a polymer compound consisting of constituent units represented by the formulae (1), (3a) and (3b); a polymer compound consisting of constituent units represented by the formulae (1), (3a) and (4a); a polymer compound consisting of constituent units represented by the formulae (1), (3a), (3b) and (4a); a polymer compound consisting of constituent units represented by the formulae (1) and (3b); a polymer compound consisting of constituent units represented by the formulae (1), (3b) and (3c); a polymer compound consisting of constituent units represented by the formulae (1), (3b), (3c) and (3d); a polymer compound consisting of constituent units represented by the formulae (1), (3b), (3c) and (4d); a polymer compound consisting of constituent units represented by the formula (1), (3b) and (3d); a polymer compound consisting of constituent units represented by the formula (1), (3b) and (3e); a polymer compound consisting of constituent units represented by the formula (1), (3b) and (4a); a polymer compound consisting of constituent units represented by the formula (1), (3b) and (4b); a polymer compound consisting of constituent units represented by the formula (1), (3b) and (4c); a polymer compound consisting of constituent units represented by the formula (1), (3b) and (4d); a polymer compound consisting of constituent units represented by the formula (1) and (4a); a polymer compound consisting of constituent units represented by the formula (1) and (4b); a polymer compound consisting of constituent units represented by the formula (1) and (4c); and a polymer compound consisting of constituent units represented by the formula (1) and (4d). Specific examples of the polymer compound of the present invention include the following polymer compounds. In the formulae, v/w, v'/w'/x', v'/w'/x", v"'/w'"/x"', v^{IV}/w^{IV}/x^{IV} and v^{v}/w^{v}/x^{v} represent a molar ratio of two or three constituent units. 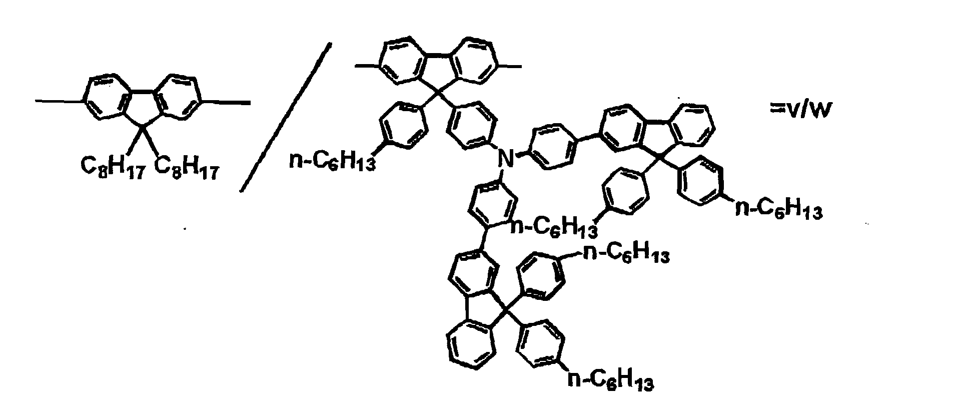 [wherein v is a number of 0 to 0.99, w is a number of 0.01 to 1, and v+wm1.3] 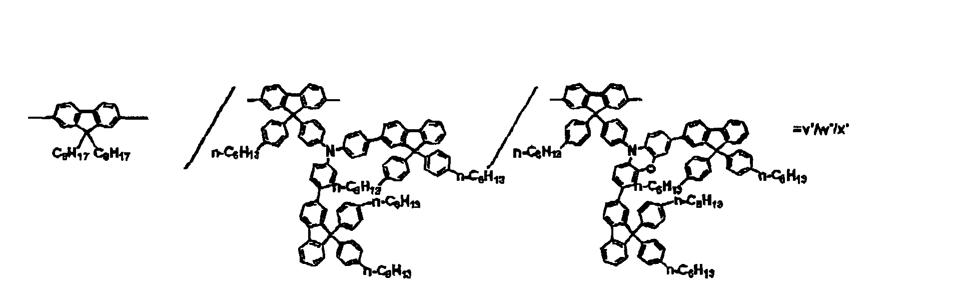 [wherein v' is a number of 0 to 0.98, w' is a number of 0.01 to 0.99, x' is a number of 0.01 to 0.99, and v'+w'+x'=1.] 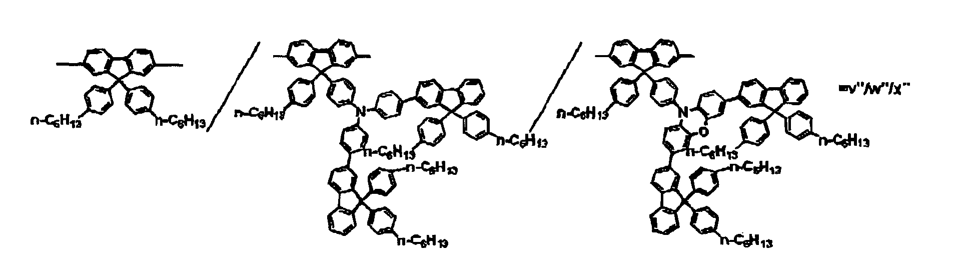 [wherein v" is a number of 0 to 0.98, w" is a number of 0.01 to 0.99, x" is a number of 0.01 to 0.50, and v''+w''+x"=1.] 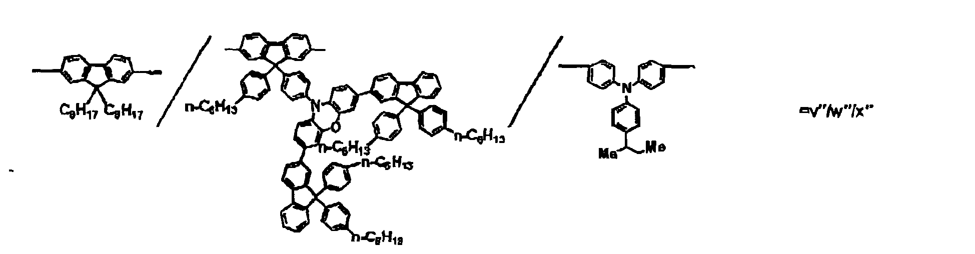 [wherein v'' is a number of 0 to 0.98, w'' is a number of 0.01 to 0.99, x'' is a number of 0.01 to 0.50, and v''+w''+x''=1.] 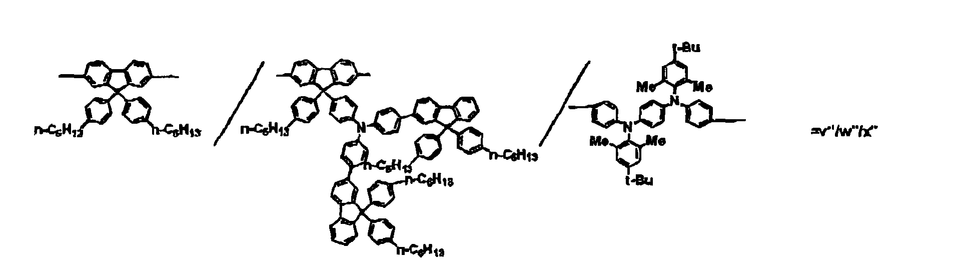 [wherein v'' is a number of 0 to 0.98, w'' is a number of 0.01 to 0.99, x" is a number of 0.01 to 0.50, and v"+w"+x"=1.] 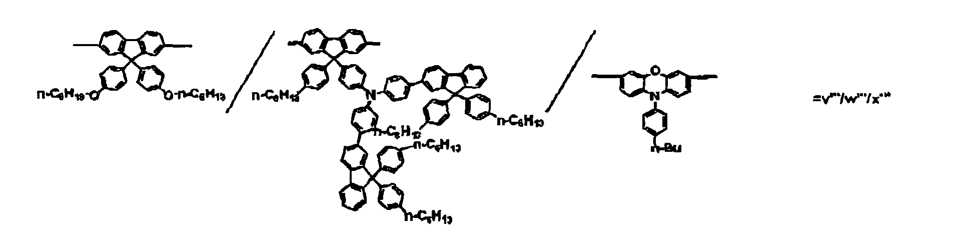 [wherein v"' is a number of 0 to 0.98, w"' is a number of 0.01 to 0.99, x"' is a number of 0.01 to 0.50, and v"'+w"'+x"'=1.] 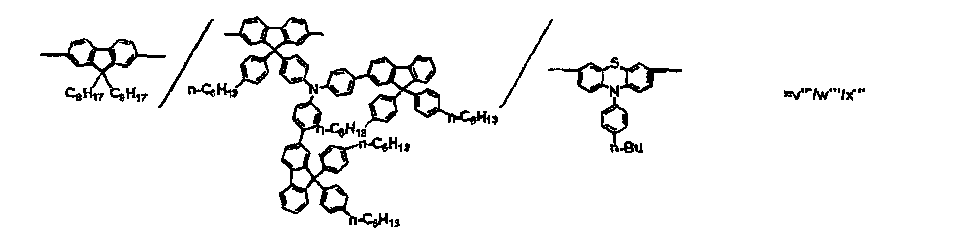 [wherein v"' is a number of 0 to 0.98, w"' is a number of 0.01 to 0.99, x"' is a number of 0.01 to 0-50, and v"'+w"'+x"'=1.] 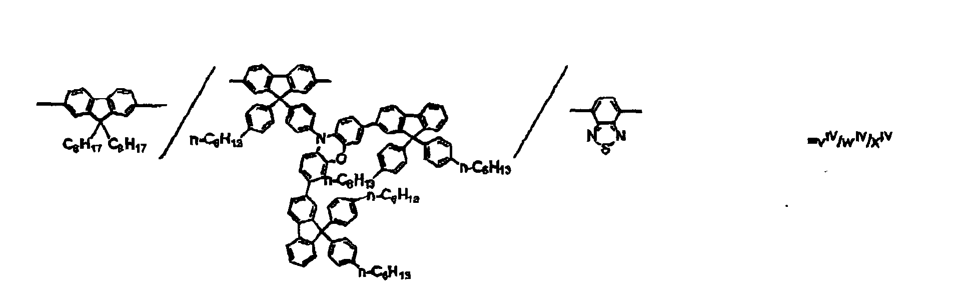 [wherein v^{IV} is a number of 0 to 0.98, w^{IV} is a number of 0.01 to 0.99, x^{IV} is a number of 0.01 to 0.50, and v^{IV}+w^{IV}+x^{IV}=1.] 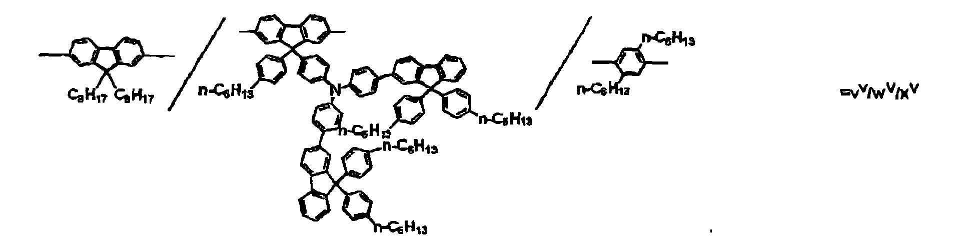 [wherein v^{V} is a number of 0 to 0.98, w^{V} is a number of 0.01 to 0.99, x^{V} is a number of 0.01 to 0.50, and v^{v}+w^{v}+x^{v}=1.].

As for the end group of the polymer compound of the present invention, if a polymerization active group remains intact thereon, there is a possibility of reduction in a light emitting property and life when the polymer compound is used for fabrication of a light emitting device, thus, the end group is preferably a stable group. The end group preferably has a conjugated bond to the main chain, and preferably has a bond to an aryl group or a monovalent aromatic heterocyclic group via a carbon-carbon bond.

In the polymer compound of the present invention, a constituent unit represented by the formula (1a) and constituent units represented by the formulae (3) to (5) may each be contained singly or in combination of two or more.

The polymer compound of the present invention may take any form such as a linear polymer, branched polymer, hyperbranch polymer, cyclic polymer, comb polymer, star polymer, network polymer and the like, and may be a polymer having any composition and regularity such as a homo polymer, alternating copolymer, periodic copolymer, random copolymer, block copolymer, graft copolymer and the like having any form described above.

The polymer compound of the present invention is useful as a light emitting material, charge transporting material and the like, and in use thereof, it may be used together with other compound to give a composition described later.

The polystyrene-equivalent number average molecular weight (Mn) according to gel permeation chromatography (hereinafter, referred to as "GPC") of the polymer compound of the present invention is usually 1× 10³ to 1×10⁸, preferably 1×10⁴ to 1×10⁶. The polystyrene-equivalent weight average molecular weight (Mw) of the polymer compound of the present invention is usually 1×10³ to 1×10⁸, and from the standpoint of film formability and the light emission efficiency of a light emitting device, is preferably 1×10⁶ to 5×10⁶, more preferably 3×10⁴ to 1×10⁶, further preferably 5×10⁴ to 5×10⁵.

From the standpoint of durability against various processes for manufacturing a light emitting device and the like and heat resistance and stability against heat generation during driving of a light emitting device, it is preferable that the glass transition temperature of the polymer compound of the present invention is 100°C or higher.

The polymer compound of the present invention usually emits fluorescence or phosphorescence at the solid state, and is useful as a material of a light emitting device. A light emitting device using this polymer compound is a high performance light emitting device which can be driven at high light emission efficiency. Therefore, this light emitting device is useful for backlight of a liquid crystal display; curved or flat light sources for illumination; segment type display devices; displays such as a dot matrix type flat panel display and the like. Further, the polymer compound of the present invention can also be used as a dye for laser; a material for an organic solar battery; an organic semiconductor for an organic transistor; a material for conductive films such as electric conductive films, organic semiconductor films and the like; or a material of a luminous film emitting fluorescence or phosphorescence.

### Method of producing polymer compound

The polymer compound of the present invention can be synthesized, for example, by polymerizing or copolymerizing a monomer represented by the formula (A) having a functional group suitable for the polymerization reaction to be used, according to a known polymerization method such as aryl coupling and the like using an alkali, a suitable catalyst, and a compound as a ligand, if necessary together with a compound selected from the group consisting of compounds represented by the following formulae (M-1) to (M-3), and if necessary under a condition of dissolution in an organic solvent.

**X^{a}-Ar⁸-X^{b}** (M-1)

wherein Ar⁶, X^{a} and X^{b} have the same meaning as described above. 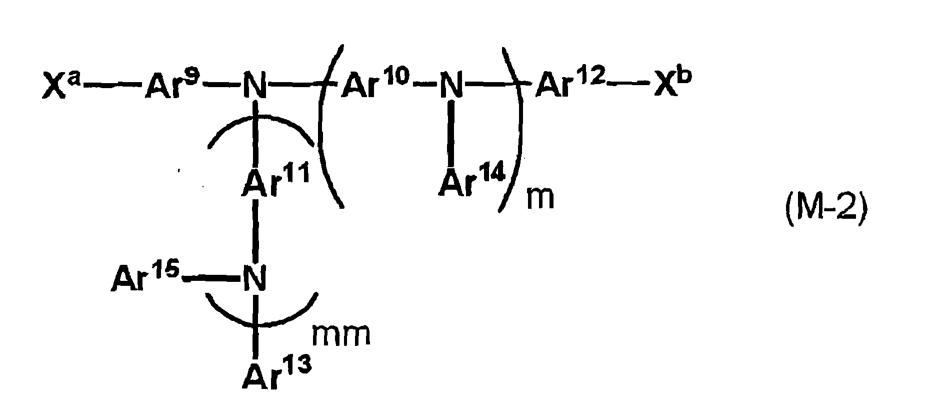 wherein Ar⁹ to Ar¹⁵, m, mm, X^{a} and X^{b} have the same meaning as described above.

**X^{a}-Ar¹⁶- X¹-X^{b}** (M-3)

wherein Ar¹⁶, X¹, X^{a} and X^{b} have the same meaning as described above.

In the formula (A), the alkyl groups represented by R²⁰, R²¹ and R²² may each independently be any of linear, branched or cyclic, and the carbon atom number thereof is usually 1 to 20, preferably 1 to 15, more preferably 1 to 10.

The alkyl group represented by R²⁰ in the formula (A) is the same as explained and exemplified in the explanation of the substituent of R².

The aryl group represented by R²⁰ in the formula (A) is the same as explained and exemplified as the aryl group represented by R², and particularly preferable from the standpoint of the easiness of synthesis of the polymer compound of the present invention and the reactivity of polymerization are a phenyl group, a 4-tolyl group, a 4-methoxyphenyl group, a 4-nitrophenyl group, a 3-nitrophenyl group, a 2-nitrophenyl group and a 4-trifluoromethylphenyl group.

The group represented by -O-S(=O)₂R²⁰ in the formula (A) includes a methanesulfonyloxy group, a trifluoromethanesulfonyloxy group, a phenylsulfonyloxy group, a 4-methylphenylsulfonyloxy group, a 4-trifluoromethylphenylsulfonyloxy group and the like.

The group represented by -B(OR²¹)₂ in the formula (A) includes groups represented by the following formulae, and the like.

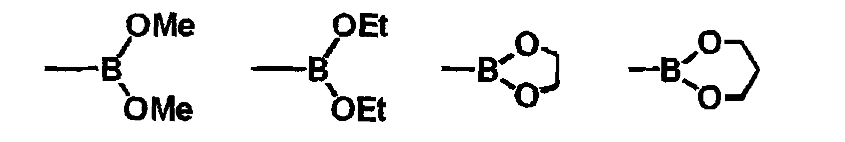

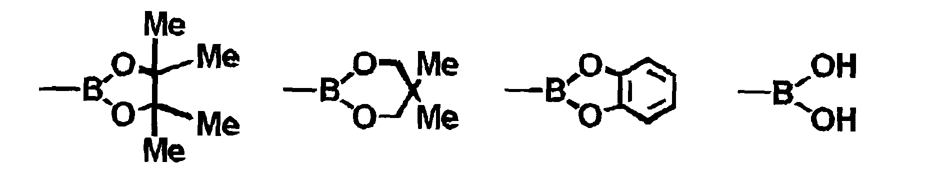

The group represented by -BF₄Q¹ in the formula (A) includes a group represented by the following formula, and the like.

**-BF₄⁻ K⁺**

The group represented by -Sn(R²²)₃ in the formula (A) includes a trimethylstannanyl group, a triethylstannanyl group, a tributylstannanyl group and the like.

The compounds represented by the formulae (A), (M-1) to (M-3) may be previously synthesized and isolated before use, or may be synthesized in the reaction system and used as they, and when the polymer compound of the present invention is used in a light emitting device, its purity exerts an influence on the performance of a device such as a light emission property, thus, it is preferable that monomers before polymerization are purified by distillation, sublimation purification, re-crystallization and the like before carrying out condensation polymerization.

The condensation polymerization method includes a method of polymerization by the Suzuki coupling reaction (Chem. Rev., vol. 95, p. 2457-2483 (1995 )), a method of polymerization by the Grignard reaction (Bull. Chem. Soc. Jpn., vol. 51, p. 2091 (1978)), a method of polymerization with a Ni(O) catalyst (Progress in Polymer Science, vol. 17, p. 1153 to 1205,1992), a method of using the Stille coupling reaction (European Polymer Journal, vol. 41, p. 2923-2933 (2005)), and the like, and the method of polymerization by the Suzuki coupling reaction and the method of polymerization with a Ni(O) catalyst are preferable from the standpoint of the easiness of synthesis of a raw material and the simplicity of the polymerization reaction operation, and the method of polymerization by the Suzuki coupling reaction is more preferable from the standpoint of the easiness of control of the structure of a polymer compound.

X^{a} and X^{b} in the formulae (M-1) to (M-3) represent preferably a bromine atom, an iodine atom, a chlorine atom, -B(OR²¹)₂, -BF₄Q¹ or -Sn(R²²)₃ from the standpoint of the easiness of synthesis of the polymer compound of the present invention, and particularly when the method of polymerization by the Suzuki coupling reaction is selected as the condensation polymerization method, represent more preferably a bromine atom, an iodine atom, a chlorine atom or -B(OR²¹)₂, further preferably a bromine atom or - B(OR²¹)₂ from the standpoint of the easiness of handling and the simplicity of synthesis of compounds represented by the formulae (A), (M-1) to (M-3).

The condensation polymerization method includes a method in which compounds represented by the formulae (A), (M-1) to (M-3) are reacted, if necessary together with a suitable catalyst and a suitable base. Particularly when the method of polymerization by the Suzuki coupling reaction is selected as the condensation polymerization method, the ratio of the total molar amount of a bromine atom, an iodine atom and a chlorine atom represented by X^{a} and X^{b} to the total molar amount of groups represented by - B(OR²¹)₂, contained in the compounds represented by the formulae (A), (M-1) to (M-3), is preferably 0.95 to 1.05, more preferably 0.98 to 1.02, for obtaining the sufficient molecular weight of the polymer compound of the present invention.

In polymerization by the Suzuki coupling reaction, there are mentioned catalysts composed of a transition metal complex such as a palladium complex such as palladium[tetrakis(triphenylphosphine)], [tris(dibenzylideneacetone)]dipalladium, palladium acetate, dichlorobistriphenylphosphinepalladium and the like, and if necessary, further a ligand such as triphenylphosphine, tri(t-butylphosphine), tricyclohexylphosphine and the like. In polymerization with a Ni(O) catalyst, there are mentioned catalysts composed of a transition metal complex such as a nickel complex such as nickel[tetrakis(triphenylphosphine)], [1,3-bis(diphenylphosphino)propane]dichloronickel, [bis(1,4-cyclooctadiene)]nickel and the like, and if necessary, further a ligand such as triphenylphosphine, tri(t-butylphosphine), tricyclohexylphosphine, diphenylphosphinopropane, bipyridyl and the like. The catalysts may be previously synthesized before use, or may be prepared in the reaction system and used as they are. The catalysts may be used singly or in combination of two or more.

When a catalyst is used, the amount of the catalyst may be an effective amount as a catalyst. The amount of transition metal compounds with respect to the total molar amount of compounds represented by the formulae (A), (M-1) to (M-3) is usually 0.00001 to 3 mol equivalent, preferably 0.00005 to 0.5 mol equivalent, more preferably 0.0001 to 0.2 mol equivalent.

In polymerization by the Suzuki coupling reaction, the reaction is carried out usually in the presence of a base. The base includes inorganic bases such as sodium carbonate, potassium carbonate, cesium carbonate, potassium fluoride, cesium fluoride, tripotassium phosphate and the like, and organic bases such as tetrabutylammonium fluoride, tetrabutylammonium chloride, tetrabutylammonium bromide, tetrabutylammonium hydroxide and the like.

In the case of use of a base, its amount is usually 0.5 to 20 mol equivalent, preferably 1 to 10 mol equivalent with respect to the total molar amount of compounds represented by the formulae (A), (M-1) to (M-3).

The condensation polymerization may be carried out in the absence of a solvent or may be carried out in the presence of a solvent, and usually, it is carried out in the presence of an organic solvent.

The organic solvent includes toluene, xylene, mesitylene, tetrahydrofuran, 1,4-dioxane, dimethoxyethane, N,N-dimethylacetamide, N,N-dimethylformamide and the like. In general, it is desirable to carry out a deoxidation treatment of the organic solvent, for suppressing side reactions. The organic solvents may be used singly or in combination of two or more.

The use amount of the organic solvent is so regulated that the total concentration of compounds represented by the formulae (A), (M-1) to (M-3) is usually 0.1 to 90 wt%, preferably 1 to 50 wt%, more preferably 2 to 30 wt% on the basis of the total weight of the organic solvent and the compounds represented by the formulae (A), (M-1) to (M-3).

The reaction temperature of condensation polymerization is preferably -100 to 200°C, more preferably -80 to 150°C, further preferably 0 to 120°C.

The reaction time is usually 1 hour or more, preferably 2 to 500 hours, depending on conditions such as the reaction temperature and the like.

The condensation polymerization is carried out under dehydration conditions if X^{a} and X^{b} in the formulae (A), (M-1) to (M-3) are groups represented by -MgY¹.

In the condensation polymerization, a compound represented by the following formula (M-4) may be used as a chain terminator, for avoiding remaining of a polymerization active group at the end of the polymer compound of the present invention. By this, a polymer compound can be obtained of which end is substituted by an aryl group or a monovalent aromatic heterocyclic group.

**X^{c}-Ar²⁴** (M-4)

wherein Ar²⁴ represents an aryl group or a monovalent aromatic heterocyclic group; X^{c} represents a bromine atom, an iodine atom, a chlorine atom, -O-S(=O)₂R²⁰, -B(OR²¹)₂, -BF₄Q¹, -Sn(R²²)₃, -MgY¹ or ZnY¹; R²⁰ represents an alkyl group, or an aryl group optionally substituted by an alkyl group, an alkoxy group, a nitro group, a fluorine atom or a cyano group; R²¹ and R²² represent each independently a hydrogen atom or an alkyl group.; two R²¹ s may be the same or different and may form a ring together; three R²² s may be the same or differentand may form a ring together; Q¹ represents a monovalent cation of lithium, sodium, potassium, rubidium or cesium; Y¹ represents a bromine atom, an iodine atom or a chlorine atom.

The atom or group represented by X^{c} in the formula (M-4) is the same as explained and exemplified as the atom or group represented by X^{a} and X^{b}.

The aryl group and monovalent aromatic heterocyclic group represented by Ar²⁴ in the formula (M-4) are the same as explained and exemplified as the aryl group and monovalent aromatic heterocyclic group represented by R².

The post-treatment of condensation polymerization can be carried out by a known method. The post-treatment can be carried out, for example, by a method in which a reaction solution obtained by condensation polymerization is added to a lower alcohol such as methanol and the like thereby causing deposition of a precipitate which is then filtrated and dried.

When the purity of the polymer compound of the present invention is low, the polymer compound can be purified by a usual method such as re-crystallization, continuous extraction by a Soxhlet extractor, column chromatography and the like. When the polymer compound of the present invention is used in a light emitting device, its purity exerts an influence on the performance of a device such as a light emission property and the like, thus, it is preferable, after condensation polymerization, to perform a refinement treatment such as re-precipitation purification, chromatographic fractionation and the like.

### <Monomer>

### -Compound represented by the formula (A)-

One of two connecting bonds in constituent units represented by the formula (1) (for example, constituent units represented by the formulae (1-001) to (1-005), (1-101) to (1-106), (1-201) to (1-202), (1-301) to (1-303)) and substituted bodies thereof is substituted by a group represented by X^{a} and another connecting bond is substituted by a group represented by X^{b}, thus obtained compounds are mentioned as the compound represented by the formula (A).

### Method of producing compound represented by the formula (A)

A compound represented by the formula (A) can be synthesized, for example, by a coupling reaction of a compound represented by the following formula (B) and a compound represented by the following formula (C) in the presence of an acid, if necessary under a condition of dissolution or suspension in a solvent, as shown in the following scheme 1. The compound represented by the formula (B) can be synthesized, for example, by reacting a fluorenone derivative with a Grignard reagent and an organolithium reagent.

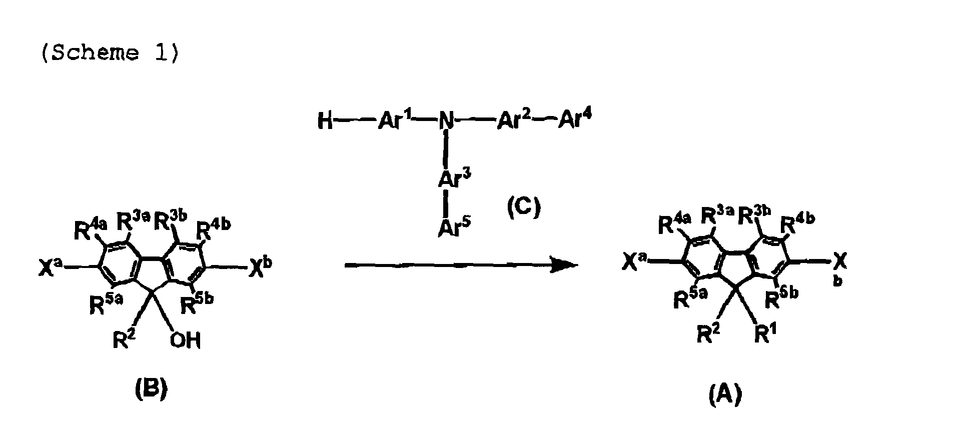

The use amount of the compound represented by the formula (C) is usually 0.8 to 2 mol with respect to 1 mol of the compound represented by the formula (B), and from the standpoint of the easiness of purification of the resulting compound represented by the formula (A), it is preferably 0.9 to 1.5 mol.

The acid includes a boron trifluoride diethyl ether complex, trifluoromethanesulfonic acid, methanesulfonic acid, trifluoroacetic acid, sulfuric acid, polyphosphoric acid and the like, and preferable is a boron trifluoride diethyl ether complex. The use amount of the acid varies depending on its kind, and when, for example, a boron trifluoride diethyl ether complex is used, the use amount of the boron trifluoride diethyl ether complex is usually 1 to 10 mol, preferably 1 to 2 mol with respect to 1 mol of the compound represented by the formula (B) from the standpoint of reactivity and economy.

In the case of use of a solvent, the solvent includes organic solvents such as toluene, xylene, mesitylene, chlorobenzene, o-dichlorobenzene, dichloromethane, chloroform, carbon tetrachloride and the like. In the case of use of a boron trifluoride diethyl ether complex as the acid, the solvent includes preferably chlorobenzene, o-dichlorobenzene, dichloromethane, chloroform and carbon tetrachloride, more preferably dichloromethane, chloroform and carbon tetrachloride. It is preferable to use a combination of a boron trifluoride diethyl ether complex and an organic solvent, from the standpoint of easiness of handling such as easiness of control of the reaction temperature, and the like.

The reaction is preferably carried out under light shielding from the standpoint of the stability of the compound represented by the formula (B) and the compound represented by the formula (A)

The reaction temperature of the reaction is usually - 50 to 300°C, and in the case of use of a combination of a boron trifluoride diethyl ether complex and an organic solvent, it is preferably -20 to 100°C. When an organic solvent is used, the reaction may be performed under a reflux condition.

After completion of the reaction, water, alcohol and the like are added to stop the reaction, then, undesired components such as water, alcohol and the like are removed by washing, liquid separation and the like, then, usual operations such as column chromatography, re-crystallization and the like are carried out, thus, the compound represented by the formula (A) can be obtained.

### <Composition>

The polymer compound of the present invention can be mixed with other components and used as a composition, and for example, can be combined with at least one component selected from the group consisting of a hole transporting material, an electron transporting material and a light emitting material, and used in the form of a composition as a light emitting material, a hole transporting material or an electron transporting material.

Regarding the ratio of at least one component selected from the group consisting of a hole transporting material, an electron transporting material and a light emitting material to the polymer compound of the present invention in a composition, the weight of the hole transporting material, electron transporting material and light emitting material is usually 1 to 400 parts by weight, preferably 5 to 150 parts by weight with respect to 100 parts by weight of the polymer compound of the present invention, when the composition of the present invention is used for the light emitting material.

The polystyrene-equivalent number average molecular weight of the composition of the present invention is usually 1×10³ to 1×10⁸, preferably 1×10⁴ to 1×10⁶. The polystyrene-equivalent weight average molecular weight of the composition of the present invention is usually 1×10³ to 1×10⁸, and from the standpoint of film formability and the light emission efficiency of the resultant light emitting device, preferably 1×10⁴ to 5×10⁶. Here, the average molecular weight of the composition of the present invention denotes a value obtained by analyzing the composition by GPC.

### <Solution>

The solution of the present invention is a solution containing the polymer compound of the present invention and a solvent, or a solution composed of the composition of the present invention containing a solvent. This solution is useful for a printing method and the like, and in general, called an ink, an ink composition or the like, in some cases. The solvent of the present invention may contain a hole transporting material (material used in a hole transporting layer described later), an electron transporting material (material used in an electron transporting layer described later), a light emitting material, a stabilizer, a thickening agent (high molecular weight compound for enhancing viscosity), a low molecular weight compound for lowering viscosity, a surfactant, an antioxidant, a high molecular weight compound other than the polymer compound, and the like. Components contained in the solution of the present invention may each be composed of a single ingredient or a combination of two or more ingredients.

The proportion of the polymer compound of the present invention in the solution of the present invention is usually 0.1 to 99 parts by weight, preferably 0.5 to 40 parts by weight, more preferably 0.5 to 20 parts by weight, with respect to 100 parts by weight of the whole solution.

Though the viscosity of the solution of the present invention can be adjusted depending on a printing method, the viscosity at 25°C is preferably in the range of 1 to 20 mPa·s, for preventing clogging and flying curving in discharging, when the solution passes through a discharge apparatus such as in an inkjet print method and the like.

The thickening agent may advantageously be an agent which is soluble in the same solvent as for the polymer compound of the present invention and which does not disturb light emission and charge transportation, and use can be made of, for example, high molecular weight polystyrene, high molecular weight polymethyl methacrylate and the like. The compound used as the thickening agent has a polystyrene-equivalent weight average molecular weight of preferably 5×10⁵ or more, more preferably 1×10⁶ or more.

The antioxidant is an agent for improving the preservation stability of the solution of the present invention. The antioxidant may advantageously be an agent which is soluble in the same solvent as for the polymer compound of the present invention and which does not disturb light emission and charge transportation, and includes a phenol antioxidant, a phosphorus antioxidant and the like.

As the solvent in the solution of the present invention, preferable are those capable of dissolving or uniformly dispersing solid components as a solute. The solvent includes chlorine-based solvents such as chloroform, methylene chloride, 1,2-dichloroethane, 1,1,2-trichloroethane, chlorobenzene, o-dichlorobenzene and the like; ether solvents such as tetrahydrofuran, dioxane, anisole and the like; aromatic hydrocarbon solvents such as toluene, xylene and the like; aliphatic hydrocarbon solvents such as cyclohexane, methylcyclohexane, n-pentane, n-hexane, n-heptane, n-octane, n-nonane, n-decane and the like; ketone solvents such as acetone, methyl ethyl ketone, cyclohexanone, benzophenone, acetophenone and the like; ester solvents such as ethyl acetate, butyl acetate, ethyl cellosolve acetate, methyl benzoate, phenyl acetate and the like; polyhydric alcohols such as ethylene glycol, ethylene glycol monobutyl ether, ethylene glycol monoethyl ether, ethylene glycol monomethyl ether, dimethoxyethane, propyrene glycol, diethoxymethane, triethylene glycol monoethyl ether, glycerin, 1,2-hexane diol and the like, and derivatives thereof; alcohol solvents such as methanol, ethanol, propanol, isopropanol, cyclohexanol and the like; sulfoxide solvents such as dimethyl sulfoxide and the like; amide solvents such as N-methyl-2-pyrrolidone, N,N-dimethylformamide and the like. These solvents may be used singly or in combination of two or more.

It is preferable to use two or more solvents, it is more preferable to use two to three solvents and it is particularly preferable to use two solvents, from the standpoint of film formability, device property and the like.

When two solvents are contained in the solution of the present invention, one of them may be solid at 25°C. From the standpoint of film formability, it is preferable that one solvent has a boiling point of 180°C or higher, more preferably a boiling point of 200°C or higher. From the standpoint of viscosity, a solution which can exist as a uniform solution at a temperature lower than the boiling point of the mixed solvent to be used is preferable as the solution of the present invention, and it is more preferable that the polymer compound of the present invention is dissolved at a concentration of 1 wt% or more at 60°C in any of the two solvents to be used, and it is particularly preferable that the polymer compound of the present invention is dissolved at a concentration of 1 wt% or more at 25°C in one of the two solvents.

When two or more solvents are contained in the solution of the present invention, the content of a solvent having the highest boiling point is preferably 40 to 90 wt%, more preferably 50 to 90 wt%, and further preferably 65 to 85 wt% with respect to the weight of all solvents contained in the solution, from the standpoint of viscosity and film formability.

The solution of the present invention may further contain water, metals and salts thereof, silicon, phosphorus, fluorine, chlorine, bromine and the like in an amount of 1 to 1000 ppm by weight. The metals include lithium, sodium, calcium, potassium, iron, copper, nickel, aluminum, zinc, chromium, manganese, cobalt, platinum, iridium and the like.

### <Film>

The film of the present invention comprises the polymer compound of the present invention, and is, for example, a luminous film, an electric conductive film, an organic semiconductor film or the like.

The film of the present invention can be fabricated by, for example, a spin coat method, a casting method, a micro gravure coat method, a gravure coat method, a bar coat method, a roll coat method, a wire bar coat method, a dip coat method, a spray coat method, a screen printing method, a flexo printing method, an offset printing method, an inkjet print method, a capillary coat method, a nozzle coat method and the like.

When a film is fabricated using the solution of the present invention, the glass transition temperature of the polymer compound of the present invention contained in the solution is high, thus, it is possible to perform baking at a temperature of 100°C or higher, and even if baking is performed at a temperature of 130°C, the device property scarcely lowers. Depending on the kind of the polymer compound, it is also possible to perform baking at a temperature of 160°C or higher.

The luminous film has a light emission quantum yield of preferably 30% or more, more preferably 50% or more, further preferably 60% or more, particularly preferably 70% or more, from the standpoint of the luminance and light emission voltage of a device and the like.

The electric conductive film has a surface resistance of preferably 1 KΩ/□ or less, more preferably 100 Ω/□ or less, further preferably 10 Ω/□ or less. By doping the electric conductive film with a Lewis acid, ionic compound or the like, electric conductivity can be enhanced.

In the organic semiconductor film, one larger parameter of electron mobility or hole mobility is preferably 10⁻⁵ cm²/V/s or more, more preferably 10⁻³ cm²/V/s or more, and further preferably 10⁻¹ cm²/V/s or more. By forming the organic semiconductor film on a Si substrate carrying a gate electrode and an insulation film made of SiO₂ and the like formed thereon, and forming a source electrode and a drain electrode with Au and the like, an organic transistor can be obtained.

### <Light emitting device>

The light emitting device of the present invention is a light emitting device having electrodes consisting of an anode and a cathode, and an organic layer containing the polymer compound disposed between the electrodes. At least one of the anode and the cathode is usually transparent or semi-transparent. The organic layer may be composed of one layer or may be composed of two or more layers, and when composed of two or more layers, at least one of them contains the polymer compound. The organic layer containing the polymer compound functions usually as a light emitting layer, a hole transporting layer or an electron block layer, and preferably, the organic layer functions as a light emitting layer. In the light emitting device of the present invention, other layers may be disposed between an anode and a light emitting layer and between a cathode and a light emitting layer, in addition to an anode, a cathode and a light emitting layer. In the light emitting device of the present invention, each layer may be composed of one layer or two or more layer, and each layer may be constituted of one material or compound, or two or more materials or a compounds.

The layer disposed between an anode and a light emitting layer includes a hole injection layer, a hole transporting layer, an electron block layer and the like. When only one layer is disposed between an anode and a light emitting layer, it is a hole injection layer, and when two or more layers are disposed between an anode and a light emitting layer, the layer next to an anode is a hole injection layer and other layers are hole transporting layers. The hole injection layer is a layer having a function of improving hole injection efficiency from a cathode. The hole transporting layer is a layer having a function of improving hole injection from a hole injection layer or a layer nearer to an anode. When a hole injection layer and a hole transporting layer have a function of blocking transportation of electrons, these layers are electron block layers. A function of blocking transportation of electrons can be confirmed, for example, by fabricating a device allowing only electron current and measuring decrease of its current value.

The layer disposed between a cathode and a light emitting layer includes an electron injection layer, an electron transporting layer, a hole block layer and the like. When only one layer is disposed between a cathode and a light emitting layer, it is an electron injection layer, and when two or more layers are disposed between a cathode and a light emitting layer, the layer next to a cathode is an electron injection layer and other layers are electron transporting layers. The electron injection layer is a layer having a function of improving electron injection efficiency from a cathode. The electron transporting layer is a layer having a function of improving electron injection from an electron injection layer or a layer nearer to a cathode. When an electron injection layer and an electron transporting layer have a function of blocking transportation of holes, these layers are called a hole block layer in some cases. A function of blocking transportation of holes can be confirmed, for example, by fabricating a device allowing only hole current and measuring decrease of its current value.

The structure of the light emitting device of the present invention includes, for example, the following structures a) to d).
a) anode/light emitting layer/cathode
b) anode/hole transporting layer/light emitting layer/cathode
c) anode/light emitting layer/electron transporting layer/cathode
d) anode/hole transporting layer/light emitting layer/electron transporting layer/cathode (here, "/" means adjacent lamination of layers, the same shall apply hereinafter).

Among hole transporting layers and electron transporting layers disposed adjacent to an electrode, those having a function of improving charge (hole, electron) injection efficiency from an electrode and having an effect of lowering the driving voltage of a device are called a charge injection layer (hole injection layer, electron injection layer) in some cases.

Further, for improving close adherence with an electrode or improving charge injection from an electron, a charge injection layer and an insulation layer may be disposed next to an electrode. For improving close adherence of an interface or preventing mixing, a thin buffer layer may be inserted into an interface of a charge transporting layer and a light emitting layer. The order and number of layers to be laminated, and the thickness of each layer can be adjusted in view of light emission efficiency and device life.

The structure of the light emitting device of the present invention having a charge injection layer includes, for example, the following structures e) to p).
e) anode/charge injection layer/light emitting layer/cathode
f) anode/light emitting layer/charge injection layer/cathode
g) anode/charge injection layer/light emitting layer/charge injection layer/cathode
h) anode/charge injection layer/hole transporting layer/light emitting layer/cathode
i) anode/hole transporting layer/light emitting layer/charge injection layer/cathode
j) anode/charge injection layer/hole transporting layer/light emitting layer/charge injection layer/cathode
k) anode/charge injection layer/light emitting layer/electron transporting layer/cathode
1) anode/light emitting layer/electron transporting layer/charge injection layer/cathode
m) anode/charge injection layer/light emitting layer/electron transporting layer/charge injection layer/cathode
n) anode/charge injection layer/hole transporting layer/light emitting layer/electron transporting layer/cathode
o) anode/hole transporting layer/light emitting layer/electron transporting layer/charge injection layer/cathode
p) anode/charge injection layer/hole transporting layer/light emitting layer/electron transporting layer/charge injection layer/cathode

### Anode

The anode is usually transparent or semi-transparent and constituted of film of a metal oxide, a metal sulfide or a metal having high electric conductivity, and particularly, the anode is preferably constituted of a material of high transmission. As the material of the anode, use is made of films (NESA and the like) formed using electric conductive inorganic compounds composed of indium oxide, zinc oxide, tin oxide, and composite thereof: indium·tin·oxide (ITO), indium·zinc·oxide and the like; and gold, platinum, silver, copper and the like, and ITO, indium·zinc·oxide and tin oxide are preferable. For fabrication of the anode, a vacuum vapor-deposition method, a sputtering method, an ion plating method, a plating method and the like can be used. As the anode, organic transparent electric conductive films made of polyaniline and its derivatives, polythiophene and its derivatives, and the like may be used.

The thickness of the anode can be selected in view of light transmission and electric conductivity, and it is usually 10 nm to 10 µm, preferably 20 nm to 1 µm, more preferably 50 nm to 500 nm.

### Hole injection layer

The material used in the hole injection layer includes phenyl amines, starburst type amines, phthalocyanines, oxides such as vanadium oxide, molybdenum oxide, ruthenium oxide, aluminum oxide and the like, amorphous carbon, electric conductive polymers such as polyaniline and derivatives thereof, polythiophene and derivatives thereof and the like, and the polymer compound of the present invention, and the like.

When the material used in the hole injection layer is an electric conductive polymer or the polymer compound of the present invention, anions such as a polystyrenesulfonic ion, an alkylbenzenesulfonic ion, a camphor sulfonic ion and the like may be doped, if necessary, for improving the electric conductivity of the electric conductive polymer or the polymer compound.

### Hole transporting layer

The material used in the hole transporting layer includes polyvinylcarbazoles and derivatives thereof, polysilanes and derivatives thereof, polysiloxane derivatives having an aromatic amine on its side chain or main chain, pyrazoline derivatives, arylamine derivatives, stilbene derivatives, triphenyldiamine derivatives, polyanilines and derivatives thereof, polythiophenes and derivatives thereof, polyarylamines and derivatives thereof, polypyrroles and derivatives thereof, poly(p-phenylenevinylene) and derivatives thereof, poly(2,5-thienylenevinylene) and derivatives thereof, the polymer compound of the present invention and the like, and preferable are polymer hole transporting materials such as polyvinylcarbazoles and derivatives thereof, polysilanes and derivatives thereof, polysiloxane derivatives having an aromatic amine compound group on its side chain or main chain, polyanilines and derivatives thereof, polythiophenes and derivatives thereof, polyarylamines and derivatives thereof, poly(p-phenylenevinylene) and derivatives thereof, poly(2,5-thienylenevinylene) and derivatives thereof, the polymer compound of the present invention and the like, further preferable are polyvinylcarbazoles and derivatives thereof, polysilanes and derivatives thereof, polysiloxane derivatives having an aromatic amine on its side chain or main chain, polyarylamines and derivatives thereof, and the polymer compound of the present invention. When the material used in the hole transporting layer is a low molecular weight compound, it is preferably dispersed in a polymer binder.

As the method of film formation of the hole transporting layer, film formation from a mixed solution with a polymer binder is used when the material used in the hole transporting layer is a low molecular weight compound, and film formation from a solution is used in the case of a polymer compound.

The solvent used for film formation from a solution dissolves materials used in the hole transporting layer. The solvent includes chlorine-based solvents such as chloroform, methylene chloride, dichloroethane and the like, ether solvents such as tetrahydrofuran and the like, aromatic hydrocarbon solvents such as toluene, xylene and the like, ketone solvents such as acetone, methyl ethyl ketone and the like, ester solvents such as ethyl acetate, butyl acetate, ethylcellosolve acetate and the like.

For film formation from a solution, there can be used application methods from a solution such as a spin coat method, a casting method, a micro gravure coat method, a gravure coat method, a bar coat method, a roll coat method, a wire bar coat method, a dip coat method, a spray coat method, a screen printing method, a flexo printing method, an offset printing method, an inkjet print method and the like.

As the polymer binder, those not extremely disturbing charge transportation are preferable, and those showing no strong absorption against visible light are suitably used. The polymer binder includes polycarbonate, polyacrylate, polymethyl acrylate, polymethyl methacrylate, polystyrene, polyvinyl chloride, polysiloxane and the like.

The thickness of the hole transporting layer can be selected in view of driving voltage and light emission efficiency, and a thickness causing no formation of pin holes is necessary, and when the thickness is too large, the driving voltage of a device increases undesirably. Therefore, the thickness of the hole transporting layer is usually 1 nm to 1 µm, preferably 2 nm to 500 nm, further preferably 5 nm to 200 nm.

### Light emitting layer

The light emitting layer is usually formed from an organic compound emitting fluorescence or phosphorescence (low molecular weight compound, polymer compound), and a dopant aiding this if necessary. In the light emitting layer in the light emitting device of the present invention, use can be made of light emitting materials such as the polymer compound of the present invention; dye materials such as cyclopendamine derivatives, tetraphenylbutadiene derivative compounds, triphenylamine derivatives, oxadiazole derivatives, pyrazoloquinoline derivatives, distyrylbenzene derivatives, distyrylarylene derivatives, pyrrole derivatives, thiophene ring compounds, pyridine ring compounds, anthracene derivatives, perylene derivatives, naphthacene derivatives, quinacridone derivatives, oligothiophene derivatives, trifumarylamine derivatives, oxadiazole dimers, pyrazoline dimers and the like; metal complex materials such as metal complexes showing light emission from the triplet excited state such as an iridium complex, a platinum complex and the like, an alumiquinolinol complex, a benzoquinolinol beryllium complex, a benzooxazolyl zinc complex, a benzothiazole zinc complex, an azomethyl zinc complex, a porphyrin zinc complex, a europium complex and the like, metal complexes having Al, Zn, Be and the like or a rare earth metal such as Tb, Eu, Dy and the like as the center metal and having an oxadiazole, thiadiazole, phenylpyridine, phenylbenzoimidazole or quinolone structure as a ligand; polymer materials such as polyparaphenylenevinylene derivatives, polythiophene derivatives, polyparaphenylene derivatives, polysilane derivatives, polyacetylene derivatives, polyfluorene derivatives, polyvinylcarbazole derivatives, those obtained by enhancing the molecular weight of the above-described dyes and metal complex light emitting materials, and the like.

Of the above-described light emitting materials, materials emitting blue color can be classified into blue fluorescent materials and blue phosphorescent materials. The blue fluorescent material includes distyrylarylene derivatives and polymers thereof, oxadiazole derivatives and polymers thereof, polyvinylcarbazole derivatives, polyparaphenylene derivatives, polyfluorene derivatives and the like, preferably polyvinylcarbazole derivatives, polyparaphenylene derivatives, polyfluorene derivatives and the like. The blue phosphorescent material includes an iridium complex.

Of the above-described light emitting materials, materials emitting green color can be classified into green fluorescent materials and green phosphorescent materials. The green fluorescent material includes quinacridone derivatives, coumarin derivatives, anthracene derivative and polymers thereof, polyparaphenylenevinylene derivatives, polyfluorene derivatives and the like, preferably polyparaphenylenevinylene derivatives, polyfluorene derivatives and the like. The green phosphorescent material includes an iridium complex.

Of the above-described light emitting materials, materials emitting red color can be classified into red fluorescent materials and red phosphorescent materials. The red fluorescent material includes coumarin derivatives and polymers thereof, thiophene compounds and polymers thereof, polyparaphenylenevinylene derivatives, polythiophene derivatives, polyfluorene derivatives and the like, preferably polyparaphenylenevinylene derivatives, polythiophene derivatives, polyfluorene derivatives and the like. The red phosphorescent material includes an iridium complex.

To the light emitting layer, a dopant can be added for improving light emission efficiency and changing light emission wavelength. The dopant can be classified into fluorescent dopants and phosphorescent dopants. The fluorescent dopant includes anthracene derivatives, perylene derivatives, coumarin derivatives, rubrene derivatives, quinacridone derivatives, squalium derivatives, porphyrin derivatives, styryl dyes, tetracene derivatives, pyrazolone derivatives, decacyclene, phenoxazone and the like. The phosphorescent dopant includes an iridium complex.

The thickness of the light emitting layer can be selected in view of driving voltage and light emission efficiency, and is usually about 2 to 200 nm.

For film formation of the light emitting layer, there can be used a method in which a solution containing a light emitting material is coated on or above a substrate, a vacuum vapor deposition method, a transfer method and the like. The solvent used for film formation from a solution is the same as explained and exemplified in the section of film formation from a solution of a hole transporting layer. For coating a solution containing a light emitting material on or above a substrate, there can be used printing methods such as a spin coat method, a dip coat method, an inkjet print method, a flexo printing method, a gravure printing method, a slit coat method and the like. In the case of a sublimating low molecular weight compound, a vacuum vapor deposition method can be used. Use can be made also of a method of forming a light emitting layer at a desired position, by laser transfer or thermal transfer.

### Electron transporting layer

The material used in the electron transporting layer includes oxadiazole derivatives, anthraquinodimethane and derivatives thereof, benzoquinone and derivatives thereof, naphthoquinone and derivatives thereof, anthraquinone and derivatives thereof, tetracyanoanthraquinodimethane and derivatives thereof, fluorenone derivatives, diphenyldicyanoethylene and derivatives thereof, diphenoquinone derivatives, metal complexes of 8-hydroxyquinoline and derivatives thereof, polyquinoline and derivatives thereof, polyquinoxaline and derivatives thereof, polyfluorene and derivatives thereof, and the like, preferably oxadiazole derivatives, benzoquinone and derivatives thereof, anthraquinone and derivatives thereof, metal complexes of 8-hydroxyquinoline and derivatives thereof, polyquinoline and derivatives thereof, polyquinoxaline and derivatives thereof, and polyfluorene and derivatives thereof, more preferably 2-(4-biphenylyl)-5-(4-t-butylphenyl)-1,3,4-oxadiazole, benzoquinone, anthraquinone, tris(8-quinolinol)aluminum and polyquinoline.

For film formation of the electron transporting layer, a vacuum vapor deposition method from a powder and a method of film formation from a solution or melted condition are used when the material used in the electron transporting layer is a low molecular weight compound, and a method of film formation from a solution or melted condition is used when the material used in the electron transporting layer is a polymer compound. For film formation from a solution or melted condition, a polymer binder may be used together. The film formation from a solution is the same as the method of forming a hole transporting layer from a solution.

The thickness of the electron transporting layer can be adjusted in view of driving voltage and light emission efficiency, and a thickness causing no formation of pin holes is necessary, and when the thickness is too large, the driving voltage of a device increases undesirably. Therefore, the thickness of the electron transporting layer is usually 1 nm to 1 µm, preferably 2 nm to 500 nm, further preferably 5 nm to 200 nm.

### Electron injection layer

The electron injection layer includes, depending on the kind of a light emitting layer, an electron injection layer having a single layer structure composed of a Ca layer, or an electron injection layer having a lamination structure composed of a Ca layer and a layer formed of one or two or more materials selected from the group consisting of metals belonging to group IA and group IIA of the periodit table of elements and having a work function of 1.5 to 3.0 eV excluding Ca, and oxides, halides and carbonates of the metals. As the metals belonging to group IA of the periodit table of elements and having a work function of 1.5 to 3.0 eV and oxides, halides and carbonates thereof, listed are lithium, lithium fluoride, sodium oxide, lithium oxide, lithium carbonate and the like. As the metals belonging to group IIA of the periodit table of elements and having a work function of 1.5 to 3.0 eV excluding Ca, and oxides, halides and carbonates thereof, listed are strontium, magnesium oxide, magnesium fluoride, strontium fluoride, barium fluoride, strontium oxide, magnesium carbonate and the like.

The electron injection layer is formed by a vapor deposition method, a sputtering method, a printing method and the like. The thickness of the electron injection layer is preferably 1 nm to 1 µm.

### Cathode material

As the material of the cathode, materials having a small work function and providing easy injection of electrons into a light emitting layer are preferable, and use is made of metals such as lithium, sodium, potassium, rubidium, cesium, beryllium, magnesium, calcium, strontium, barium, aluminum, scandium, vanadium, zinc, yttrium, indium, cerium, samarium, europium, terbium, ytterbium and the like, alloys composed of two or more of the above-described metals, or alloys composed of at least one of them and at least one of gold, silver, platinum, copper, manganese, titanium, cobalt, nickel, tungsten and tin, and, graphite or graphite intercalation compounds, and the like. The alloy includes a magnesium-silver alloy, a magnesium-indium alloy, a magnesium-aluminum alloy, an indium-silver alloy, a lithium-aluminum alloy, a lithium-magnesium alloy, a lithium-indium alloy, a calcium-aluminum alloy, and the like. When the cathode has a laminated structure consisting of two or more layers, preferable is a laminated structure composed of a metal, a metal oxide, a metal fluoride or an alloy thereof and of a metal such as aluminum, silver, chromium and the like.

The thickness of the cathode may be advantageously selected in view of electric conductivity and durability, and it is usually 10 nm to 10 µm, preferably 20 nm to 1 µm, further preferably 50 nm to 500 nm.

For fabrication of the cathode, a vacuum vapor deposition method, a sputtering method, a lamination method of thermally press-binding a metal film, and the like are used. After fabrication of the cathode, a protective layer for protecting a light emitting device may be installed. For use of a light emitting device stably for a long period of time, it is preferable to install a protective layer and/or a protective cover, for protecting the light emitting device from outside.

As the protective layer, high molecular weight compounds, metal oxides, metal fluorides, metal borides and the like can be used. As the protective cover, a metal plate, a glass plate, and a plastic plate having a surface which has been subjected to a low water permeation treatment, and the like can be used. As the protective method, a method in which the protective cover is pasted to a device substrate with a thermosetting resin or a photocuring resin to attain sealing is used. When a space is kept using a spacer, blemishing of a device can be prevented easily. If an inert gas such as nitrogen, argon and the like is filled in this space, oxidation of a cathode can be prevented, further, by placing a drying agent such as barium oxide and the like in this space, it becomes easy to suppress moisture adsorbed in a production process or a small amount of water invaded through a hardened resin from imparting a damage to the device. It is preferable to adopt at least one strategy among these methods.

The light emitting device of the present invention can be used as a planar light source, a display such as segment displays, dot matrix displays and the like, back light of a liquid crystal display, or the like. For obtaining light emission in the form of plane using the light emitting device of the present invention, a planar anode and a planar cathode are placed so as to overlap.

For obtaining light emission in the form of pattern, there are a method in which a mask having a window in the form of pattern is placed on the surface of a planar light emitting device, a method in which an organic layer in non-light emitting parts is formed with extremely large thickness to give substantially no light emission, a method in which either an anode or a cathode, or both electrodes are formed in the form of pattern. By forming a pattern by any of these methods, and placing several electrodes so that on/off is independently possible, a display of segment type is obtained which can display digits, letters, simple marks and the like. Further, for providing a dot matrix device, both an anode and a cathode are formed in the form of stripe, and placed so as to cross. By using a method in which several polymer compounds showing different emission colors are painted separately or a method in which a color filter or a fluorescence conversion filter is used, partial color display and multi-color display are made possible. In the case of a dot matrix device, passive driving is possible, and active driving may be carried out in combination with TFT and the like. These display devices can be used as a display of a computer, a television, a portable terminal, a cellular telephone, a car navigation, a view finder of a video camera, and the like. Further, the planar light emitting device is of self emitting and thin type, and can be suitably used as a planar light source for back light of a liquid crystal display, or as a planar light source for illumination, and the like. If a flexible substrate is used, it can also be used as a curved light source or display.

### EXAMPLES

Examples will be shown below for illustrating the present invention further in detail, but the present invention is not limited to these examples.

### (Number average molecular weight and weight average molecular weight)

In examples, the polystyrene-equivalent number average molecular weight (Mn) and the polystyrene-equivalent weight average molecular weight (Mw) were measured by GPC (manufactured by Shimadzu Corporation, trade name: LC-10 Avp). A polymer compound to be measured was dissolved in tetrahydrofuran so as to give a concentration of about 0.5 wt%, and 30 µL of the solution was injected into GPC. Tetrahydrofuran was used as the mobile phase of GPC, and allowed to flow at a flow rate of 0.6 mL/min. As the column, two TSKgel Super HM-H (manufactured by Tosoh Corp.) and one TSKgel Super H2000 (manufactured by Tosoh Corp.) were connected serially. A differential refractive index detector (manufactured by Shimadzu Corp., trade name: RID-10A) was used as a detector.

### (High Performance Liquid Chromatogfraphy (HPLC))

In examples, the value of HPLC area percentage as an index of the purity of a compound was measured by high performance liquid chromatography (manufactured by Shimadzu Corp., trade name: LC-20A) at 254 nm, unless otherwise stated. A compound to be measured was dissolved in tetrahydrofuran or chloroform so as to give a concentration of 0.01 to 0.2 wt%, and 1 to 10 µL of the solution was injected into HPLC, depending on the concentration. Acetonitrile and tetrahydrofuran were used as the mobile phase of HPCL and allowed to flow, at a flow rate of 1 mL/min, by gradient analysis of acetonitrile/tetrahydrofuran = 100/0 to 0/100 (volume ratio). Kaseisorb LC ODS 2000 (manufactured by Tokyo Chemical Industry Co., Ltd.) was used as a column. Photodiode Array Detector (manufactured by Shimadzu Corp., trade name: SPD-M20A) was used as a detector.

### (Glass transition temperature)

In examples, the glass transition temperature (Tg) was measured by a differential scanning calorimeter (DSC, manufactured by TA Instruments, trade name: DSC2920). As measurement conditions, a sample was kept at 200°C for 5 minutes, then, quenched down to -50°C and kept for 30 minutes. The temperature was raised up to 30°C, then, the measurement was carried out at a temperature rising rate of 5°C per minute up to 300°C.

### (Evaluation of fluorescent property)

In examples, evaluation of a fluorescent property (fluorescence peak wavelength of a film of a polymer compound) was carried out according to the following method. A polymer compound was dissolved in xylene (manufactured by Kanto Chemical Co., Inc., grade for electronic industry). In this operation, the concentration of solid components was adjusted to 0.8 wt%, and the solution was spin-coated on a quartz plate at a revolution of 1500 rpm to fabricate a film of the polymer compound. This film was excited with a wavelength of 350 nm, and the fluorescent spectrum was measured by using a fluorescence spectrophotometer (manufactured by JOBINYVON-SPEX, trade name: Fluorolog).

### (Measurement of photoluminescence quantum yield (PLQY))

In examples, the photoluminescence quantum yield was measured by using an absolute PL quantum yield measuring apparatus (manufactured by Hamamatsu Photonics K.K., trade name: C9920-02) at an excitation center wavelength of 325 nm, an excitation wavelength range of 315 to 335 nm and a measurement wavelength range of 390 to 800 nm.

### <Example 1> (Synthesis of compound M1)

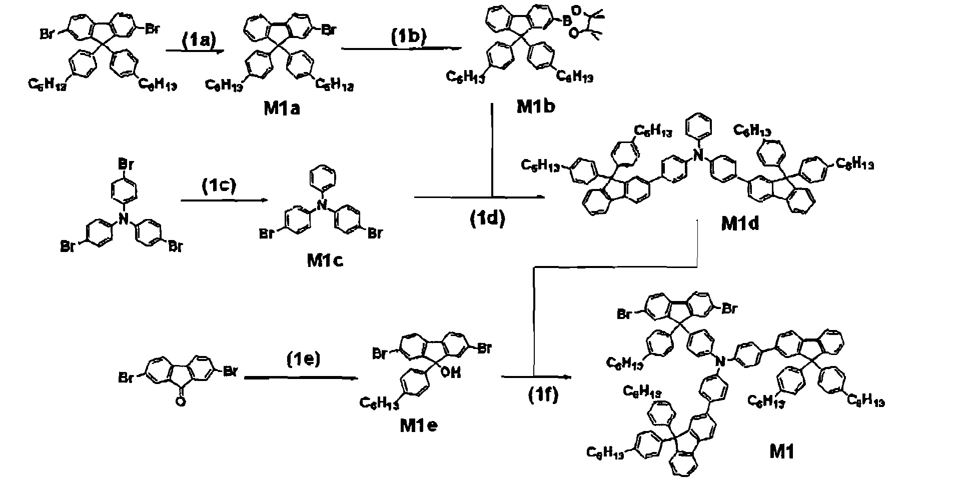

### Step (1a)

Under an argon atmosphere, 2,7-dibromo-9,9-bis(4-hexylphenyl)fluorine (50.27 g, 78 mmol) and THF (500 ml) were mixed in a 300 ml four-necked flask, and the mixture was cooled down to -78°C. Then, a 1.6M n-butyllithium hexane solution (51 ml, 82 mmol) was dropped over a period of 2 hours, and the mixture was further stirred for 2 hours while keeping at -78°C. The reaction solution was quenched by adding 100 ml of water at one time. The reaction solution was heated up to room temperature, then, the organic layer was dried over sodium sulfate, and concentrated under reduced pressure. To the resultant oil was added toluene (500 ml), and the mixture was washed with water (100 ml × 3), then, the organic layer was dried over sodium sulfate, and concentrated under reduced pressure. The resultant oil was purified by a middle pressure preparative column (silica gel, hexane:toluene = 10:1) to obtain a compound M1a (35.1 g, 79%).
¹H-NMR (270 MHz, CDCl₃): δ = 0.87 (t, 6H), 1.25-1.40 (m, 24H), 1.55 (m, 4H), 2.54 (t, 4H), 7.02 (d, 4H), 7.06 (d, 4H), 7.24-7.39 (m, 3H), 7.45 (dd, 1H), 7.52 (s, 1H), 7.59 (d, 1H), 7.69 (d, 1H) ppm.
¹³C-NMR (270 MHz, CDCl₃): δ = 14.4, 22.9, 29.4, 31.6, 32.0, 35.8, 65.3, 120.4, 121.6, 121.7, 126.5, 127.7, 128.2, 128.3, 128.6, 129.7, 130.8, 139.2, 139.4, 141.8, 142.7, 151.7, 154.0 ppm.

### Step (1b)

Under an argon atmosphere, the compound M1a (12.16 g, 22 mmol), pinacolatodiborane (5.35 g, 24 mmol), potassium acetate (6.33 g, 66 mmol), dioxane (92 ml), diphenylphosphinoferrocenepalladium dichloride (0.53g, 0.66mmol) and diphenylphosphinoferrocene (0.36g, 0.66mmol) were mixed in a 300 ml four-necked flask, and heated at 110°C for 15 hours. After completion of the reaction, ion exchange water (100 ml) was added to quench the reaction solution. After removal of the aqueous layer using a separatory funnel, washing with water was performed (100 ml × 3), then, the organic layer was dried over sodium sulfate, and concentrated under reduced pressure. The resultant oil was purified by a middle pressure preparative column (silica gel, hexane:toluene = 1:1) to obtain a compound M1b (10.5 g, 80%).
¹H-NMR (270 MHz, CDCl₃): δ = 0.87 (t, 6H), 1.25-1.40 (m, 24H), 1.56 (m, 4H), 2.53 (t, 4H), 7.00 (d, 4H), 7.10 (d, 4H) 7.22-7.39 (m, 4H), 7.72-7.85 (m, 3H) ppm.
¹³C-NMR (270 MHz, CDCl₃): δ = 14.4, 22.9, 25.2, 29.4, 31.6, 32.0, 35.8, 65.2, 83.9, 119.6, 120.8, 126.6, 127.5, 128.3, 128.4, 132.6, 134.5, 140.1, 141.3, 143.3, 143.4, 151.2, 152.6 ppm.

### Step (1c)

Under an argon atmosphere, tris-(4-bromophenyl)amine (73.75 g, 153 mmol) and dehydrated THF (980ml) were mixed in a 2L four-necked flask, and cooled down to -78°C. Into the reaction solution, 1.6M butyllithium (100 ml) was dropped over a period of 1 hours. After dropping, 100 ml of ion exchange water was added at one time to perform quenching. To the reaction solution was added toluene (400 ml), and the aqueous layer was removed using a separatory funnel, then, the organic layer was concentrated under reduced pressure until 400 ml. Further, the product was washed with ion exchange water (300 ml × 3), dried over sodium sulfate, then, dried under reduced pressure. The resultant oil was purified three times by a middle pressure preparative column (silica gel, hexane:toluene = 1:1) to obtain a compound M1c (34 g, 55%).
¹H-NMR (270 MHz, CDCl₃): δ = 6.93 (d, 4H), 7.05 (m, 3H), 7.25 (m, 2H), 7.33 (d, 4H) ppm.
¹³C-NMR (270 MHz, CDCl₃): δ = 115.7, 124.0, 124.9, 125.9, 129.8, 132.6, 146.8, 147.2 ppm.

### Step (1d)

Under an argon atmosphere, the compound M1b (13.82 g, 23 mmol), the compound M1c (4.43 g, 11 mmol), potassium hydroxide (9.26 g, 170 mmol), tetrabutylammonium bromide (1.77 g, 6 mmol), toluene (150 ml), ion exchange water (70 ml) and tetrakis(triphenylphosphine)palladium (380 mg, 0.33 mmol) were mixed in a 300 ml four-necked flask, and heated at 80°C for 2 hours, After completion of the reaction, the aqueous layer was removed using a separatory funnel, then, washing was performed with ion exchange water (100 ml × 3). The organic layer was dried over sodium sulfate, then, concentrated under reduced pressure. The resultant oil was purified three times by a middle pressure preparative column (silica gel, hexane:toluene = 8:1) to obtain a compound M1d (10.7 g, 80%).
¹H-NMR (270 MHz, CDCl₃): δ = 0.85 (t, 12H), 1.28 (m, 24H), 1.54 (m, 8H), 2.53 (t, 8H), 7.01 (d, 8H), 7.07-7.19 (m, 14H), 7.20-7.50 (m, 13H), 7.51-7.63 (m, 4H), 7.69-7.62 (m, 4H) ppm.
¹³C-NMR (270 MHz, CDCl₃): δ = 14.4, 22.9, 29.5, 31.8, 32.0, 35.9, 65.3, 120.4, 120.5, 123.5, 124.4, 124.7, 124.9, 126.3, 126.6, 127.7, 127.8, 128.2, 126.3, 128.5, 129.6, 135.8, 139.3, 140.1, 140.3, 141.5, 143.5, 147.2, 147.8, 152.2, 152.6 ppm.

### Step (1e)

Under an argon atmosphere, magnesium (2.89 g, 120 mmol) and a small amount of THF were mixed in a 500 ml four-necked flask. 1,2-dibromoethane (0.51 g, 2.8 mmol) was added while heating the mixed liquid with a heat gun, and 4-hexylbromobenzene (25.3 g, 105 mmol) was dropped over a period of 1 hour while maintaining reflux, and the solution was further refluxed for 1 hour to synthesize a Grignard reagent. In another 500 ml four-necked flask purged with argon, 2,7-dibromofluorenone (23.7 g, 70 mmol) and diethyl ether (300ml) were mixed, and the Grignard reagent synthesized previously was dropped over a period of 30 minutes at room temperature. After completion of dropping, the solution was refluxed for 4 hours. After completion of the reaction, 100 ml of water was added to perform quenching, and the solution was washed with water (200 ml × 3) using a separatory funnel. The resultant organic layer was dried over sodium sulfate, then, concentrated under reduced pressure. The resultant oil was purified twice by a middle pressure preparative column (silica gel, chloroform:hexane = 1:5) to obtain a compound M1e (29 g, 83%).
¹H-NMR (270 MHz, CDCl₃) : δ = 0.88 (t, 3H), 1.36 (m, 6H), 1.58 (m, 2H), 2.44 (s, 1H), 2.56 (t, 2H), 7.13 (d, 2H), 7.23 (d, 2H), 7.43 (d, 2H), 7.48 (m, 4H)
¹³C-NMR (270 MHz, CDCl₃) : δ = 14.3, 22.9, 29.4, 31.6, 32.0, 35.9, 83.6, 121.8, 122.8, 125.4, 128.6, 128.8, 132.6, 137.8, 139.0, 142.9, 152.4 ppm.

### Step (If)

Under an argon atmosphere, the compound M1d (9.7 g, 8.0 mmol), the compound M1e (4.8 g, 10 mmol) and dichloromethane (150 ml) were mixed in a 500 ml four-necked flask. Into the mixed solution, a mixed solution of trifluoroborane ether complex (1.2 ml, 10 mmol) and dichloromethane (50 ml) was dropped over a period of 1 hour at room temperature, then, the mixture was stirred for 2 hours. After completion of the reaction, ion exchange water (100 ml) was added, then, washing was performed with ion exchange water (100 ml × 3) using a separatory funnel. The resultant organic layer was dried over sodium sulfate, and concentrated under reduced pressure. The resultant oil was purified three times by a middle pressure preparative column (silica gel, hexane:toluene = 4:1) to obtain a compound M1 (9.11 g, 67%).
MS (APCI-MS: Positive)m/z: 1697.3 ([M+H)⁺)
¹H-NMR (270 MHz, CDCl₃) : δ = 0.86 (t, 15H), 1.12-1.43 (m, 30H), 1.44-1.67 (m, 10H), 2.52 (t, 10H), 6.84-7.20 (m, 30H), 7.22-7.65 (m, 26H), 7.76 (dd, 4H) ppm.
¹³C-NMR (270 MHz, CDCl₃) : δ = 14.4, 22.9, 29.4, 31.6, 32.0, 35.8, 65.3, 120.4, 120.6, 121.8, 122.0, 123.8, 124.7, 126.5, 127.6, 127.8, 128.1, 128.2, 128.4, 128.5, 128.8, 129.1, 129.7, 131.1, 136.1, 138.3, 139.3, 140.1, 140.3, 141.5, 141.8, 142.2, 143.5, 146.9, 152.2, 152.6, 153.7 ppm

### <Example 2> (Synthesis of compound M2)

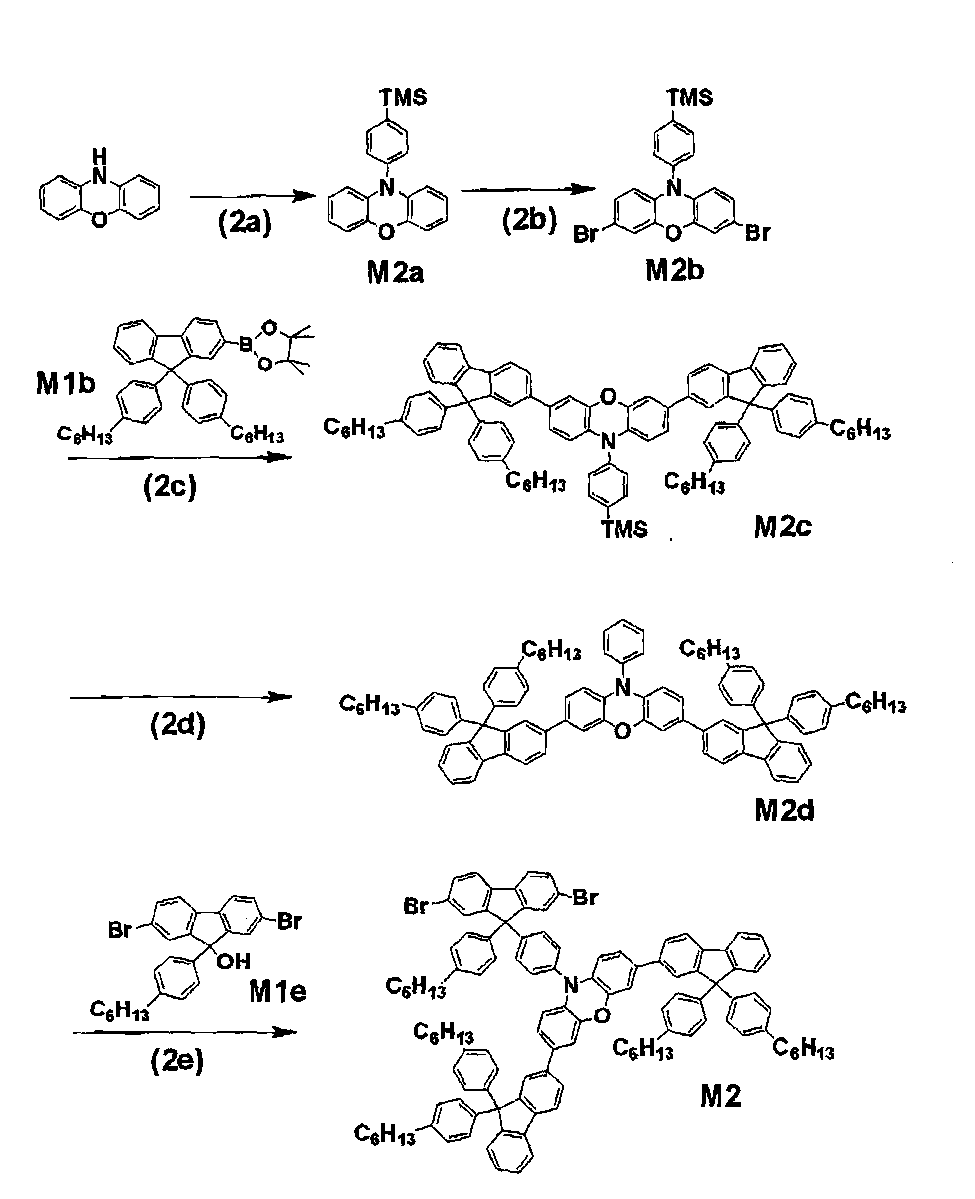

### Step (2a)

Under an argon atmosphere, phenoxazine (19.79 g, 108 mmol), 4-trimethylsilylbromobenzene (24.75 g, 108 mmol), sodium-t-butoxide (15.57 g, 162 mmol), palladium acetate (121 mg, 0.54 mmol), tris(o-methylphenyl)phosphine (329 mg, 1.1 mmol) and toluene (170 ml) were mixed in a 500 ml four-necked flask, and refluxed for 6 hours. After completion of the reaction, the solution was cooled, and passed through celite and alumina. The resultant toluene solution was concentrated to 100 ml, and methanol (200 ml) was added, and the mixture was allowed to stand still to cause re-crystallization. The resultant solid was filtrated and dried to obtain a compound M2a (26.3 g, 73%).
¹H-NMR (270 MHz, THF-d₈) : δ = -0.46 (s, 9H), 6.01 (d, 2H), 6.63-6.77 (m, 6H), 7.46 (d, 2H), 7.72 (d, 2H) ppm.
¹³C-NMR (270 MHz, THF-d₈) : δ = -1.2, 114.0, 115.9, 121.9, 123.8, 130.6, 135.2, 136.7, 140.5, 141.7, 144.8 ppm.

### Step (2b)

Under an argon atmosphere, the compound M2a (23.2 g, 70 mmol) and chloroform (300 ml) were mixed in a 500 ml four-necked flask, and cooled down to 0°C. Into the reaction solution, a mixed solution of N-bromosuccinimide (NBS, 24.9 g, 140 mmol) and N,N-dimethylformamide (DMF, 100 ml) was dropped over a period of 1 hour. After completion of dropping, the mixture was heated up to room temperature. Further, NBS was added several times (1 g for each time) until complete progress of the reaction. After completion of the reaction, the reaction solution was poured into methanol (1.5 L). The resultant solid was filtrated, and dried. To the resultant solid was added toluene (500 ml) and the mixture was refluxed, and hot-filtrated. Here, the resultant solid (solid A) was recoved, and separately, the resultant toluene solution was concentrated, and re-crystallized from toluene-isopropanol, and the solid obtained by re-crystallization (solid B) was filtrated. These solids A and B were mixed, and re-crystallized from toluene-isopropanol three times, to obtain a target material M2b (25.1 g, 64%).
¹H-NMR (270 MHz, THF-d₈) : δ = -0.50 (s, 9H), 5.96 (d, 2H), 6.89 (dd, 2H), 7.02 (s, 2H), 7.49 (d, 2H), 7.99 (d, 2H) ppm.

### Step (2c)

Under an argon atmosphere, the compound M1b (12.1 g, 20 mmol) synthesized as described above, the compound M2b (4.6 g, 9.4 mmol), Aliquat336 (1.2 g, 3 mmol) and toluene (150 ml) were mixed in a 500 ml four-necked flask, and argon was bubbled through the mixture for 1 hour. This reaction solution was mixed with palladium acetate (21 mg, 0.1 mmol) and tris(o-methoxyphenyl)phosphine (33 mg, 0.1 mmol), and the mixture was heated at 105°C. Into this reaction solution, a 2M sodium carbonate aqueous solution (15 ml) was dropped over a period of 1 hour, and the mixture was reacted for 3 hours. After completion of the reaction, the liquid was separated, and the organic layer was washed with ion exchange water (100 ml × 3), and dried over sodium sulfate. Further, the solution was passed through alumina, and concentrated and dried to obtain a compound M2c (11.9 g, 99%). The crude product was used in the subsequent reaction without purification.

### Step (2d)

Under an argon atmosphere, the compound M2c (11.9 g, 9 mmol), trifluoroacetic acid (22 g, 180 mmol) and toluene (100 ml) were mixed in a 300 ml four-necked flask, and heated at 80°C for 3 hours. After completion of the reaction, the liquid was separated, and washed with ion exchange water (100 ml × 3) and a sodium hydrogen carbonate saturated aqueous solution (100 ml × 4) and dried over sodium sulfate. The solution was passed through alumina, and the toluene solution was concentrated to dryness. The resultant solid was purified by silica gel column chromatography (toluene/hexane = 1:1), and the resultant solution was concentrated, then, re-crystallized from toluene-hexane to obtain a compound M2d (9.41 g, 83%). MS(APCI-MS:Positive) m/z: 1228.6 ([M+H]*).
¹H-NMR (270 MHz, THF-d₈): δ = 0.99 (t, 12H), 1.32-1.56 (m, 24H), 1.63-1.73 (m, 8H), 2.65 (t, 8H), 6.06 (d, 2H), 6.94 (dd, 2H), 7.09 (d, 2H), 7.13 (d, 8H), 7.23 (d, 8H), 7.33 (dd, 2H), 7.43 (dd, 2H), 7.49-7.52 (m, 4H), 7.60-7.67 (m, 3H), 7.68 (s, 2H), 7.76 (dd, 2H), 7.89-7.95 (m, 4H) ppm.

### Step (2e)

Under an argon atmosphere, the compound M2d (8.6 g, 7.0 mmol), the compound Mle (3.6 g, 7.1 mmol) synthesized as described above and dichloromethane (130 ml) were mixed in a 500 ml four-necked flask. Into the mixed solution, a mixed solution of a trifluoroborane ether complex (1 ml, 8 mmol) and dichloromethane (10 ml) was dropped over a period of 1 hour at room temperature. Thereafter, the reaction solution was stirred at 30°C for 100 hours. After completion of the reaction, ion exchange water (100 ml) was added, then, the mixture was washed with ion exchange water (100 ml × 3) using a separatory funnel. The resultant organic layer was dried over sodium sulfate, and concentrated under reduced pressure. The resultant oil was purified by a middle pressure preparative column (silica gel, hexane:toluene = 4:1) to obtain a compound M2 (2.2 g, 18%).
MS (APCI-MS: Positive) m/z: 1711.6 ([M+H]⁺)

### <Comparative Example 1> (Synthesis of compound CM1)

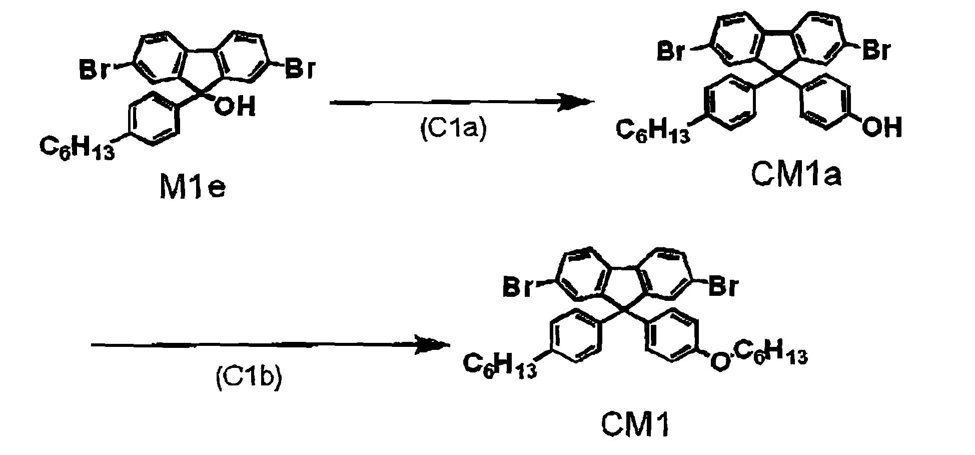

### Step (C1a)

Under an argon gas atmosphere, the compound Mle (10.0 g, 20.0 mmol) and phenol (2.82 g, 30.0 mmol) were dissolved in dehydrated dichloromethane (300 mL) and the solution was stirred at room temperature under shading, and into the solution, a solution of a boron trifluoride diethyl ether complex (3.0 mL, 24 mmol) diluted in dehydrated dichloromethane (100 mL) was dropped over a period of 1 hour, and further, the mixture was stirred at room temperature for 2 hours. Ethanol (200 mL) and water (200 mL) were added to the reaction mixture, and the mixture was stirred for 1 hour. The aqueous layer was removed by liquid separation, then, the organic layer was washed sequentially with a 5 wt% sodium hydrogen carbonate aqueous solution (twice), water and 15 wt% saline (twice), and dried over anhydrous magnesium sulfate, and concentrated under reduced pressure to obtain a compound CM1a (11.0 g, yield: 96%, HPLC area percentage: 97%) as a red oil. ¹H-NMR (300 MHz, THF-d8) δ 8.25 (s, 1H), 7.74 (d, 2H), 7.54 (s, 1H), 7.51 (s, 2H), 7.08 (s, 4H), 6.96 (d, 2H), 6.63 (d, 2H), 2.57 (t,2H), 1.60 (m,2H), 1.33 (s, 6H), 0.90 (t, 3H) ¹³C-NMR (75 MHz, THF-d8) δ = 159.0, 156.2, 144.2, 143.5, 140.2, 136.9, 132.6, 131.2, 131.0, 130.9, 130.3, 129.8, 123.8, 123.5, 117.0, 37.4, 33.8, 33.6, 31.2, 24.6, 15.5

### Step (Clb)

Under an argon gas atmosphere, the compound CM1a (10.9 g, 18.9 mmol), 1-bromohexane (6.24 g, 37.8 mmol), potassium carbonate (7.84 g, 56.7 mmol) and ethanol (47 ml) were mixed at room temperature under shading, and the mixture was stirred for 4 hours under reflux with heating. Water (100 ml) was added and the mixture was stirred and allowed to stand still, then, the supernatant was removed by decantation; this operation was repeated twice, then, ethanol (38 ml) was added, and the mixture was refluxed with heating for 30 minutes and cooled, then, the supernatant was removed by decantation. An oil fixed to the bottom of the reaction vessel was dissolved in toluene, and the solution was concentrated under reduced pressure to attain dehydration, then, the product was purified by middle pressure preparative silica gel column chromatography (silica gel, hexane:chloroform = 100:0 to 70:30) to obtain a compound CM1 as a yellow oil (10.49 g, yield: 55%, HPLC area percentage value: 99%).
¹H-NMR (300 MHz, THF-d8) δ 7.75 (d, 2H), 7.55 (s, 2H), 7.52 (s, 2H), 7.06 (m, 6H), 6.78 (d, 2H), 3.91 (t, 2H), 2.57 (t, 2H), 1.75 (m, 2H), 1.60 (m, 2H), 1.37 (m, 12H), 0.91 (t, 6H)
¹³C-NMR (75 MHz, THF-d8) δ = 159.0, 156.2, 144.2, 143.5, 140.2, 136.9, 132.6, 131.2, 131.0, 130.9, 130.3, 129.8, 123.8, 123.5, 117.0, 37.4, 33.8, 33.6, 31.2, 24.6, 15.5

### <Comparative Example 2> (Synthesis of compound CM2)

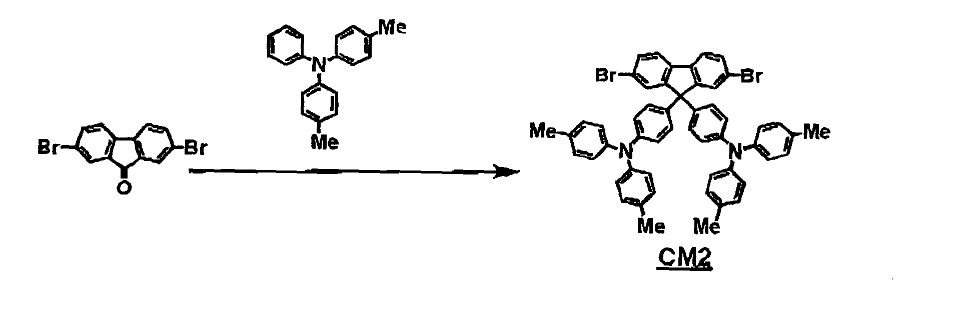

Under a nitrogen gas atmosphere, 2,7-dibromofluorenone (4.97 g, 14.7 mmol), 4,4'-dimethyltriphenylamine (10.5 g, 36.8 mmol) and methanesulfonic acid (1.41g, 14.7mmol) were stirred at 140°C for 5 hours under shading. The mixture cooled down to 50°C, then, chloroform (50 ml) was added, and the mixture was washed with a 10 wt% sodium carbonate aqueous solution (50 ml) twice, dried over anhydrous magnesium sulfate, concentrated under reduced pressure, then, re-crystallized (chloroform-acetone). The resultant solid was dissolved in methylene chloride (330 g) with heating to obtain a solution, and activated carbon (3 g) was added to the solution, and the mixture was stirred at room temperature for 1 hour. Activated carbon was removed by a filtration device pre-coated with silica gel, and to the resultant solution was added acetone slowly to cause crystallization, and the crystal was dried under reduced pressure to obtain a compound CM2 (9.8 g, yield: 77%, HPLC area percentage: 99% or more) as a white solid.
¹H-NMR (300 MHz, THF-d8) δ 2.26 (s, 12H), 6.80-7.20 (m, 24H), 7.5-7.8 (m, 6H)
LC-MS M = 864

### <Comparative Example 3> (Synthesis of compound CM3)

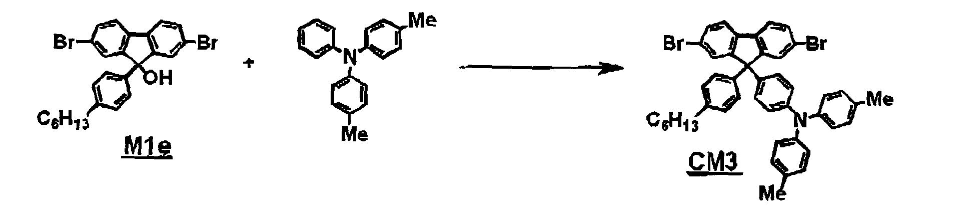

Under an argon gas atmosphere, the compound Mle (5.00 g, 10.0 mmol) synthesized as described above and 4,4'-dimethyltriphenylamine (2.73 g, 10.0 mmol) were dissolved in dehydrated dichloromethane (340 mL) and the solution was stirred at room temperature under shading, and into this solution, a solution of a boron trifluoride diethyl ether complex (1.44 mL, 11.7 mmol) diluted in dehydrated dichloromethane (68 mL) was dropped over a period of 30 minutes, and further, the mixture was stirred at room temperature for 30 minutes. Ethanol (100 mL) and water (100 mL) were added to the reaction mixture, and the mixture was stirred for 1 hour. The aqueous layer was removed by liquid separation, then, the organic layer was washed sequentially with a 5 wt% sodium hydrogen carbonate aqueous solution (twice) and 15% saline (twice), dried over anhydrous magnesium sulfate, concentrated under reduced pressure, then, passed through a silica gel short column (hexane/toluene = 1/1), concentrated under reduced pressure, re-crystallized (acetone-methanol) twice, and dried under reduced pressure to obtain a compound CM3 (5.84 g, yield: 77%, HPLC area percentage: 99% or more) as a white solid.
¹H-NMR (300 MHz, THF-d8) δ 0.90 (t, 3H), 1.28-1.41 (m, 6H), 1.56-1.62 (m, 2H), 2.27 (s, 6H), 2.56 (t, 2H), 6.84 (d, 2H), 6.92-7.11 (m, 14H), 7.51 (dd, 2H), 7.59 (d, 2H), 7.74 (d, 2H)
LC-MS M = 753

### <Example 3> (Synthesis of polymer compound P1)

2,7-bis(1,3,2-dioxaborolan-2-yl)-9,9-dioctylfluorene (0.7942 g, 1.497 mmol), 2,7-dibromo-9,9-dioctylfluorene (0.6581 g, 1.2 mmol), the compound M1 (0.5091 g, 0.300 mmol) and trioctylmethylammonium chloride (manufactured by Aldrich, trade name: Aliquat336) (0.19 g, 0.48 mmol) were dissolved in toluene (48 ml) under an argon gas atmosphere. An argon gas was bubbled through the solution, then, the solution was heated up to 80°C, and a suspension (5 ml) of dichlorobistriphenylphosphinepalladium (3.2 mg, 4.5 µmol) in toluene was charged, further, a 17.5 wt% sodium carbonate aqueous solution (8.2 ml, 6.8 mmol) was added, and the mixture was reacted for 20 hours under reflux. The reaction mixture was once cooled, then, a solution prepared by suspending phenylboric acid (0.02 g, 0.15 mmol) in 1 ml of toluene was added, and further, the mixture was reacted for 2 hours under reflux. Toluene (20 ml) was added for dilution, then, the aqueous layer was removed, and a 9 wt% sodium N,N-diethyldithiocarbamate aqueous solution (9 ml) was added, the mixture was stirred at 90°C for 2 hours, then, the organic layer was washed sequentially with ion exchange water (20 ml) twice, a 3 wt% acetic acid aqueous solution (20 ml) twice and ion exchange water (20 ml) twice, then, dropped into methanol (250 ml), and the mixture was stirred for 30 minutes to cause deposition of a polymer. The polymer was filtrated by suction filtration, washed with methanol (50 ml) and dried under reduced pressure to obtain a crude polymer.

This crude polymer was dissolved in toluene (70 ml), the solution was passed through alumina (5 g) and silica gel (15 g) filled in a column, further, passed through toluene (70 ml). The resultant solution was added slowly into methanol (250 ml) under stirring, and the mixture was further stirred for 30 minutes to cause deposition of a polymer. The polymer was filtrated by suction filtration, washed with methanol (50 ml), and dried under reduced pressure to obtain a polymer compound P1 (1.20 g, yield: 80%) as a polymer. The polymer compound P1 had a polystyrene-equivalent number average molecular weight Mn of 1.2×10⁵, a polystyrene-equivalent weight average molecular weight Mw of 3.8×10⁵ and a glass transition temperature of 108°C, and the fluorescence peak wavelength of a film was found at 422 nm and 446 nm.

The polymer compound P1 is guessed to contain the following repeating units at the following ratio (molar ratio) on the basis of the charged raw materials.

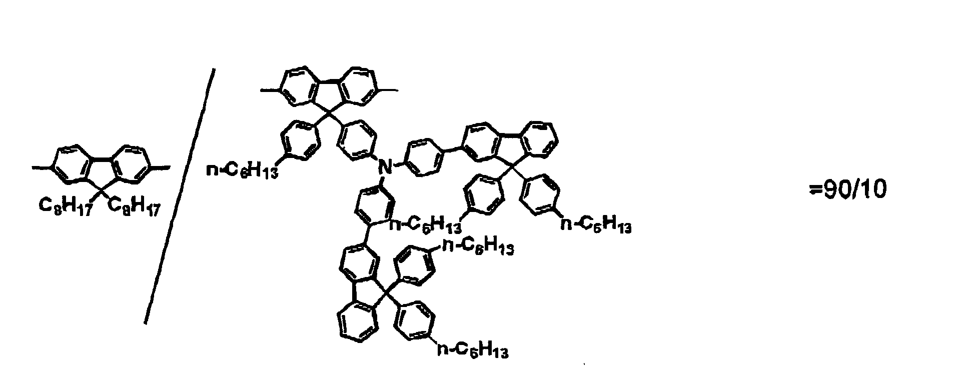

### <Example 4> (Synthesis of polymer compound P2)

2,7-bis(1,3,2-dioxaborolan-2-yl)-9,9-dioctylfluorene (0.4223 g, 0.796 mmol), 2,7-dibromo-9,9-dioctylfluorene (0.3861 g, 0.704 mmol), the compound M1 (0.1358 g, 0.080 mmol), the compound M2 (0.0274 g, 0.016 mmol) and trioctylmethylammonium chloride (manufactured by Aldrich, trade name: Aliquat336) (0.10 g, 0.26 mmol) were dissolved in toluene (16 ml) under an argon gas atmosphere. An argon gas was bubbled through the solution, then, the solution was heated up to 80°C, and a suspension (1 ml) of dichlorobistriphenylphosphinepalladium (0.6 mg, 0.8 µmol) in toluene was charged, further, a 17.5 wt% sodium carbonate aqueous solution (2.2 ml, 3.6 mmol) was added, and the mixture was reacted for 20 hours under reflux. The reaction mixture was once cooled, then, a solution prepared by suspending phenylboric acid (0.10 g, 0.8 mmol) in 3 ml of toluene was added, and further, the mixture was reacted for 2 hours under reflux. Toluene (20 ml) was added for dilution, then, the aqueous layer was removed, and a 9 wt% sodium N,N-diethyldithiocarbamate aqueous solution (5 ml) was added, the mixture was stirred at 90°C for 2 hours, then, the organic layer was washed sequentially with ion exchange water (10 ml) twice, a 3 wt% acetic acid aqueous solution (10 ml) twice and ion exchange water (10 ml) twice, then, dropped into methanol (125 ml), and the mixture was stirred for 30 minutes to cause deposition of a polymer. The polymer was filtrated by suction filtration, washed with methanol (25 ml) and dried under reduced pressure to obtain a crude polymer.

This crude polymer was dissolved in toluene (25 ml), the solution was passed through alumina (5 g) and silica gel (12 g) filled in a column, further, passed through toluene (20 ml). The resultant solution was added slowly into methanol (125 ml) under stirring, and the mixture was further stirred for 30 minutes to cause deposition of a polymer. The polymer was filtrated by suction filtration, washed with methanol (25 ml), and dried under reduced pressure to obtain a polymer compound P2 (0.50 g, yield: 78%) as a polymer. The polymer compound P2 had a polystyrene-equivalent number average molecular weight Mn of 1.1×10⁵, a polystyrene-equivalent weight average molecular weight Mw of 2.4×10⁵ and a glass transition temperature of 86°C, and the fluorescence peak wavelength of a film was found at 422 nm and 440 nm.

The polymer compound P2 is guessed to contain the following repeating units at the following ratio (molar ratio) on the basis of the charged raw materials.

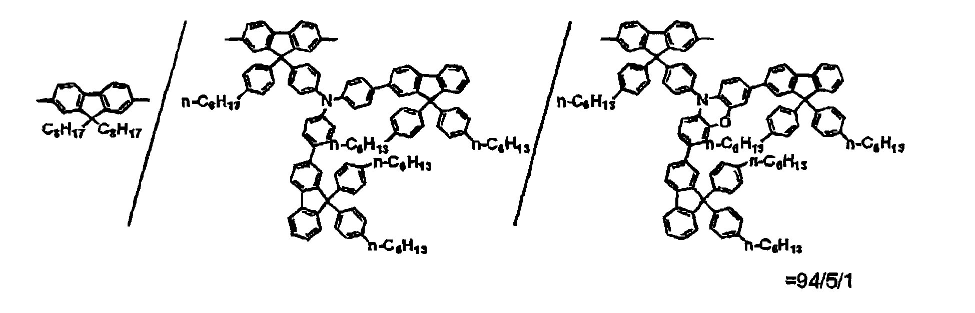

### <Example 5> (Synthesis of polymer compound P3)

2,7-bis(4,4,5,5-tetramethyl-1,3,2-dioxaborolan-2-yl)-9,9-bis(4'-hexylphenyl) fluorine (0.5909 g, 0.800 mmol), 2,7-dibromo-9,9-bis(4'-hexylphenyl) fluorine (0.4125 g, 0.640 mmol), the compound M1 (0.2308 g, 0.136 mmol) and the compound M2 (0.0411 g, 0.024 mmol) were dissolved in toluene (18 ml) under an argon gas atmosphere. An argon gas was bubbled through the solution, then, the solution was heated up to 80°C, and a suspension (3 ml) of dichlorobistriphenylphosphinepalladium (1.1 mg, 1.6 µmol) in toluene was charged, further, a 20 wt% tetraethylammonium hydroxide aqueous solution (2.7 ml, 3.6 mmol) was added, and the mixture was reacted for 20 hours under reflux. The reaction mixture was once cooled, then, a solution prepared by suspending phenylboric acid (0.13 g, 0.85 mmol) in 3 ml of toluene was added, and further, the mixture was reacted for 2 hours under reflux. Toluene (20 ml) was added for dilution, then, the aqueous layer was removed, and a 9 wt% sodium N,N-diethyldithiocarbamate aqueous solution (5 ml) was added, the mixture was stirred at 90°C for 2 hours, then, the organic layer was washed sequentially with ion exchange water (10 ml) twice, a 3 wt% acetic acid aqueous solution (10 ml) twice and ion exchange water (10 ml) twice, then, dropped into methanol (125 ml), and the mixture was stirred for 30 minutes to cause deposition of a polymer. The polymer was filtrated by suction filtration, washed with methanol (25 ml) and dried under reduced pressure to obtain a crude polymer.

This crude polymer was dissolved in toluene (25 ml), the solution was passed through alumina (5 g) and silica gel (12 g) filled in a column, further, passed through toluene (20 ml). The resultant solution was added slowly into methanol (125 ml) under stirring, and the mixture was further stirred for 30 minutes to cause deposition of a polymer. The polymer was filtrated by suction filtration, washed with methanol (25 ml), and dried under reduced pressure to obtain a polymer compound P3 (0.72 g, yield: 76%) as a polymer. The polymer compound P3 had a polystyrene-equivalent number average molecular weight Mn of 1.4×10⁵, a polystyrene-equivalent weight average molecular weight Mw of 3.9×10⁵ and a glass transition temperature of 179°C, and the fluorescence peak wavelength of a film was found at 448 nm.

The polymer compound P3 is guessed to contain the following repeating units at the following ratio (molar ratio) on the basis of the charged raw materials.

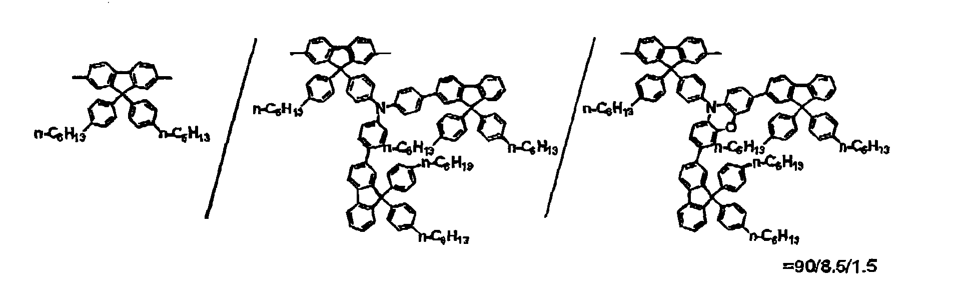

### <Comparative Example 4> (Synthesis of polymer compound CP1)

2,7-bis (1,3,2-dioxaborolan-2-yl)-9,9-dioctylfluorene (1.0675 g, 2.012 mmol), 2,7-dibromo-9,9-dioctylfluorene (0.8873 g, 1.618 mmol), the compound CM1 (0.2672 g, 0.404 mmol) and trioctylmethylammonium chloride (manufactured by Aldrich, trade name:Aliquat336) (0.26 g, 0.65 mmol) were dissolved in toluene ( 20ml) under an argon gas atmosphere. An argon gas was bubbled through the solution, then, the solution was heated up to 80°C, and a suspension (5 ml) of dichlorobistriphenylphosphinepalladium (2.8 mg, 4.0 µmol) in toluene was charged, further, a 17.5 wt% sodium carbonate aqueous solution (5.5 ml, 9.1 mmol) was added, and the mixture was reacted for 7 hours under reflux. The reaction mixture was once cooled, then, a solution prepared by suspending phenylboric acid (0.25 g, 2.02 mmol) in 3 ml of toluene was added, and further, the mixture was reacted for 2 hours under reflux. Toluene (20 ml) was added for dilution, then, the aqueous layer was removed, and a 9 wt% sodium N,N-diethyldithiocarbamate aqueous solution (12 ml) was added, the mixture was stirred at 90°C for 2 hours, then, the organic layer was washed sequentially with ion exchange water (26 ml) twice, a 3 wt% acetic acid aqueous solution (26 ml) twice and ion exchange water (26 ml) twice, then, dropped into methanol (320 ml), and the mixture was stirred for 30 minutes to cause deposition of a polymer. The polymer was filtrated by suction filtration, washed with methanol (60 ml) and dried under reduced pressure to obtain a crude polymer (1.54 g).

This crude polymer was dissolved in toluene (70 ml), the solution was passed through alumina (15 g) and silica gel (30 g) filled in a column, further, passed through toluene (50 ml). The resultant solution was added slowly into methanol (320 ml) under stirring, and the mixture was further stirred for 30 minutes to cause deposition of a polymer. The polymer was filtrated by suction filtration, washed with methanol (60 ml), and dried under reduced pressure to obtain a polymer compound CP1 (1.22 g, yield: 76%) as a polymer. The polymer compound CP1 had a polystyrene-equivalent number average molecular weight Mn of 1.7×10⁵, a polystyrene-equivalent weight average molecular weight Mw of 5.8×10⁵ and a glass transition temperature of 83°C, and the fluorescence peak wavelength of a film was found at 422 nm and 438 nm.

The polymer compound CP1 is guessed to contain the following repeating units at the following ratio (molar ratio) on the basis of the charged raw materials.

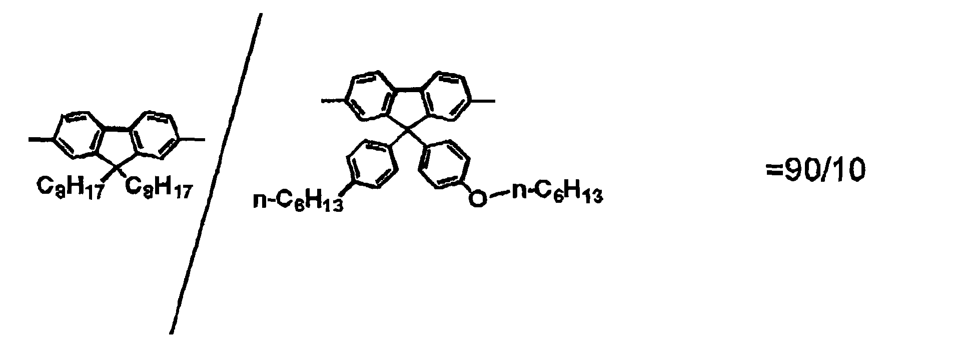

### <Comparative Example 5> (Synthesis of polymer compound CP2)

2,7-bis(1,3,2-dioxaborolan-2-yl)-9,9-dioctylfluorene (1.1814 g, 2.228 mmol), 2,7-dibromo-9,9-dioctylfluorene (0.9872 g, 1.800 mmol), the compound CM2 (0.3900 g, 0.450 mmol) and trioctylmethylammonium chloride (manufactured by Aldrich, trade name: Aliquat336) (0.29 g, 0.72 mmol) were dissolved in toluene (17.5 ml) under an argon gas atmosphere. An argon gas was bubbled through the solution, then, the solution was heated up to 80°C, and a suspension (5 ml) of dichlorobistriphenylphosphinepalladium (1.6 mg, 2.3 µmol) in toluene was charged, further, a 20 wt% tetraethylammonium hydroxide aqueous solution (7.3 ml, 10.4 mmol) was added, and the mixture was reacted for 7 hours under reflux. The reaction mixture was once cooled, then, a solution prepared by suspending phenylboric acid (0.27 g, 2.25 mmol) in 3 ml of toluene was added, and further, the mixture was reacted for 2 hours under reflux. Toluene (22 ml) was added for dilution, then, the aqueous layer was removed, and a 9 wt% sodium N,N-diethyldithiocarbamate aqueous solution (14 ml) was added, the mixture was stirred at 90°C for 2 hours, then, the organic layer was washed sequentially with ion exchange water (30 ml) twice, a 3 wt% acetic acid aqueous solution (30 ml) twice and ion exchange water (30 ml) twice, then, dropped into methanol (350 ml), and the mixture was stirred for 30 minutes to cause deposition of a polymer. The polymer was filtrated by suction filtration, washed with methanol (70 ml) and dried under reduced pressure to obtain a crude polymer (1.89 g).

This crude polymer was dissolved in toluene (70 ml), the solution was passed through alumina (15 g) and silica gel (35 g) filled in a column, further, passed through toluene (110 ml). The resultant solution was added slowly into methanol (350 ml) under stirring, and the mixture was further stirred for 30 minutes to cause deposition of a polymer. The polymer was filtrated by suction filtration, washed with methanol (70 ml), and dried under reduced pressure to obtain a polymer compound CP2 (1.65 g, yield: 88%) as a polymer. The polymer compound CP2 had a polystyrene-equivalent number average molecular weight Mn of 2.8×10⁴, a polystyrene-equivalent weight average molecular weight Mw of 6.1×10⁴ and a glass transition temperature of 89°C, and the fluorescence peak wavelength of a film was found at 423 nm and 438 nm.

The polymer compound CP2 is guessed to contain the following repeating units at the following ratio (molar ratio) on the basis of the charged raw materials.

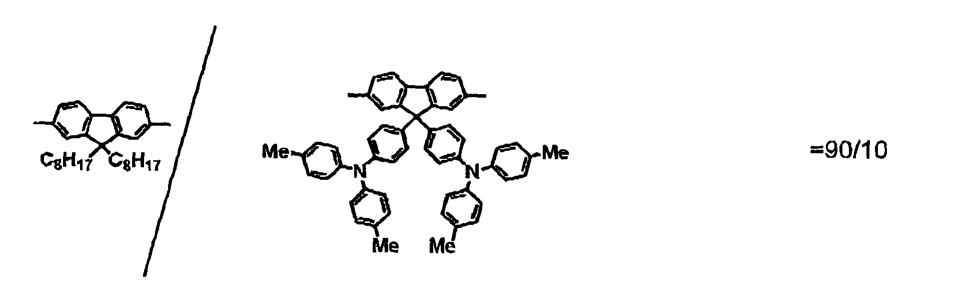

### <Comparative Example 6> (Synthesis of polymer compound CP3)

2,7-bis(1,3,2-dioxaborolan-2-yl)-9,9-dioctylfluorene (0.7838 g, 1.478 mmol), 2,7-dibromo-9,9-dioctylfluorene (0.6581 g, 1.200 mmol) and the compound CM3 (0.2267 g, 0.300 mmol) were dissolved in toluene (17ml) under an argon gas atmosphere. An argon gas was bubbled through the solution, then, the solution was heated up to 80°C, and a suspension (5 ml) of dichlorobistriphenylphosphinepalladium (1.1 mg, 1.5 µmol) in toluene was charged, further, a 20 wt% tetraethylammonium hydroxide aqueous solution (4.9 ml, 6.9 mmol) was added, and the mixture was reacted for 7 hours under reflux. The reaction mixture was once cooled, then, a solution prepared by suspending phenylboric acid (0.18 g, 1.5 mmol) in 17 ml of toluene was added, and further, the mixture was reacted for 2 hours under reflux. The aqueous layer was removed, and a 9 wt% sodium N,N-diethyldithiocarbamate aqueous solution (10 ml) was added, the mixture was stirred at 90°C for 2 hours, then, the organic layer was washed sequentially with ion exchange water (20 ml) twice, a 3 wt% acetic acid aqueous solution (20 ml) twice and ion exchange water (20 ml) twice, then, dropped into methanol (250 ml), and the mixture was stirred for 30 minutes to cause deposition of a polymer. The polymer was filtrated by suction filtration, washed with methanol (50 ml) and dried under reduced pressure to obtain a crude polymer (0.94 g).

This crude polymer was dissolved in toluene (50 ml), the solution was passed through alumina (5.5 g) and silica gel (16.5 g) filled in a column, further, passed through toluene (72 ml). The resultant solution was added slowly into methanol (250 ml) under stirring, and the mixture was further stirred for 30 minutes to cause deposition of a polymer. The polymer was filtrated by suction filtration, washed with methanol (50 ml), and dried under reduced pressure to obtain a polymer compound CP3 (0.83 g, yield: 69%) as a polymer. The polymer compound CP3 had a polystyrene-equivalent number average molecular weight Mn of 1.7×10⁴, a polystyrene-equivalent weight average molecular weight Mw of 3.2×10⁴ and a glass transition temperature of 73°C, and the fluorescence peak wavelength of a film was found at 423 nm and 446 nm.

The polymer compound CP3 is guessed to contain the following repeating units at the following ratio (molar ratio) on the basis of the charged raw materials.

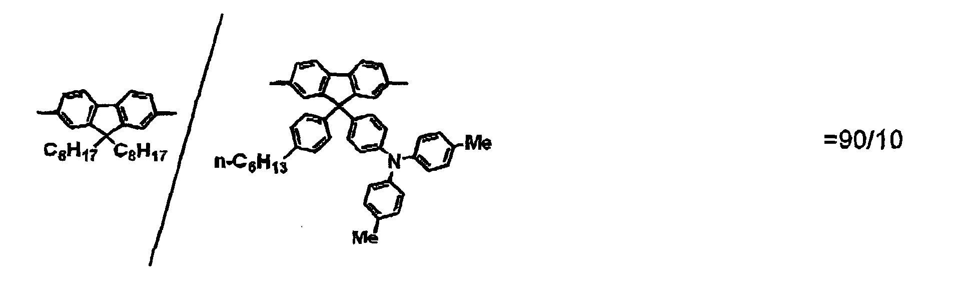

### <Example 6> (Fabrication of light emitting device P1)

The polymer compound P1 was dissolved in xylene (manufactured by Kanto Chemical Co., Inc., grade for electronic industry). The concentration of solid components was adjusted to 1.2 wt%. A solution of poly(3,4-ethylenedioxythiophene)/polystyrenesulfonic acid (manufactured by Bayer, trade name: BaytronP CH8000) was spin-coated to form a film with a thickness of 65 nm on a glass substrate carrying an ITO film having a thickness of 150 nm formed thereon by a sputtering method, and the film was dried on a hot plate at 200°C for 10 minutes. Next, the xylene solution prepared above was spin-coated at a revolution of 850 rpm to form a film. The film thickness was about 100 nm. This was dried at 130°C for 20 minutes under a nitrogen gas atmosphere, then, as a cathode, lithium fluoride was vapor-deposited with a thickness of about 4 nm, then, calcium was vapor-deposited with a thickness of about 5 nm, finally, aluminum was vapor-deposited with a thickness of about 100 nm, fabricating a light emitting device P1. The device constitution is ITO/BaytronP (65 nm)/polymer compound Pl/LiF/Ca/Al. After the degree of vacuum reached 1×10⁻⁴ Pa or less, vapor-deposition of a metal was initiated.

When voltage was applied on the light emitting device P1, deep blue light emission with a peak wavelength (EL) of 450 nm ascribable to the polymer compound P1 was shown. The maximum light emission efficiency was 1.9 cd/A, and under this condition, the voltage was 3.6 V and the external quantum yield was 1.5%. When the luminance was 1000 cd/m², the voltage was 7.4 V, the chromaticity coordinate C.I.E.1931 was (x, y) = (0.18, 0.13), the light emission efficiency was 1.2 cd/A and the external quantum yield was 1.2%. These results are shown in Table 1.

### <Example 7> (Fabrication of light emitting device P2)

A light emitting device P2 was fabricated in the same manner as in Example 6 excepting that a 1.3 wt% xylene solution of the polymer compound P2 was used instead of the 1.2 wt% xylene xolution of the polymer compound P1 and the revolution of spin coat was changed to 1000 rpm, in Example 6. The film thickness was about 100 nm.

When voltage was applied on the light emitting device P2, deep blue light emission with a peak wavelength (EL) of 450 nm ascribable to the polymer compound P2 was shown. The maximum light emission efficiency was 0.82 cd/A, and under this condition, the voltage was 6.4 V and the external quantum yield was 0.92%. When the luminance was 1000 cd/m², the voltage was 12.0 V, the chromaticity coordinate C.I.E.1931 was (x, y)=(0.16, 0.10), the light emission efficiency was 0.77 cd/A and the external quantum yield was 0.90%. These results are shown in Table 1.

### <Example 8> (Fabrication of light emitting device P3)

A light emitting device P3 was fabricated in the same manner as in Example 6 excepting that a 1.2 wt% xylene solution of the polymer compound P3 was used instead of the 1.2 wt% xylene xolution of the polymer compound P1 and the revolution of spin coat was changed to 1000 rpm, in Example 6. The film thickness was about 100 nm.

When voltage was applied on the light emitting device P3, blue light emission with a peak wavelength (EL) of 455 nm ascribable to the polymer compound P3 was shown. The maximum light emission efficiency was 2.8 cd/A, and under this condition, the voltage was 4.6 V and the external quantum yield was 2.0%. When the luminance was 1000 cd/m², the voltage was 9.2 V, the chromaticity coordinate C.I.E.1931 was (x, y) = (0.15, 0.17), the light emission efficiency was 2.1 cd/A and the external quantum yield was 1.6%. These results are shown in Table 1.

### <Comparative Example 7> (Fabrication of light emitting device CP1)

A light emitting device CP1 was fabricated in the same manner as in Example 6 excepting that a 1.2 wt% xylene solution of the polymer compound CP1 was used instead of the 1.2 wt% xylene xolution of the polymer compound P1 and the revolution of spin coat was changed to 2000 rpm, in Example 6. The film thickness was about 100 nm.

When voltage was applied on the light emitting device CP1, deep blue light emission with a peak wavelength (EL) of 425 nm ascribable to the polymer compound CP1 was shown. The maximum light emission efficiency was 1.5 cd/A, and under this condition, the voltage was 3.2 V and the external quantum yield was 1.2%. When the luminance was 1000 cd/m², the voltage was 5.6 V, the chromaticity coordinate C.I.E. 1931 was (x, y)=(0.15, 0.17), the light emission efficiency was 0.54 cd/A and the external quantum yield was 0.59%. These results are shown in Table 1.

### <Comparative Example 8> (Fabrication of light emitting device CP2)

A light emitting device CP2 was fabricated in the same manner as in Example 6 excepting that a 1.7 wt% xylene solution of the polymer compound CP2 was used instead of the 1.2 wt% xylene xolution of the polymer compound P1 and the revolution of spin coat was changed to 2200 rpm, in Example 6. The film thickness was about 100 nm.

When voltage was applied on the light emitting device CP2, deep blue light emission with a peak wavelength (EL) of 450 nm ascribable to the polymer compound CP2 was shown. The maximum light emission efficiency was 0.18 cd/A, and under this condition, the voltage was 5.6 V and the external quantum yield was 0.29%. When the luminance was 1000 cd/m², the voltage was 7.8 V, the chromaticity coordinate C.I.E.1931 was (x, y)=(0.19, 0.11), the light emission efficiency was 0.34 cd/A and the external quantum yield was 0.37%. These results are shown in Table 1.

### <Comparative Example 9> (Fabrication of light emitting device CP3)

A light emitting device CP3 was fabricated in the same manner as in Example 6 excepting that a 1,8 wt% xylene solution of the polymer compound CP2 was used instead of the 1.2 wt% xylene xolution of the polymer compound P1 and the revolution of spin coat was changed to 2200 rpm, in Example 6. The film thickness was about 100 nm.

When voltage was applied on the light emitting device CP3, blue light emission with a peak wavelength (EL) of 450 nm ascribable to the polymer compound CP1 was shown. The maximum light emission efficiency was 0.83 cd/A, and under this condition, the voltage was 3.4 V and the external quantum yield was 0.89%. When the luminance was 1000 cd/m², the voltage was 7.8 V, the chromaticity coordinate C.I.E. 1931 was (x, y) = (0.17, 0.10), the light emission efficiency was 0.43 cd/A and the external quantum yield was 0.51%. These results are shown in Table 1.

**Table 1**

| | polymer compound | value at a luminance of 1000 cd/m² | | peak wavelength | |
|---|---|---|---|---|---|
| | | external quantum yield (%) | chromaticity (CIE) (x, y) | λmax | |
| | | | | EL | PL |
| Example 6 | P1 | 1.19 | (0.18, 0.13) | 450nm | 422, 446nm |
| Example 7 | P2 | 0.90 | (0.16,0.10) | 450nm | 422, 440nm |
| Example 8 | P3 | 1.55 | (0.15, 0.17) | 455nm | 448nm |
| Comparative example 7 | CP1 | 0.59 | (0.16, 0.11) | 425nm | 422, 438nm |
| Comparative example 8 | CP2 | 0.37 | (0.19, 0.11) | 450nm | 423, 438nm |
| Comparative example 9 | CP3 | 0.51 | (0.17, 0.10) | 450nm | 423, 446nm |

### <Synthesis Example 1> (Synthesis of light emitting material EM-A)

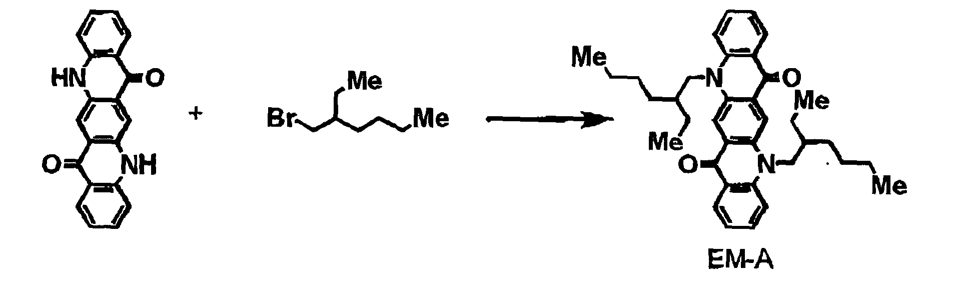

Under an argon atmosphere, N,N-dimethylacetamide (300 ml) and quinacridone (15.0 g, 48.0 mmol) were mixed in a 1000 ml flask, and to this mixture was gradually added sodium hydride (5.76 g, 144 mmol) diluted in a mineral oil at a concentration of about 60 wt%, and the mixture was stirred at 80°C for 1 hour, and 2-ethylhexyl bromide (38.6 g, 200 mmol) was dropped into this mixture over a period of 15 minutes, and the resultant mixture was stirred at 80°C for 6 hours. After completion of the reaction, the reaction mixture was poured into distilled water (900 ml) cooled in an ice water bath, and neutralized with 1N hydrochloric acid water. To this was added 800 ml of ethyl acetate and extraction thereof was performed, then, the organic layer was washed with 5 wt% saline (300 ml), and the resultant organic layer was dried over magnesium sulfate, and concentrated under reduced pressure. The resultant solid was dissolved in chloroform (200 ml) and the solution was passed through a silica gel short column, then, concentrated under reduced pressure, and hexan (150 ml) was added to cause deposition of a solid which was then filtrated, washed with hexane (100 ml), and dried under reduced pressure, to obtain a crude product (11.2 g). The resultant solid was purified by middle pressure silica gel column chromatography (chloroform/ethyl acetate = 5/1) to obtain a light emitting material EM-A (9.4 g, yield: 46%). ¹H-NMR (300 MHz, CDCl₃) : 5 (ppm) = 0.84 (t, 6H), 0.97 (t, 6H), 1.20-1.54 (m, 16H), 2.20 (bs, 2H), 4.50 (bs, 4H), 7.26 (t, 2H), 7.56 (d, 2H), 7.72 (t, 2H), 8.58 (d, 2H), 8.84 (s, 2H).
¹³C-NMR (75 MHz, CDCl₃) : δ (ppm) = 11.6, 14.3, 23.4, 24.7, 29.1, 31.3, 38.7, 50.0, 114.7, 115.8, 121.2, 121.6, 126.5, 128.4, 134.7, 136.7, 143.4, 178.5.

### <Synthesis Example 2> (Synthesis of light emitting material EM-B)

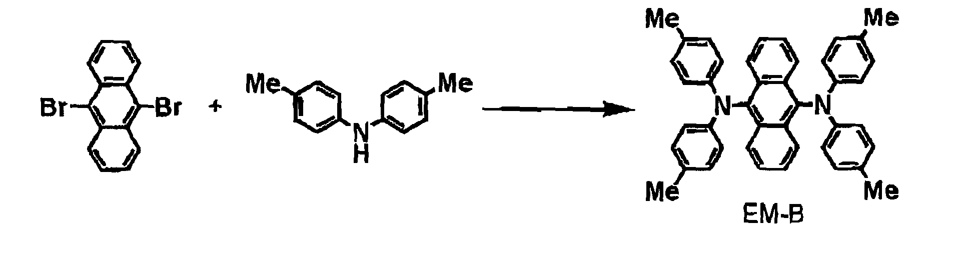

Under an argon atmosphere, an argon gas was bubbled through a mixture of 9,10-dibromoanthracene (16.8 g, 50.0 mmol), sodium-tert-butoxide (10.5 g, 110 mmol), tris(dibenzylideneacetone)dipalladium(0) (0.46 g, 0.5 mmol) and toluene (100 ml) in a 500 ml flask, then, tri-tert-butylphosphine (0.4 g, 2 mmol) was added through a syringe. The mixture was heated up to 90°C, then, a solution prepared by dissolving N,N-di-p-tolylamine (21.7 g, 110 mmol) in toluene (100 ml) was dropped over a period of 40 minutes. The mixture was stirred at 90°C for 40 minutes, subsequently under reflux for 3 hours, then, cooled down to room temperature, and the deposit was filtrated. The resultant solid was dissolved in chloroform (500 ml) under reflux, and insoluble materials were removed by hot filtration. The filtrate was concentrated to about 350 g, then, methanol (250 ml) was dropped while stirring, and the deposited solid was filtrated, washed with methanol and dried under reduced pressure. To the resultant solid was added toluene (200 ml), and the mixture was stirred vigorously at 80°C, then, cooled down to room temperature, and the solid was filtrated, washed sequentially with toluene (100 ml) and hexane (100 ml), and dried under reduced pressure to obtain a light emitting material EM-B as an orange powder (19.9 g, yield 70%).
¹H-NMR (300 MHz, CDCl₃) : δ (ppm) = 2.26 (s, 12H), 6.98 (s, 16H), 7.30-7.34 (m, 4H), 8.15-8.18 (m, 4H).

### <Example 9>

A 0.8 wt% xylene solution of the polymer compound P1 was prepared. This solution was coated on a quartz substrate by spin coat at a revolution of 1000 rpm, and the photoluminescence quantum yield was measured. As a result, the quantum yield was 65%, and the chromaticity coordinate C.I.E. 1931 determined by the light emission spectrum was (x, y) = (0.16, 0.07), revealing deep blue light emission. These results are shown in Table, 2.

### <Example 10>

The photoluminescence quantum yield was measured in the same manner as in Example 32 excepting that a 0.8 wt% xylene solution of a mixture obtained by adding the light emissing material EM-A in a proportion of 5 wt% to the polymer compound P1 was used instead of the 0.8 wt% xylene solution of the polymer compound P1, in Example 9. As a result, the quantum yield was 24%, and the chromaticity coordinate C.I.E.1931 determined by the light emission spectrum was (x, y) = (0.37, 0.52), revealing green light emission. These results are shown in Table, 2.

### <Example 11>

The photoluminescence quantum yield was measured in the same manner as in Example 32 excepting that a 0.8 wt% xylene solution of a mixture obtained by adding the light emissing material EM-B in a proportion of 5 wt% to the polymer compound P1 was used instead of the 0.8 wt% xylene solution of the polymer compound P1, in Example 9. As a result, the quantum yield was 73%, and the chromaticity coordinate C.I.E. 1931 determined by the light emission spectrum was (x, y)=(0.30, 0.62), revealing green light emission. These results are shown in Table, 2.

### <Example 12>

The photoluminescence quantum yield was measured in the same manner as in Example 32 excepting that a 0.8 wt% xylene solution of a mixture obtained by adding a light emissing material EM-C (manufactured by American Dye Source, trade name: ADS077RE) represented by the following formula: 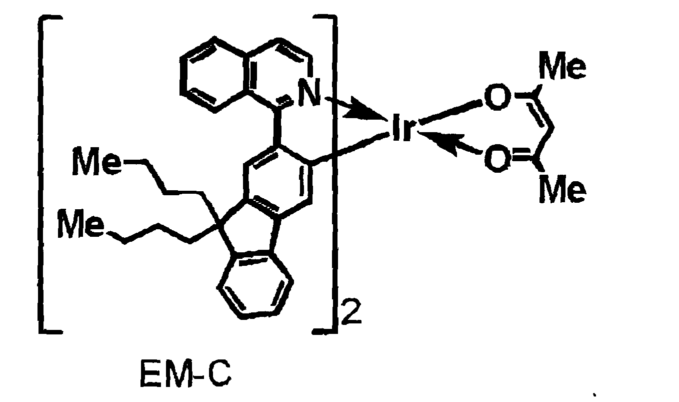 in a proportion of 5 wt% to the polymer compound P1 was used instead of the 0.8 wt% xylene solution of the polymer compound P1, in Example 9. As a result, the quantum yield was 24%, and the chromaticity coordinate C.I.E.1931 determined by the light emission spectrum was (x, y)=(0.51, 0.22), revealing red light emission. These results are shown in Table, 2.

### <Example 13>

The photoluminescence quantum yield was measured in the same manner as in Example 32 excepting that a 0.8 wt% xylene solution of a mixture obtained by adding a light emissing material EM-D (manufactured by Tokyo Chemical Industry Co., Ltd.; 5,6,11,12-tetraphenylnaphthacene) represented by the following formula: 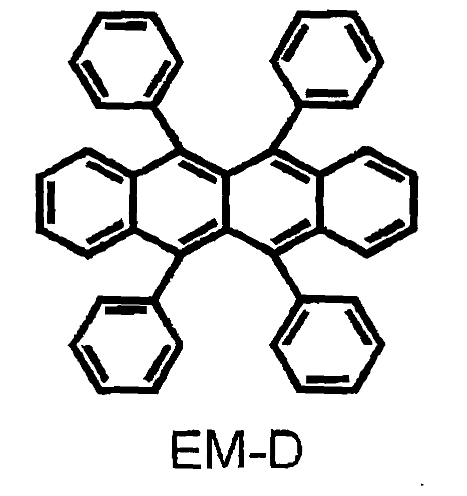 in a proportion of 10 wt% to the polymer compound P1 was used instead of the 0.8 wt% xylene solution of the polymer compound P1, in Example 9. As a result, the quantum yield was 58%, and the chromaticity coordinate C.I.E. 1931 determined by the light emission spectrum was (x, y) = (0.48, 0.49), revealing yellow light emission. These results are shown in Table, 2.

**Table 2**

| | polymer compound | light emitting material | composition ratio (weight ratio) | PLQY | chromaticity (CIE) (x, y) |
|---|---|---|---|---|---|
| Example 9 | P1 | Non | - | 65% | (0.16, 0.07) |
| Example 10 | P1 | EM-A | 95/5 | 24% | (0.37, 0.55) |
| Example 11 | P1 | EM-B | 95/5 | 73% | (0.30, 0.62) |
| Example 12 | P1 | EM-C | 95/5 | 24% | (0.51, 0.22) |
| Example 13 | P1 | EM-D | 90/10 | 58% | (0.48, 0.49) |

### <Evaluation>

As is understood from Table 1, the polymer compound of the present invention is a polymer compound which is useful for fabrication of a light emitting device excellet in external quantum yield when the luminance is 1000 cd/m².

As is understood from Table 2, the polymer compound of the present invention can be used to give a composition with a light emitting material, thereby easily regulating light emission chromaticity.

### Industrial Applicability

The polymer compound of the present invention is a polymer compound which is useful for fabrication of a light emitting device excellet in external quantum yield when the luminance is 1000 cd/m². Further, the polymer compound of the present invention can be usually used to give a composition with a light emitting material, thereby easily regulating light emission chromaticity.

## Claims

1. A polymer compound comprising a constituent unit represented by the following formula (1a) : 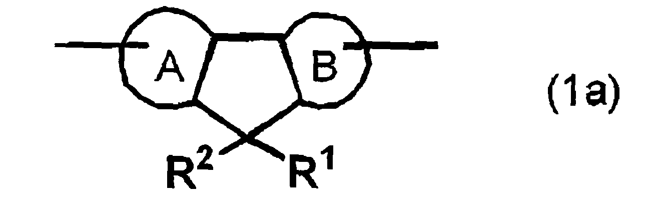 wherein ring A and ring B represent each independently an aromatic hydrocarbon ring optionally having a substituent;
R¹ is a group represented by the following formula (2);
R² represents an aryl group or a monovalent aromatic heterocyclic group, and any hydrogen atom in these groups may be substituted by an alkyl group, an alkoxy group, an alkylthio group, a substituted carbonyl group, a substituted carboxyl group, an aryl group, an aryloxy group, an arylthio group, an aralkyl group, a monovalent aromatic heterocyclic group, a fluorine atom or a cyano group. 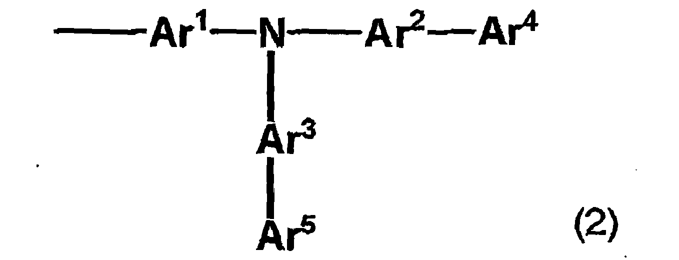 wherein Ar¹ represents an arylene group or a divalent group comprising two or more directly bonded identical or different arylene groups; Ar⁴ and Ar⁵ represent each independently an aryl group or a monovalent aromatic heterocyclic group; Ar² and Ar³ represent each independently an arylene group or a divalent aromatic heterocyclic group; when Ar² and Ar³ are each a phenylene group, one carbon atom in the phenylene group represented by Ar² and one carbon atom in the phenylene group represented by Ar³, the carbon atoms being positioned at the ortho position with respect to the nitrogen atom bonded to these phenylene groups, may be bonded to each other directly or via -O-,
-S-, -C (=O) -, -C (=O) -O-, -N(R⁶) -, -C (=O) -N (R⁶) - or -C(R⁶) (R⁶)- to form a 5- to 7-membered ring; R⁶ represents a hydrogen atom, an alkyl group, an aryl group or a monovalent aromatic heterocyclic group;any hydrogen atom in the groups represented by Ar¹, Ar², Ar³, Ar⁴, Ar⁵ and R⁶ may be substituted by an alkyl group, an alkoxy group, an alkylthio group, a substituted carbonyl group, a substituted carboxyl group, an aryl group, an aryloxy group, an arylthio group, an aralkyl group, a monovalent aromatic heterocyclic group, a fluorine atom or a cyano group; when there are a plurality of R⁶s, these may be the same or different.

2. The polymer compound according to Claim 1, wherein the constituent unit represented by the formula (1a) is a constituent unit represented by the following formula (1): 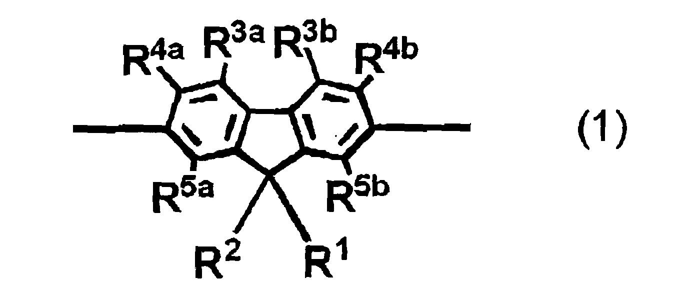 wherein R¹ and R² have the same meaning as described above;
R^{3a}, R^{4a}, R^{5a}, R^{3b}, R^{4b} and R^{5b} represent each independently a hydrogen atom, an alkyl group, an aryl group, a monovalent aromatic heterocyclic group, - N(R⁸)(R⁹), a fluorine atom or a cyano group; R⁸ and R⁹ represent each independently a hydrogen atom, an alkyl group, an aryl group or a monovalent aromatic heterocyclic group; any hydrogen atom in the aryl group and monovalent aromatic heterocyclic group represented by R^{3a}, R^{4a}, R^{5a}, R^{3b}, R^{4b}, R^{5b}, R⁸ and R⁹ may be substituted by an alkyl group, an alkoxy group, an alkylthio group, a substituted carbonyl group, a substituted carboxyl group, an aryl group, an aryloxy group, an arylthio group, an aralkyl group, a monovalent aromatic heterocyclic group, a fluorine atom or a cyano group a pair of R^{3a} and R^{4a}, a pair of R^{3b} and R^{4b}, a pair of R^{3a} and R^{3b}, and a pair of R⁸ and R⁹ each may form a ring together.

3. The polymer compound according to Claim 1 or 2,
wherein R² is an aryl group substituted by an alkyl group or an aryl group, or an unsubstituted aryl group.

4. The polymer compound according to any one of Claims 1 to 3, wherein the group represented by the formula (2) is a group represented by the following formula (2-000) or (2-100) : 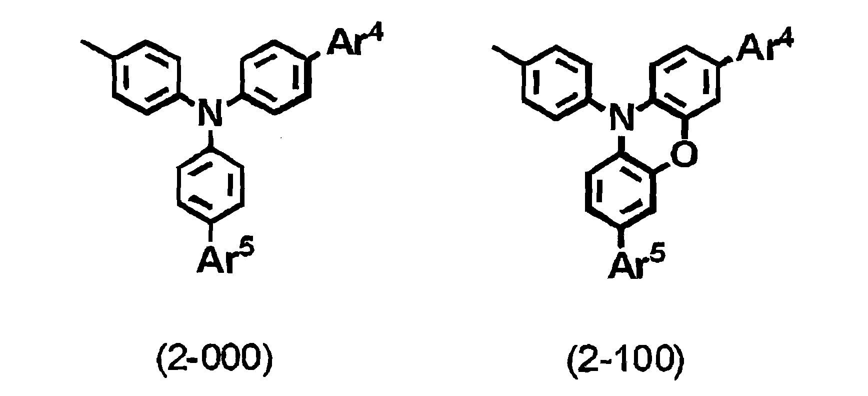 wherein Ar⁴ and Ar⁵ represent the same meaning as described above.

5. The polymer compound according to any one of Claims 1 to 4, further comprising at least one constituent unit selected from the group consisting of constituent units represented by the following formulae (3) to (5):
-Ar⁸- (3) 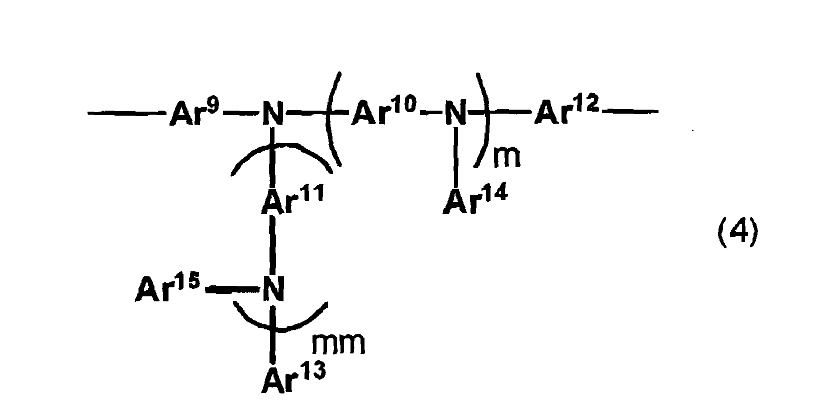
-Ar¹⁶-X¹- (5)
wherein Ar⁸ and Ar¹⁶ represent each independently an arylene group or a divalent aromatic heterocyclic group, or a divalent group comprising two or more directly bonded identical or different groups selected from the group consisting of arylene groups and divalent aromatic heterocyclic groups; Ar⁹, Ar¹⁰, Ar¹¹ and Ar¹² represent each independently an arylene group, or a divalent group comprising two or more directly bonded identical or different arylene groups; Ar¹³, Ar¹⁴ and Ar¹⁵ represent each independently an aryl group or a monovalent aromatic heterocyclic group; the arylene group, the divalent aromatic heterocyclic group and the divalent group represented by Ar⁸ and Ar¹⁶ each may be substituted by an alkyl group, an alkoxy group, an alkylthio group, a substituted carbonyl group, a substituted carboxyl group, an aryl group, an aryloxy group, an arylthio group, an aralkyl group, a monovalent aromatic heterocyclic group, - N(R⁸)(R⁹), a fluorine atom or a cyano group; any hydrogen atom in the groups represented by Ar⁹, Ar¹⁰, Ar¹¹, Ar¹², Ar¹³, Ar¹⁴ and Ar¹⁵ may be substituted by an alkyl group, an alkoxy group, an alkylthio group, a substituted carbonyl group, a substituted carboxyl group, an aryl group, an aryloxy group, an arylthio group, an aralkyl group, a monovalent aromatic heterocyclic group, a fluorine atom or a cyano group; a group selected from the group consisting of the groups represented by Ar¹¹, Ar¹⁴ and Ar¹⁵ and a group selected from the group consisting of the groups represented by Ar⁹, Ar¹⁰, Ar¹¹, Ar¹², Ar¹³, Ar¹⁴ and Ar¹⁵ bonded to the same nitrogen atom as that to which that group bonds may be bonded to each other directly or via - O-, -S-, -C(=O)-,
-C(=O)-O-, -N(R⁶)-, -C(=O)-N(R⁶)- or -C(R⁶)(R⁶)- to form a 5- to 7-membered ring; m and mm represent each independently 0 or 1; X¹ represents -C(R⁷)=C(R⁷)- or -CΞC-; R⁷ represents a hydrogen atom, an alkyl group, an aryl group, a monovalent aromatic heterocyclic group, a fluorine atom or a cyano group; the group represented by R⁷ may have a substituent; when there are a plurality of Ar¹⁰s, Ar¹¹s, Ar¹⁴s and Ar¹⁵s, each of them may be the same or different; R⁶, R⁸ and R⁹ represent the same meaning as described above.

6. The polymer compound according to Claim 5, wherein the total molar amount of the constituent unit represented by the formula (1a), the constituent unit represented by the formula (3), the constituent unit represented by the formula (4) and the constituent unit represented by the formula (5) relative to the total molar amount of all constituent units is 90 to 100%.

7. The polymer compound according to any one of Claims 1 to 6, wherein the polystyrene-equivalent number average molecular weight thereof is 1x10³ to 1×10⁸.

8. A compound represented by the following formula (A): 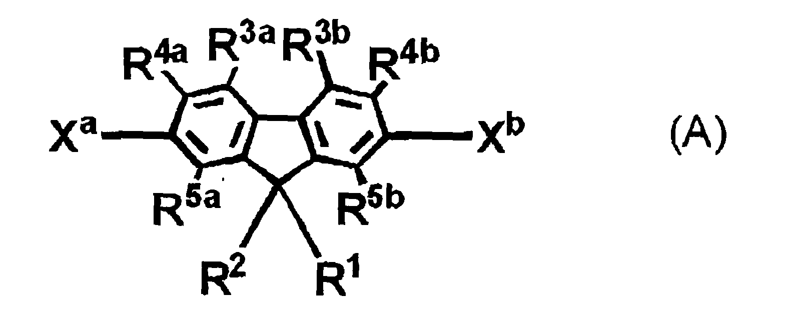 wherein R¹, R², R^{3a}, R^{4a}, R^{5a}, R^{3b}, R^{4b} and R^{5b} have the same meaning as described above; X^{a} and X^{b} represent each independently a bromine atom, an iodine atom, a chlorine atom, -O-S (=O)₂ R²⁰, -B (OR²¹)₂, -BF₄Q¹, -Sn(R²²)₃, -MgY¹ or -ZnY¹; R²⁰ represents an alkyl group, or an aryl group optionally substituted by an alkyl group, an alkoxy group, a nitro group, a fluorine atom or a cyano group; R²¹ and R²² represent each independently a hydrogen atom or an alkyl group; two R²¹s may be the same or different and may form a ring together; three R²²s may be the same or different and may form a ring together; Q¹ represents a monovalent cation of lithium, sodium, potassium, rubidium or cesium. Y¹ represents a bromine atom, an iodine atom or a chlorine atom.

9. A composition comprising the polymer compound according to any one of Claims 1 to 7.

10. A solution comprising the polymer compound according to any one of Claims 1 to 7, and a solvent.

11. A film comprising the polymer compound according to any one of Claims 1 to 7.

12. A light emitting device having electrodes consisting of an anode and a cathode, and an organic layer comprising the polymer compound according to any one of Claims 1 to 7 disposed between the electrodes.

13. A planar light source comprising the light emitting device according to Claim 12.

14. A display comprising the light emitting device according to Claim 12.
